# EUROPEAN PATENT APPLICATION

(11) **EP 3 754 739 A1**
(43) Date of publication of application: **23.12.2020**
(21) Application number: 19755069.2
(22) Date of filing: 13.02.2019
(51) Int. Cl.: H01L 51/50

(54) **ORGANIC ELECTROLUMINESCENCE ELEMENT**

(30) Priority: 15.02.2018 JP 2018025363
(71) Applicant: Hodogaya Chemical Co., Ltd., Tokyo 104-0028 (JP)
(72) Inventor: SURUGA Kazuyuki, Tokyo 104-0028 (JP); KO Sang-Won, Tokyo 104-0028 (JP); YAMAMOTO Takeshi, Tokyo 104-0028 (JP)
(74) Representative: Müller-Boré & Partner Patentanwälte PartG mbB
(86) International application number: PCT/JP2019/004948
(87) International publication number: WO 2019/159919

(57) **Abstract**

An organic EL element having at least, in the stated order, an anode, a hole transport layer, a light emission layer, an electron transport layer, and a cathode, wherein the hole transport layer contains an indenophenanthrene compound represented by general formula (1a) or general formula (1b).

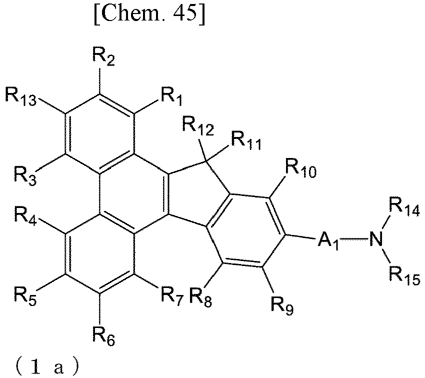

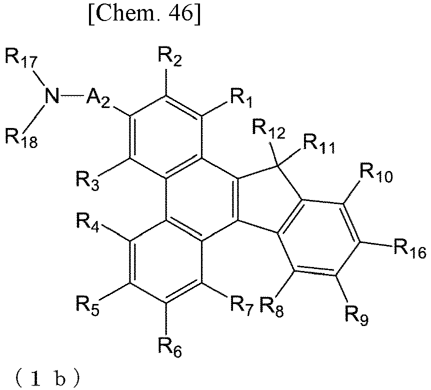

## Description

### Technical Field

The present invention relates to an organic electroluminescence device (hereinafter, may be referred to as "organic EL device") which is a self-luminescent device suitable for various display devices.

### Background Art

Since organic EL devices are self-luminescent devices, they are bright and excellent in visibility as compared with liquid-crystalline devices and capable of giving clear display. Therefore, organic EL devices have been actively studied.

In 1987, C. W. Tang et al. of Eastman Kodak Company put an organic EL device using organic materials into practical use by developing a device having a laminated structure in which various roles are assigned to respective materials. They formed a lamination of a fluorescent material capable of transporting electrons and an organic material capable of transporting holes, so that both charges are injected into the layer of the fluorescent material to emit light, thereby achieving a high luminance of 1,000 cd/m² or more at a voltage of 10 V or lower (see, e.g., Patent Literatures 1 and 2).

To date, many improvements have been performed for practical utilization of the organic EL devices, and high efficiency and durability have been achieved by an electroluminescence device in which an anode, a hole injection layer, a hole transport layer, a light emitting layer, an electron transport layer, an electron injection layer, and a cathode are sequentially provided on a substrate, to further subdivide various roles of the laminated structure (see, e.g., Non-Patent Literature 1).

Moreover, for the purpose of further improvements of luminous efficiency, utilization of triplet exciton has been attempted and utilization of a phosphorescent compound has been investigated (see, e.g., Non-Patent Literature 2).

A device that utilizes light emission by thermally activated delayed fluorescence (TADF) has also been developed. In 2011, Adachi et al. of Kyushu University achieved external quantum efficiency of 5.3% through a device using a thermally activated delayed fluorescence material (see, e.g., Non-Patent Literature 3).

The light emitting layer can be also prepared by doping a charge-transporting compound, generally called a host material, with a fluorescent compound, a phosphorescent compound, or a material emitting delayed fluorescence. The choice of the organic materials in organic EL devices remarkably affects various characteristics such as efficiency and durability of the devices as described in the above-mentioned Non-Patent Literature (see, e.g., Non-Patent Literature 2).

In the organic EL devices, the charges injected from both electrodes are recombined in the light emitting layer to attain light emission. In order to obtain high luminous efficiency, it is important to achieve efficient delivery of both charges of holes and electrons to the light emitting layer, the balance of both charges injected into the light emitting layer, confinement of the generated excitons, and the like. When hole-injection property from the hole transport layer to the light emitting layer is enhanced, and an electron-blocking property of the hole transport layer, which prevents leakage of electrons from the light emitting layer to the hole transport layer, is enhanced, the probability of recombination of holes and electrons in the light emitting layer can be increased, and excitons can be efficiently generated. Further, the excitons generated in the light emitting layer can be prevented from leaking to the transporting layer and confined in the light emitting layer, thereby obtaining high luminous efficiency. Therefore, the roles of the hole-transporting material are important, and there is a demand for a hole-transporting material which has high hole-injection property, high hole-mobility, a high electron-blocking property, and high durability for electrons.

The heat resistance and the amorphous property of the material are also important in terms of the device lifetime. In the case of a material having low heat resistance, thermal decomposition occurs even at a low temperature due to heat generated during driving of the device, and the material is deteriorated. In the case of a material having a low amorphous property, crystallization of the thin film occurs even in a short period, and the device is deteriorated. Therefore, the material used is required to have high heat resistance and good amorphous property.

As the hole transport material used for the organic EL device, N,N'-diphenyl-N,N'-di(α-naphthyl)benzidine (NPD) and various aromatic amine derivatives have been known (see, e.g., Patent Literatures 1 and 2). Although NPD has a good hole-transporting ability, NPD has a glass transition point (Tg), which is an index of heat resistance, as low as 96°C, and thus a deterioration in device characteristics due to crystallization occurs under high-temperature conditions (see, e.g., Non-Patent Literature 4). In addition, among the aromatic amine derivatives described in Patent Literatures, a compound having an excellent mobility as a hole-mobility of 10⁻³ cm²/Vs or more has been known (see, e.g., Patent Literatures 1 and 2). However, this compound has insufficient electron blocking property, so that a part of electrons pass through the light emitting layer, and improvements in the luminous efficiency cannot be expected. For higher efficiency, a material which has a higher electron-blocking property and which forms a more stable thin film and has higher heat resistance has been required. An aromatic amine derivative having high durability has been reported (see, e.g., Patent Literature 3). However, this aromatic amine derivative has been used as a charge-transporting material used for an electrophotographic photoreceptor, and there has been no example using this aromatic amine derivative in an organic EL device.

As a compound with improved characteristics such as heat resistance and hole injection property, arylamine compounds having a substituted carbazole structure have been proposed (see, e.g., Patent Literatures 4 and 5). However, in the case of a device in which these compounds are used for a hole injection layer or a hole transport layer, improvements in heat resistance, luminous efficiency, and the like have been achieved, but it is not yet sufficient, and further lower drive voltage and further higher luminous efficiency are required.

As described above, improvements in device characteristics of an organic EL device, and improvements in yields of device fabrication are required. There is a demand for a device having high luminous efficiency, a low drive voltage, and long lifetime, in which holes and electrons can be recombined at high efficiency through combining materials excellent in an injection or transportation performance of holes and electrons, and in stability and durability of a thin film.

### Citation List

### Patent Literature

Patent Literature 1: JP-A-H08-048656
Patent Literature 2: Japanese Patent No. 3194657
Patent Literature 3: Japanese Patent No. 4943840
Patent Literature 4: JP-A-2006-151979
Patent Literature 5: WO 2008/062636
Patent Literature 6: WO 2014/009310

### Non-Patent Literature

Non-Patent Literature 1: Japan Society of Applied Physics Ninth Workshop Preprint, pp. 55-61 (2001)
Non-Patent Literature 2: Japan Society of Applied Physics Ninth Workshop Preprint, pp. 23-31 (2001)
Non-Patent Literature 3: Appl. Phys. Let., 98, 083302 (2011)
Non-Patent Literature 4: Organic EL Debate Third Regular Meeting Preprint pp. 13-14 (2006)

### Summary of Invention

### Technical Problem

An object of the present invention is to provide an organic EL device in which a material for an organic EL device, which is excellent in an injection or transportation performance of holes, the electron blocking ability, and the stability and durability of the state of a thin film, is used as a material for an organic EL device having high efficiency and durability. Further, another object is to provide an organic EL device having high efficiency, a low drive voltage, and long lifetime by combining this material with various materials for an organic EL device, which are excellent in an injection or transportation performance of holes and electrons, the electron blocking ability, or the stability and durability of the state of a thin film so that characteristics of each material can be exhibited effectively.

The physical characteristics that the organic EL device to be provided by the present invention should possess can include: (1) high luminous efficiency and power efficiency; (2) a low light-emission start voltage; (3) a low practical drive voltage; and particularly (4) long lifetime.

### Solution to Problem

In order to achieve the above-described object, the present inventors focused on the fact that an amine-based material having an indenophenanthrene skeleton has excellent injection and transport abilities of holes, and excellent stability and durability of a thin film. They selected various indenophenanthrene compounds to prepare organic EL devices, and evaluated the characteristics of the devices diligently. As a result, the present inventors have found that when indenophenanthrene compounds having a specific structure are selected as a material of the hole transport layer, the holes injected from the anode side can be efficiently transported. Further, they combined the indenophenanthrene compounds with electron transport materials having a specific structure or the like to prepare various organic EL devices, and evaluated the characteristics of the devices diligently. As a result, the present invention has been completed.

That is, the present invention provides the following organic EL device.

Provided is an organic electroluminescence device including at least an anode, a hole transport layer, a light emitting layer, an electron transport layer, and a cathode in this order, in which the hole transport layer contains an indenophenanthrene compound represented by the following general formula (1a) or (1b). 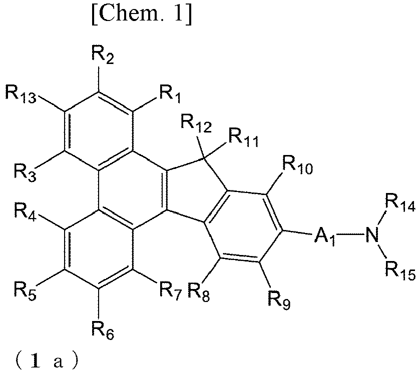
(In the formula, R₁ to R₁₀, and R₁₃ may be the same as or different from each other and each represents a hydrogen atom, a deuterium atom, a fluorine atom, a chlorine atom, a cyano group, a nitro group, a linear or branched alkyl group having a carbon number of 1 to 6 which may have a substituent, a cycloalkyl group having a carbon number of 5 to 10 which may have a substituent, a linear or branched alkenyl group having a carbon number of 2 to 6 which may have a substituent, a linear or branched alkyloxy group having a carbon number of 1 to 6 which may have a substituent, a cycloalkyloxy group having a carbon number of 5 to 10 which may have a substituent, a substituted or unsubstituted aromatic hydrocarbon group, a substituted or unsubstituted aromatic heterocyclic group, a substituted or unsubstituted condensed polycyclic aromatic group, a substituted or unsubstituted aryloxy group, or a di-substituted amino group substituted with a group selected from an aromatic hydrocarbon group, an aromatic heterocyclic group, and a condensed polycyclic aromatic group, these groups may be bonded to each other through a single bond, a substituted or unsubstituted methylene group, an oxygen atom, or a sulfur atom to form a ring, or these groups may be bonded to each other through an oxygen atom, a sulfur atom, or a linking group to form a ring together with a benzene ring to which R₁ to R₁₀, and R₁₃ are bonded.
R₁₁, R₁₂, R₁₄ and R₁₅ may be the same as or different from each other and each represents a linear or branched alkyl group having a carbon number of 1 to 6 which may have a substituent, a cycloalkyl group having a carbon number of 5 to 10 which may have a substituent, a linear or branched alkenyl group having a carbon number of 2 to 6 which may have a substituent, a substituted or unsubstituted aromatic hydrocarbon group, a substituted or unsubstituted aromatic heterocyclic group, a substituted or unsubstituted condensed polycyclic aromatic group, or a substituted or unsubstituted aryloxy group.
Here, R₁₁ and R₁₂, or R₁₄ and R₁₅ may be bonded to each other between the respective groups through a single bond, an oxygen atom, a sulfur atom, or a linking group to form a ring.
A₁ represents a single bond, a divalent group of a substituted or unsubstituted aromatic hydrocarbon, a divalent group of a substituted or unsubstituted aromatic heterocycle, or a divalent group of a substituted or unsubstituted condensed polycyclic aromatic compound.)

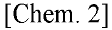

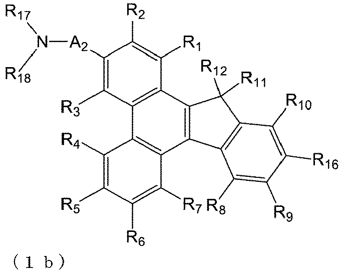

(In the formula, R₁ to R₁₀, and R₁₆ may be the same as or different from each other and each represents a hydrogen atom, a deuterium atom, a fluorine atom, a chlorine atom, a cyano group, a nitro group, a linear or branched alkyl group having a carbon number of 1 to 6 which may have a substituent, a cycloalkyl group having a carbon number of 5 to 10 which may have a substituent, a linear or branched alkenyl group having a carbon number of 2 to 6 which may have a substituent, a linear or branched alkyloxy group having a carbon number of 1 to 6 which may have a substituent, a cycloalkyloxy group having a carbon number of 5 to 10 which may have a substituent, a substituted or unsubstituted aromatic hydrocarbon group, a substituted or unsubstituted aromatic heterocyclic group, a substituted or unsubstituted condensed polycyclic aromatic group, a substituted or unsubstituted aryloxy group, or a di-substituted amino group substituted with a group selected from an aromatic hydrocarbon group, an aromatic heterocyclic group, and a condensed polycyclic aromatic group, these groups may be bonded to each other through a single bond, a substituted or unsubstituted methylene group, an oxygen atom, or a sulfur atom to form a ring, or these groups may be bonded to each other through an oxygen atom, a sulfur atom, or a linking group to form a ring together with a benzene ring to which R₁ to R₁₀, and R₁₆ are bonded.
R₁₁, R₁₂, R₁₇ and R₁₈ may be the same as or different from each other and each represents a linear or branched alkyl group having a carbon number of 1 to 6 which may have a substituent, a cycloalkyl group having a carbon number of 5 to 10 which may have a substituent, a linear or branched alkenyl group having a carbon number of 2 to 6 which may have a substituent, a substituted or unsubstituted aromatic hydrocarbon group, a substituted or unsubstituted aromatic heterocyclic group, a substituted or unsubstituted condensed polycyclic aromatic group, or a substituted or unsubstituted aryloxy group.
Here, R₁₁ and R₁₂, or R₁₇ and R₁₈ may be bonded to each other between the respective groups through a single bond, an oxygen atom, a sulfur atom, or a linking group to form a ring.
A₂ represents a single bond, a divalent group of a substituted or unsubstituted aromatic hydrocarbon, a divalent group of a substituted or unsubstituted aromatic heterocycle, or a divalent group of a substituted or unsubstituted condensed polycyclic aromatic compound.)

### Advantageous Effects of Invention

Since a specific indenophenanthrene compound capable of effectively playing the role of injecting and transporting holes is selected, the organic EL device of the present invention can efficiently inject and transport holes from the hole transport layer to the light emitting layer, and can be excellent in the stability and the durability of a thin film, and an organic EL device having high efficiency, a low drive voltage, and long lifetime, as compared with a conventional organic EL device can be achieved.

### Brief Description of Drawings

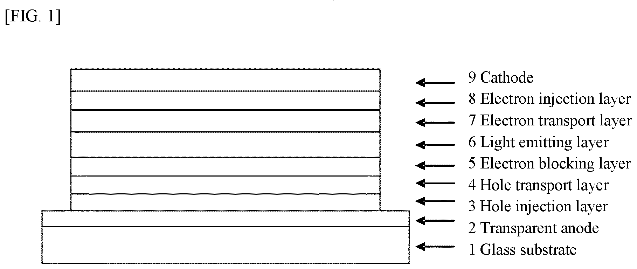

[FIG. 1] This is a diagram illustrating a structure of organic EL devices in Examples 12 to 22, and Comparative Examples 1 to 4.

### Description of Embodiments

An embodiment of the present invention will be described in detail below. First, aspects of the present embodiment will be listed and described. In the present application, the term "to" is a term representing a range. For example, the description "5 to 10" means "5 or more and 10 or less", and represents a range including the numerical values themselves described before and after "to".
1) An organic electroluminescence device including at least an anode, a hole transport layer, a light emitting layer, an electron transport layer, and a cathode in this order, in which the hole transport layer contains an indenophenanthrene compound represented by the following general formula (1a) or (1b). 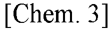 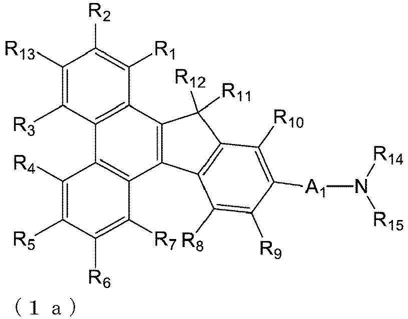
   (In the formula, R₁ to R₁₀, and R₁₃ may be the same as or different from each other and each represents a hydrogen atom, a deuterium atom, a fluorine atom, a chlorine atom, a cyano group, a nitro group, a linear or branched alkyl group having a carbon number of 1 to 6 which may have a substituent, a cycloalkyl group having a carbon number of 5 to 10 which may have a substituent, a linear or branched alkenyl group having a carbon number of 2 to 6 which may have a substituent, a linear or branched alkyloxy group having a carbon number of 1 to 6 which may have a substituent, a cycloalkyloxy group having a carbon number of 5 to 10 which may have a substituent, a substituted or unsubstituted aromatic hydrocarbon group, a substituted or unsubstituted aromatic heterocyclic group, a substituted or unsubstituted condensed polycyclic aromatic group, a substituted or unsubstituted aryloxy group, or a di-substituted amino group substituted with a group selected from an aromatic hydrocarbon group, an aromatic heterocyclic group, and a condensed polycyclic aromatic group, these groups may be bonded to each other through a single bond, a substituted or unsubstituted methylene group, an oxygen atom, or a sulfur atom to form a ring, and these groups may be bonded to each other through an oxygen atom, a sulfur atom, or a linking group to form a ring together with a benzene ring to which R₁ to R₁₀, and R₁₃ are bonded.
   R₁₁, R₁₂, R₁₄ and R₁₅ may be the same as or different from each other and each represents a linear or branched alkyl group having a carbon number of 1 to 6 which may have a substituent, a cycloalkyl group having a carbon number of 5 to 10 which may have a substituent, a linear or branched alkenyl group having a carbon number of 2 to 6 which may have a substituent, a substituted or unsubstituted aromatic hydrocarbon group, a substituted or unsubstituted aromatic heterocyclic group, a substituted or unsubstituted condensed polycyclic aromatic group, or a substituted or unsubstituted aryloxy group.
   Here, R₁₁ and R₁₂, or R₁₄ and R₁₅ may be bonded to each other between the respective groups through a single bond, an oxygen atom, a sulfur atom, or a linking group to form a ring.
   A₁ represents a single bond, a divalent group of a substituted or unsubstituted aromatic hydrocarbon, a divalent group of a substituted or unsubstituted aromatic heterocycle, or a divalent group of a substituted or unsubstituted condensed polycyclic aromatic compound.) 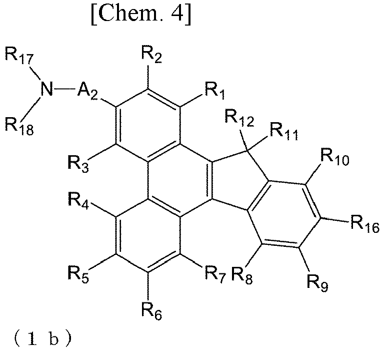
   (In the formula, R₁ to R₁₀, and R₁₆ may be the same as or different from each other and each represents a hydrogen atom, a deuterium atom, a fluorine atom, a chlorine atom, a cyano group, a nitro group, a linear or branched alkyl group having a carbon number of 1 to 6 which may have a substituent, a cycloalkyl group having a carbon number of 5 to 10 which may have a substituent, a linear or branched alkenyl group having a carbon number of 2 to 6 which may have a substituent, a linear or branched alkyloxy group having a carbon number of 1 to 6 which may have a substituent, a cycloalkyloxy group having a carbon number of 5 to 10 which may have a substituent, a substituted or unsubstituted aromatic hydrocarbon group, a substituted or unsubstituted aromatic heterocyclic group, a substituted or unsubstituted condensed polycyclic aromatic group, a substituted or unsubstituted aryloxy group, or a di-substituted amino group substituted with a group selected from an aromatic hydrocarbon group, an aromatic heterocyclic group, and a condensed polycyclic aromatic group, these groups may be bonded to each other through a single bond, a substituted or unsubstituted methylene group, an oxygen atom, or a sulfur atom to form a ring, and these groups may be bonded to each other through an oxygen atom, a sulfur atom, or a linking group to form a ring together with a benzene ring to which R₁ to R₁₀, and R₁₆ are bonded.
   R₁₁, R₁₂, R₁₇ and R₁₈ may be the same as or different from each other and each represents a linear or branched alkyl group having a carbon number of 1 to 6 which may have a substituent, a cycloalkyl group having a carbon number of 5 to 10 which may have a substituent, a linear or branched alkenyl group having a carbon number of 2 to 6 which may have a substituent, a substituted or unsubstituted aromatic hydrocarbon group, a substituted or unsubstituted aromatic heterocyclic group, a substituted or unsubstituted condensed polycyclic aromatic group, or a substituted or unsubstituted aryloxy group.
   Here, R₁₁ and R₁₂, or R₁₇ and R₁₈ may be bonded to each other between the respective groups through a single bond, an oxygen atom, a sulfur atom, or a linking group to form a ring.
   A₂ represents a single bond, a divalent group of a substituted or unsubstituted aromatic hydrocarbon, a divalent group of a substituted or unsubstituted aromatic heterocycle, or a divalent group of a substituted or unsubstituted condensed polycyclic aromatic compound.)
2) The organic electroluminescence device according to the item 1), in which R₁₄, R₁₅, R₁₇ and R₁₈ each represents a substituted or unsubstituted aromatic hydrocarbon group, a substituted or unsubstituted aromatic heterocyclic group, or a substituted or unsubstituted condensed polycyclic aromatic group.
3) The organic electroluminescence device according to the item 1) or 2), in which A₁ and A₂ are a single bond.
4) The organic electroluminescence device according to any one of the items 1) to 3), in which the electron transport layer contains a compound having a pyrimidine ring structure, which is represented by the following general formula (2). 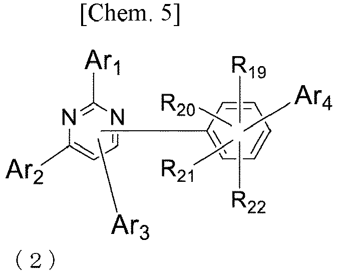
   (In the formula, Ar₁ represents a substituted or unsubstituted aromatic hydrocarbon group, or a substituted or unsubstituted condensed polycyclic aromatic group;
   Ar₂ and Ar₃ may be the same as or different from each other and represent a hydrogen atom, a substituted or unsubstituted aromatic hydrocarbon group, or a substituted or unsubstituted condensed polycyclic aromatic group;
   Ar₄ represents a substituted or unsubstituted aromatic heterocyclic group; and
   R₁₉ to R₂₂ may be the same as or different from each other and each represents a hydrogen atom, a deuterium atom, a fluorine atom, a chlorine atom, a cyano group, a trifluoromethyl group, a linear or branched alkyl group having a carbon number of 1 to 6, a substituted or unsubstituted aromatic hydrocarbon group, a substituted or unsubstituted aromatic heterocyclic group, or a substituted or unsubstituted condensed polycyclic aromatic group.
   Here, Ar₂ and Ar₃ are not a hydrogen atom at the same time.)
5) The organic electroluminescence device according to any one of the items 1) to 3), in which the electron transport layer contains a compound having a benzazole ring structure, which is represented by the following general formula (3). 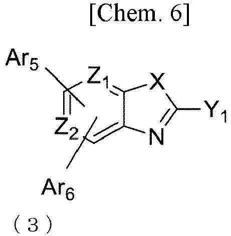
   (In the formula, Ar₅ and Ar₆ may be the same as or different from each other and represent a hydrogen atom, a deuterium atom, a substituted or unsubstituted aromatic hydrocarbon group, a substituted or unsubstituted aromatic heterocyclic group, a substituted or unsubstituted condensed polycyclic aromatic group, or a substituted or unsubstituted alkyl group;
   Y₁ represents a substituted or unsubstituted aromatic hydrocarbon group, a substituted or unsubstituted aromatic heterocyclic group, a substituted or unsubstituted condensed polycyclic aromatic group, or a substituted or unsubstituted alkyl group;
   X represents an oxygen atom or a sulfur atom; and
   Z₁ and Z₂ may be the same as or different from each other and represent a carbon atom or a nitrogen atom.)
6) The organic electroluminescence device according to any one of the items 1) to 5), further including an electron blocking layer between the hole transport layer and the light emitting layer.
7) The organic electroluminescence device according to the item 6), in which the electron blocking layer contains an arylamine compound represented by the following general formula (4). 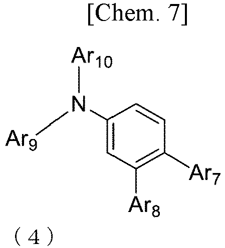 (In the formula, Ar₇ to Ar₁₀ may be the same as or different from each other and each represents a substituted or unsubstituted aromatic hydrocarbon group, a substituted or unsubstituted aromatic heterocyclic group, or a substituted or unsubstituted condensed polycyclic aromatic group.)
8) The organic electroluminescence device according to any one of items 1) to 7), further including a hole injection layer between the anode and the hole transport layer.
9) The organic electroluminescence device according to the item 8), in which the hole injection layer contains the indenophenanthrene compound represented by the foregoing general formula (1a) or (1b) and an electron acceptor, and the electron acceptor is at least one electron acceptor selected from the group consisting of trisbromophenylamine hexachloroantimony, tetracyanoquinone dimethane (TCNQ), 2,3,5,6-tetrafluoro-tetracyano-1,4-benzoquinone dimethane (F4TCNQ), and radialene derivatives.

Specific examples of the "linear or branched alkyl group having a carbon number of 1 to 6", the "cycloalkyl group having a carbon number of 5 to 10", or the "linear or branched alkenyl group having a carbon number of 2 to 6" in the "linear or branched alkyl group having a carbon number of 1 to 6 which may have a substituent", the "cycloalkyl group having a carbon number of 5 to 10 which may have a substituent", or the "linear or branched alkenyl group having a carbon number of 2 to 6 which may have a substituent", which is represented by R₁ to R₁₈ in the general formulas (1a) and (1b), include: a methyl group, an ethyl group, a n-propyl group, an isopropyl group, a n-butyl group, an isobutyl group, a tert-butyl group, a n-pentyl group, an isopentyl group, a neopentyl group, a n-hexyl group, a cyclopentyl group, a cyclohexyl group, a 1-adamantyl group, a 2-adamantyl group, a vinyl group, an allyl group, an isopropenyl group, a 2-butenyl group, and the like, and these groups may be bonded to each other through a single bond, a substituted or unsubstituted methylene group, an oxygen atom, or a sulfur atom to form a ring.

Specific examples of the "substituent" in the "linear or branched alkyl group having a carbon number of 1 to 6 which has a substituent", the "cycloalkyl group having a carbon number of 5 to 10 which has a substituent", or the "linear or branched alkenyl group having a carbon number of 2 to 6 which has a substituent", which is represented by R₁ to R₁₈ in the general formulas (1a) and (1b), include: a deuterium atom; a cyano group; a nitro group; a halogen atom such as a fluorine atom, a chlorine atom, a bromine atom, and an iodine atom; a linear or branched alkyl group having a carbon number of 1 to 6 such as a methyl group, an ethyl group, a n-propyl group, an isopropyl group, a n-butyl group, an isobutyl group, a tert-butyl group, a n-pentyl group, an isopentyl group, a neopentyl group, and a n-hexyl group; a cycloalkyl group having a carbon number of 5 to 10 such as a cyclopentyl group, a cyclohexyl group, a 1-adamantyl group, and a 2-adamantyl group; a linear or branched alkyloxy group having a carbon number of 1 to 6 such as a methyloxy group, an ethyloxy group, and a propyloxy group; a linear or branched alkenyl group having a carbon number of 2 to 6 such as a vinyl group, an allyl group, an isopropenyl group, and a 2-butenyl group; an aryloxy group such as a phenyloxy group and a tolyloxy group; an arylalkyloxy group such as a benzyloxy group and a phenethyloxy group; an aromatic hydrocarbon group or a condensed polycyclic aromatic group such as a phenyl group, a biphenylyl group, a terphenyl group, a naphthyl group, an anthracenyl group, a phenanthryl group, a fluorenyl group, an indenyl group, a pyrenyl group, a perylenyl group, a fluoranthenyl group, and a triphenylenyl group; an aromatic heterocyclic group such as a pyridyl group, a pyrimidinyl group, a triazinyl group, a thienyl group, a furyl group, a pyrrolyl group, a quinolyl group, an isoquinolyl group, a benzofuranyl group, a benzothienyl group, an indolyl group, a carbazolyl group, a benzoxazolyl group, a benzothiazolyl group, a quinoxalinyl group, a benzimidazolyl group, a pyrazolyl group, a dibenzofuranyl group, a dibenzothienyl group, and a carborinyl group; a di-substituted amino group substituted with an aromatic hydrocarbon group or a condensed polycyclic aromatic group, such as a diphenylamino group and a dinaphthylamino group; a di-substituted amino group substituted with an aromatic heterocyclic group, such as a dipyridylamino group and a dithienylamino group; a di-substituted amino group substituted with a substituent selected from an aromatic hydrocarbon group, a condensed polycyclic aromatic group, and an aromatic heterocyclic group; and the like. These substituents may be further substituted with the above-exemplified substituents. In addition, these substituents may be bonded to each other through a single bond, a substituted or unsubstituted methylene group, an oxygen atom, or a sulfur atom to form a ring.

Specific examples of the "linear or branched alkyloxy group having a carbon number of 1 to 6" or the "cycloalkyloxy group having a carbon number of 5 to 10" in the "linear or branched alkyloxy group having a carbon number of 1 to 6 which may have a substituent" or the "cycloalkyloxy group having a carbon number of 5 to 10 which may have a substituent", which is represented by R₁ to R₁₀, R₁₃, and R₁₆ in the general formulas (1a) and (1b), include: a methyloxy group, an ethyloxy group, a n-propyloxy group, an isopropyloxy group, a n-butyloxy group, a tert-butyloxy group, a n-pentyloxy group, a n-hexyloxy group, a cyclopentyloxy group, a cyclohexyloxy group, a cycloheptyloxy group, a cyclooctyloxy group, a 1-adamantyloxy group, a 2-adamantyloxy group, and the like, and these groups may be bonded to each other through a single bond, a substituted or unsubstituted methylene group, an oxygen atom, or a sulfur atom to form a ring.

In addition, these groups may have a substituent, and examples of the substituent are the same as the examples described for the "substituent" in the "linear or branched alkyl group having a carbon number of 1 to 6 which has a substituent", the "cycloalkyl group having a carbon number of 5 to 10 which has a substituent", or the "linear or branched alkenyl group having a carbon number of 2 to 6 which has a substituent" represented by R₁ to R₁₈ in the foregoing general formulas (1a) and (1b), and the same applies to the possible embodiments.

Specific examples of the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group", which is represented by R₁ to R₁₈ in the above-described general formulas (1a) and (1b), include: a phenyl group, a biphenylyl group, a terphenyl group, a naphthyl group, an anthracenyl group, a phenanthryl group, a fluorenyl group, an indenyl group, a pyrenyl group, a perylenyl group, a fluoranthenyl group, a triphenylenyl group, a pyridyl group, a pyrimidinyl group, a triazinyl group, a furyl group, a pyrrolyl group, a thienyl group, a quinolyl group, an isoquinolyl group, a benzofuranyl group, a benzothienyl group, an indolyl group, a carbazolyl group, a benzoxazolyl group, a benzothiazolyl group, a quinoxalinyl group, a benzimidazolyl group, a pyrazolyl group, a dibenzofuranyl group, a dibenzothienyl group, a naphthyridinyl group, a phenanthrolinyl group, an acridinyl group, a carborinyl group, and the like, and these groups may be bonded to each other through a single bond, a substituted or unsubstituted methylene group, an oxygen atom, or a sulfur atom to form a ring. The number of carbon atoms of the "aromatic hydrocarbon group" or the "condensed polycyclic aromatic group" may be, for example, 6 to 30. The number of carbon atoms of the "aromatic heterocyclic group" may be, for example, 2 to 20.

In addition, these groups may have a substituent, and examples of the substituent are the same as the examples described for the "substituent" in the "linear or branched alkyl group having a carbon number of 1 to 6 which has a substituent", the "cycloalkyl group having a carbon number of 5 to 10 which has a substituent", or the "linear or branched alkenyl group having a carbon number of 2 to 6 which has a substituent" represented by R₁ to R₁₈ in the foregoing general formulas (1a) and (1b), and the same applies to the possible embodiments.

Specific examples of the "aryloxy group" in the "substituted or unsubstituted aryloxy group", which is represented by R₁ to R₁₈ in the above-described general formulas (1a) and (1b), include: a phenyloxy group, a biphenylyloxy group, a terphenyloxy group, a naphthyloxy group, an anthracenyloxy group, a phenanthrenyloxy group, a fluorenyloxy group, an indenyloxy group, a pyrenyloxy group, a perylenyloxy group, and the like, and these groups may be bonded to each other through a single bond, a substituted or unsubstituted methylene group, an oxygen atom, or a sulfur atom to form a ring.

In addition, these groups may have a substituent, and examples of the substituent are the same as the examples described for the "substituent" in the "linear or branched alkyl group having a carbon number of 1 to 6 which has a substituent", the "cycloalkyl group having a carbon number of 5 to 10 which has a substituent", or the "linear or branched alkenyl group having a carbon number of 2 to 6 which has a substituent" represented by R₁ to R₁₈ in the foregoing general formulas (1a) and (1b), and the same applies to the possible embodiments.

Examples of the "aromatic hydrocarbon group", the "aromatic heterocyclic group", or the "condensed polycyclic aromatic group" in the "di-substituted amino group substituted with a group selected from an aromatic hydrocarbon group, an aromatic heterocyclic group, and a condensed polycyclic aromatic group", which is represented by R₁ to R₁₀, R₁₃, and R₁₆ in the general formulas (1a) and (1b), are the same as the examples described for the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group", which is represented by R₁ to R₁₈ in the general formulas (1a) and (1b).

In addition, these groups may have a substituent, and examples of the substituent are the same as the examples described for the "substituent" in the "linear or branched alkyl group having a carbon number of 1 to 6 which has a substituent", the "cycloalkyl group having a carbon number of 5 to 10 which has a substituent", or the "linear or branched alkenyl group having a carbon number of 2 to 6 which has a substituent" represented by R₁ to R₁₈ in the foregoing general formulas (1a) and (1b), and the same applies to the possible embodiments.

Examples of the linking group in the case where R₁ to R₁₀, R₁₃, and R₁₆ are bonded to each other through a linking group to form a ring together with a benzene ring to which R₁ to R₁₀, R₁₃, and R₁₆ are bonded, include a substituted or unsubstituted methylene group, a monosubstituted amino group and the like. Examples of the linking group in the case where R₁₁ and R₁₂, R₁₄ and R₁₅, or R₁₇ and R₁₈ are bonded to each other between the respective groups through a linking group to form a ring, include a substituted or unsubstituted methylene group, a monosubstituted amino group and the like.

Examples of the "aromatic hydrocarbon", the "aromatic heterocycle", or the "condensed polycyclic aromatic compound" of the "substituted or unsubstituted aromatic hydrocarbon", the "substituted or unsubstituted aromatic heterocycle", or the "substituted or unsubstituted condensed polycyclic aromatic compound" in the "divalent group of a substituted or unsubstituted aromatic hydrocarbon", the "divalent group of a substituted or unsubstituted aromatic heterocycle", or the "divalent group of a substituted or unsubstituted condensed polycyclic aromatic compound", which is represented by A₁ in the general formula (1a) and A₂ in the general formula (1b), include: benzene, biphenyl, terphenyl, tetrakisphenyl, styrene, naphthalene, anthracene, asenaphthalene, fluorene, phenanthrene, indan, pyrene, triphenylene, pyridine, pyrimidine, triazine, pyrrole, furan, thiophene, quinoline, isoquinoline, benzofuran, benzothiophene, indoline, carbazole, carboline, benzoxazole, benzothiazole, quinoxaline, benzimidazole, pyrazole, dibenzofuran, dibenzothiophene, naphthyridine, phenanthroline, acridine, and the like.

The "divalent group of a substituted or unsubstituted aromatic hydrocarbon", the "divalent group of a substituted or unsubstituted aromatic heterocycle", or the "divalent group of a substituted or unsubstituted condensed polycyclic aromatic compound", which is represented by A₁ in the general formula (1a) and A₂ in the general formula (1b), represents a divalent group obtained by removing two hydrogen atoms from the "aromatic hydrocarbon", the "aromatic heterocycle", or the "condensed polycyclic aromatic compound".

In addition, these groups may have a substituent, and examples of the substituent are the same as the examples described for the "substituent" in the "linear or branched alkyl group having a carbon number of 1 to 6 which has a substituent", the "cycloalkyl group having a carbon number of 5 to 10 which has a substituent", or the "linear or branched alkenyl group having a carbon number of 2 to 6 which has a substituent" represented by R₁ to R₁₈ in the foregoing general formulas (1a) and (1b), and the same applies to the possible embodiments.

R₁ to R₁₀, R₁₃, and R₁₆ in the general formula (1a) and the general formula (1b) may be the same as or different from each other and are preferably a hydrogen atom, a deuterium atom, a linear or branched alkyl group having a carbon number of 1 to 6 which may have a substituent, a substituted or unsubstituted aromatic hydrocarbon group, a substituted or unsubstituted aromatic heterocyclic group, or a substituted or unsubstituted condensed polycyclic aromatic group, and more preferably a hydrogen atom, a linear or branched alkyl group having a carbon number of 1 to 6 which may have a substituent, a substituted or unsubstituted aromatic hydrocarbon group, or a substituted or unsubstituted condensed polycyclic aromatic group, and they are particularly preferably the same as each other and are a hydrogen atom.

R₁₁ and R₁₂ in the general formula (1a) and the general formula (1b) may be the same as or different from each other and are preferably a linear or branched alkyl group having a carbon number of 1 to 6 which may have a substituent, a cycloalkyl group having a carbon number of 5 to 10 which may have a substituent, a substituted or unsubstituted aromatic hydrocarbon group, or a substituted or unsubstituted condensed polycyclic aromatic group, and more preferably a linear or branched alkyl group having a carbon number of 1 to 6 which may have a substituent, a substituted or unsubstituted aromatic hydrocarbon group, or a substituted or unsubstituted condensed polycyclic aromatic group, and they are still more preferably the same as each other and are an unsubstituted linear or branched alkyl group having a carbon number of 1 to 6, an unsubstituted aromatic hydrocarbon group or an unsubstituted condensed polycyclic aromatic group, which has a carbon number of 6 to 30, and are particularly preferably the same as each other and are a methyl group or a phenyl group.

R₁₄, R₁₅, R₁₇, and R₁₈ in the general formula (1a) and the general formula (1b) may be the same as or different from each other and are preferably a substituted or unsubstituted aromatic hydrocarbon group, a substituted or unsubstituted aromatic heterocyclic group, or a substituted or unsubstituted condensed polycyclic aromatic group, more preferably a substituted or unsubstituted aromatic hydrocarbon group, or a substituted or unsubstituted condensed polycyclic aromatic group, still more preferably a substituted aromatic hydrocarbon group, or a substituted condensed polycyclic aromatic group, and particularly preferably a substituted aromatic hydrocarbon group.

The substituent in R₁₄, R₁₅, R₁₇, and R₁₈ is preferably a deuterium atom; a linear or branched alkyl group having a carbon number of 1 to 6; a cycloalkyl group having a carbon number of 5 to 10; a linear or branched alkyloxy group having a carbon number of 1 to 6; a linear or branched alkenyl group having a carbon number of 2 to 6; an aromatic hydrocarbon group or a condensed polycyclic aromatic group, which has a carbon number of 6 to 30; an aromatic heterocyclic group; a di-substituted amino group substituted with an aromatic hydrocarbon group or a condensed polycyclic aromatic group, such as a diphenylamino group and a dinaphthylamino group; a di-substituted amino group substituted with an aromatic heterocyclic group, such as a dipyridylamino group and a dithienylamino group; or a di-substituted amino group substituted with a substituent selected from an aromatic hydrocarbon group, a condensed polycyclic aromatic group, and an aromatic heterocyclic group, more preferably a linear or branched alkyl group having a carbon number of 1 to 6, or an aromatic hydrocarbon group or a condensed polycyclic aromatic group, which has a carbon number of 6 to 30, and particularly preferably an unsubstituted linear or branched alkyl group having a carbon number of 1 to 6, or an unsubstituted aromatic hydrocarbon group or an unsubstituted condensed polycyclic aromatic group, which has a carbon number of 6 to 30.

A₁ and A₂ are preferably a single bond, or a divalent group of an unsubstituted aromatic hydrocarbon group or an unsubstituted condensed polycyclic aromatic group, more preferably a single bond, or a divalent group of an unsubstituted aromatic hydrocarbon group or an unsubstituted condensed polycyclic aromatic group, which has a carbon number of 6 to 20, still more preferably a single bond or a phenylene group, and particularly preferably a single bond.

Specific examples of the "aromatic hydrocarbon group" or the "condensed polycyclic aromatic group" in the "substituted or unsubstituted aromatic hydrocarbon group" or the "substituted or unsubstituted condensed polycyclic aromatic group", which is represented by Ar₁ to Ar₃ in the general formula (2), include groups such as a phenyl group, a biphenylyl group, a terphenyl group, a quarter phenyl group, a styryl group, a naphthyl group, an anthracenyl group, an acenaphthenyl group, a phenanthryl group, a fluorenyl group, an indenyl group, a pyrenyl group, a perylenyl group, a fluoranthenyl group, a triphenylenyl group, and the like.

In addition, these groups may have a substituent, and examples of the substituent are the same as the examples described for the "substituent" in the "linear or branched alkyl group having a carbon number of 1 to 6 which has a substituent", the "cycloalkyl group having a carbon number of 5 to 10 which has a substituent", or the "linear or branched alkenyl group having a carbon number of 2 to 6 which has a substituent", which is represented by R₁ to R₁₈ in the foregoing general formulas (1a) and (1b), and the same applies to the possible embodiments.

Specific examples of the "aromatic heterocyclic group" in the "substituted or unsubstituted aromatic heterocyclic group", which is represented by Ar₄ in the general formula (2), include groups such as a triazinyl group, a pyridyl group, a pyrimidinyl group, a furyl group, a pyrrolyl group, a thienyl group, a quinolyl group, an isoquinolyl group, a benzofuranyl group, a benzothienyl group, an indolyl group, a carbazolyl group, a benzoxazolyl group, a benzothiazolyl group, a quinoxalinyl group, a benzimidazolyl group, a pyrazolyl group, a dibenzofuranyl group, a dibenzothienyl group, a naphthyridinyl group, a phenanthrolinyl group, an acridinyl group, and carborinyl group.

In addition, these groups may have a substituent, and examples of the substituent are the same as the examples described for the "substituent" in the "linear or branched alkyl group having a carbon number of 1 to 6 which has a substituent", the "cycloalkyl group having a carbon number of 5 to 10 which has a substituent", or the "linear or branched alkenyl group having a carbon number of 2 to 6 which has a substituent", which is represented by R₁ to R₁₈ in the foregoing general formulas (1a) and (1b), and the same applies to the possible embodiments.

Specific examples of the "linear or branched alkyl group having a carbon number of 1 to 6", which is represented by R₁₉ to R₂₂ in the general formula (2), include a methyl group, an ethyl group, a n-propyl group, an i-propyl group, a n-butyl group, a 2-methylpropyl group, a t-butyl group, a n-pentyl group, a 3-methylbutyl group, a tert-pentyl group, a n-hexyl group, an iso-hexyl group, and a tert-hexyl group.

In addition, these groups may have a substituent, and examples of the substituent are the same as the examples described for the "substituent" in the "linear or branched alkyl group having a carbon number of 1 to 6 which has a substituent", the "cycloalkyl group having a carbon number of 5 to 10 which has a substituent", or the "linear or branched alkenyl group having a carbon number of 2 to 6 which has a substituent", which is represented by R₁ to R₁₈ in the foregoing general formulas (1a) and (1b), and the same applies to the possible embodiments.

Specific examples of the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group", which is represented by R₁₉ to R₂₂ in the general formula (2), include groups such as a phenyl group, a biphenylyl group, a terphenyl group, a quarter phenyl group, a styryl group, a naphthyl group, an anthracenyl group, an acenaphthenyl group, a phenanthryl group, a fluorenyl group, an indenyl group, a pyrenyl group, a perylenyl group, a fluoranthenyl group, a triphenylenyl group, a triazinyl group, a pyridyl group, a pyrimidinyl group, a furyl group, a pyrrolyl group, a thienyl group, a quinolyl group, an isoquinolyl group, a benzofuranyl group, a benzothienyl group, an indolyl group, a carbazolyl group, a benzoxazolyl group, a benzothiazolyl group, a quinoxalinyl group, a benzimidazolyl group, a pyrazolyl group, a dibenzofuranyl group, a dibenzothienyl group, a naphthyridinyl group, a phenanthrolinyl group, an acridinyl group, and a carborinyl group.

In addition, these groups may have a substituent, and examples of the substituent are the same as the examples described for the "substituent" in the "linear or branched alkyl group having a carbon number of 1 to 6 which has a substituent", the "cycloalkyl group having a carbon number of 5 to 10 which has a substituent", or the "linear or branched alkenyl group having a carbon number of 2 to 6 which has a substituent", which is represented by R₁ to R₁₈ in the foregoing general formulas (1a) and (1b), and the same applies to the possible embodiments.

Ar₁ in the general formula (2) is preferably a substituted or unsubstituted aromatic hydrocarbon group or a substituted or unsubstituted condensed polycyclic aromatic group, which has a carbon number of 6 to 20.

The substituent in Ar₁₁ is preferably a deuterium atom, a linear or branched alkyl group having a carbon number of 1 to 6, a cycloalkyl group having a carbon number of 5 to 10, an aromatic hydrocarbon group or a condensed polycyclic aromatic group, which has a carbon number of 6 to 30, or an aromatic heterocyclic group, more preferably a deuterium atom, or an aromatic hydrocarbon group or a condensed polycyclic aromatic group, which has a carbon number of 6 to 20, still more preferably a deuterium atom, or an unsubstituted aromatic hydrocarbon group or an unsubstituted condensed polycyclic aromatic group, which has a carbon number of 6 to 20, and particularly preferably an unsubstituted aromatic hydrocarbon group or an unsubstituted condensed polycyclic aromatic group, which has a carbon number of 6 to 20.

One of Ar₂ and Ar₃ in the general formula (2) is preferably a hydrogen atom. In the case where one of Ar₂ and Ar₃ is a hydrogen atom, the other one thereof is preferably a substituted or unsubstituted aromatic hydrocarbon group or a substituted or unsubstituted condensed polycyclic aromatic group, which has a carbon number of 6 to 20, and more preferably a substituted aromatic hydrocarbon group or an unsubstituted condensed polycyclic aromatic group, which has a carbon number of 6 to 20.

The substituent in Ar₂ and Ar₃ is preferably a deuterium atom, a linear or branched alkyl group having a carbon number of 1 to 6, a cycloalkyl group having a carbon number of 5 to 10, an aromatic hydrocarbon group or a condensed polycyclic aromatic group, which has a carbon number of 6 to 30, or an aromatic heterocyclic group, more preferably an aromatic hydrocarbon group or a condensed polycyclic aromatic group, which has a carbon number of 6 to 20, and particularly preferably an unsubstituted aromatic hydrocarbon group or an unsubstituted condensed polycyclic aromatic group, which has a carbon number of 6 to 20.

Ar4 in the general formula (2) is preferably a substituted or unsubstituted nitrogen-containing aromatic heterocyclic group, more preferably an unsubstituted nitrogen-containing aromatic heterocyclic group, still more preferably an unsubstituted nitrogen-containing aromatic heterocyclic group having a carbon number of 5 to 10, and particularly preferably an unsubstituted aromatic heterocyclic group containing one nitrogen atom and having a carbon number of 5 to 10.

R₁₉ to R₂₂ in the general formula (2) are preferably a hydrogen atom, a deuterium atom, a linear or branched alkyl group having a carbon number of 1 to 6, a substituted or unsubstituted aromatic hydrocarbon group, a substituted or unsubstituted aromatic heterocyclic group, or a substituted or unsubstituted condensed polycyclic aromatic group, and more preferably a hydrogen atom, a deuterium atom, or a linear or branched alkyl group having a carbon number of 1 to 6, and they are particularly preferably the same as each other and are a hydrogen atom.

Specific examples of the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group", which is represented by Ar₅, Ar₆, and Y₁ in the general formula (3), include: a phenyl group, a biphenylyl group, a terphenyl group, a naphthyl group, an anthracenyl group, a phenanthryl group, a fluorenyl group, a spirobifluorenyl group, an indenyl group, a pyrenyl group, a perylenyl group, a fluoranthenyl group, a triphenylenyl group, a pyridyl group, a pyrimidinyl group, a triazinyl group, a furyl group, a pyrrolyl group, a thienyl group, a quinolyl group, an isoquinolyl group, a benzofuranyl group, a benzothienyl group, an indolyl group, a carbazolyl group, a benzoxazolyl group, a benzothiazolyl group, a quinoxalinyl group, a benzimidazolyl group, a pyrazolyl group, a dibenzofuranyl group, a dibenzothienyl group, a naphthyridinyl group, a phenanthrolinyl group, an acridinyl group, a carborinyl group, and the like, as well as those selected from an aryl group having a carbon number of 6 to 30 and a heteroaryl group having a carbon number of 2 to 20.

In addition, these groups may have a substituent, and examples of the substituent are the same as the examples described for the "substituent" in the "linear or branched alkyl group having a carbon number of 1 to 6 which has a substituent", the "cycloalkyl group having a carbon number of 5 to 10 which has a substituent", or the "linear or branched alkenyl group having a carbon number of 2 to 6 which has a substituent", which is represented by R₁ to R₁₈ in the foregoing general formulas (1a) and (1b), and the same applies to the possible embodiments.

Specific examples of the "alkyl group" in the "substituted or unsubstituted alkyl group", which is represented by Ar₅, Ar₆, and Y₁ in the general formula (3), include a methyl group, an ethyl group, an n-propyl group, an isopropyl group, an n-butyl group, an isobutyl group, a tert-butyl group, an n-pentyl group, an isopentyl group, a neopentyl group, an n-hexyl group, a cyclopentyl group, a cyclohexyl group, a 1-adamantyl group, a 2-adamantyl group, a vinyl group, an allyl group, an isopropenyl group, a 2-butenyl group, and the like.

In addition, these groups may have a substituent, and examples of the substituent are the same as the examples described for the "substituent" in the "linear or branched alkyl group having a carbon number of 1 to 6 which has a substituent", the "cycloalkyl group having a carbon number of 5 to 10 which has a substituent", or the "linear or branched alkenyl group having a carbon number of 2 to 6 which has a substituent", which is represented by R₁ to R₁₈ in the foregoing general formulas (1a) and (1b), and the same applies to the possible embodiments.

Ar₅ and Ar₆ in the general formula (3) may be the same as or different from each other and are preferably a hydrogen atom, a substituted or unsubstituted aromatic hydrocarbon group, a substituted or unsubstituted aromatic heterocyclic group, or a substituted or unsubstituted condensed polycyclic aromatic group, more preferably a substituted or unsubstituted aromatic hydrocarbon group or a substituted or unsubstituted condensed polycyclic aromatic group, which has a carbon number of 6 to 30, or a substituted or unsubstituted aromatic heterocyclic group having a carbon number of 2 to 20, and particularly preferably a substituted or unsubstituted aromatic hydrocarbon group or a substituted or unsubstituted condensed polycyclic aromatic group, which has a carbon number of 6 to 20.

The substituent in Ar₅ and Ar₆ is preferably an aromatic hydrocarbon group or a condensed polycyclic aromatic group, which has a carbon number of 6 to 30, or an aromatic heterocyclic group having a carbon number of 2 to 20, more preferably an unsubstituted aromatic hydrocarbon group or an unsubstituted condensed polycyclic aromatic group, which has a carbon number of 6 to 20, or an unsubstituted aromatic heterocyclic group having a carbon number of 2 to 10.

Y₁ in the general formula (3) is preferably a substituted or unsubstituted aromatic hydrocarbon group, a substituted or unsubstituted aromatic heterocyclic group, or a substituted or unsubstituted condensed polycyclic aromatic group, more preferably a substituted or unsubstituted aromatic hydrocarbon group or a substituted or unsubstituted condensed polycyclic aromatic group, which has a carbon number of 6 to 30, or a substituted or unsubstituted aromatic heterocyclic group having a carbon number of 2 to 20, and particularly preferably a substituted or unsubstituted aromatic hydrocarbon group or a substituted or unsubstituted condensed polycyclic aromatic group, which has a carbon number of 6 to 20.

The substituent in Y₁ is preferably an aromatic hydrocarbon group or a condensed polycyclic aromatic group, which has a carbon number of 6 to 30, or an aromatic heterocyclic group having a carbon number of 2 to 20, and more preferably an unsubstituted aromatic hydrocarbon group or an unsubstituted condensed polycyclic aromatic group, which has a carbon number of 6 to 20, or an unsubstituted aromatic heterocyclic group having a carbon number of 2 to 10.

X in the general formula (3) is preferably an oxygen atom. Z₁ and Z₂ in the general formula (3) are preferably the same as each other and are a carbon atom.

Specific examples of the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group", which is represented by Ar₇ to Ar₁₀ in the general formula (4), include: a phenyl group, a biphenylyl group, a terphenyl group, a naphthyl group, an anthracenyl group, a phenanthryl group, a fluorenyl group, an indenyl group, a pyrenyl group, a perylenyl group, a fluoranthenyl group, a triphenylenyl group, a pyridyl group, a pyrimidinyl group, a triazinyl group, a furyl group, a pyrrolyl group, a thienyl group, a quinolyl group, an isoquinolyl group, a benzofuranyl group, a benzothienyl group, an indolyl group, a carbazolyl group, a benzoxazolyl group, a benzothiazolyl group, a quinoxalinyl group, a benzimidazolyl group, a pyrazolyl group, a dibenzofuranyl group, a dibenzothienyl group, a naphthyridinyl group, a phenanthrolinyl group, an acridinyl group, a carborinyl group, and the like.

In addition, these groups may have a substituent, and examples of the substituent are the same as the examples described for the "substituent" in the "linear or branched alkyl group having a carbon number of 1 to 6 which has a substituent", the "cycloalkyl group having a carbon number of 5 to 10 which has a substituent", or the "linear or branched alkenyl group having a carbon number of 2 to 6 which has a substituent", which is represented by R₁ to R₁₈ in the foregoing general formulas (1a) and (1b), and the same applies to the possible embodiments.

Ar₇ to Ar₁₀ in the general formula (4) may be the same as or different from each other and are preferably a substituted or unsubstituted aromatic hydrocarbon group, or a substituted or unsubstituted condensed polycyclic aromatic group, and more preferably a substituted or unsubstituted aromatic hydrocarbon group or a substituted or unsubstituted condensed polycyclic aromatic group, which has a carbon number of 6 to 20.

The substituent in Ar₇ to Ar₁₀ is preferably an aromatic hydrocarbon group or a condensed polycyclic aromatic group having a carbon number of 6 to 30, or an aromatic heterocyclic group having a carbon number of 2 to 20.

The indenophenanthrene compounds represented by the foregoing general formulas (1a) and (1b), which are preferably used in the organic EL device of the present embodiment, can be used as a constituent material of a hole injection layer or a hole transport layer of an organic EL device. The indenophenanthrene compounds represented by the foregoing general formulas (1a) and (1b) have high hole-mobility and are compounds preferred as a material of a hole injection layer or a hole transport layer.

Since the indenophenanthrene compounds, which have hole-mobility higher than that of a conventional hole transport material, have an excellent electron blocking ability, have an excellent amorphous property, and are stable in a thin film state, are used in the organic EL device of the present embodiment, it is possible to achieve an organic EL device having high efficiency, a low drive voltage and long lifetime.

Specific examples of preferred compounds, among the indenophenanthrene compounds which are represented by the foregoing general formula (1a) and are preferably used in the organic EL device of the present embodiment, are shown below. However, the present invention is not limited to these compounds.

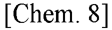

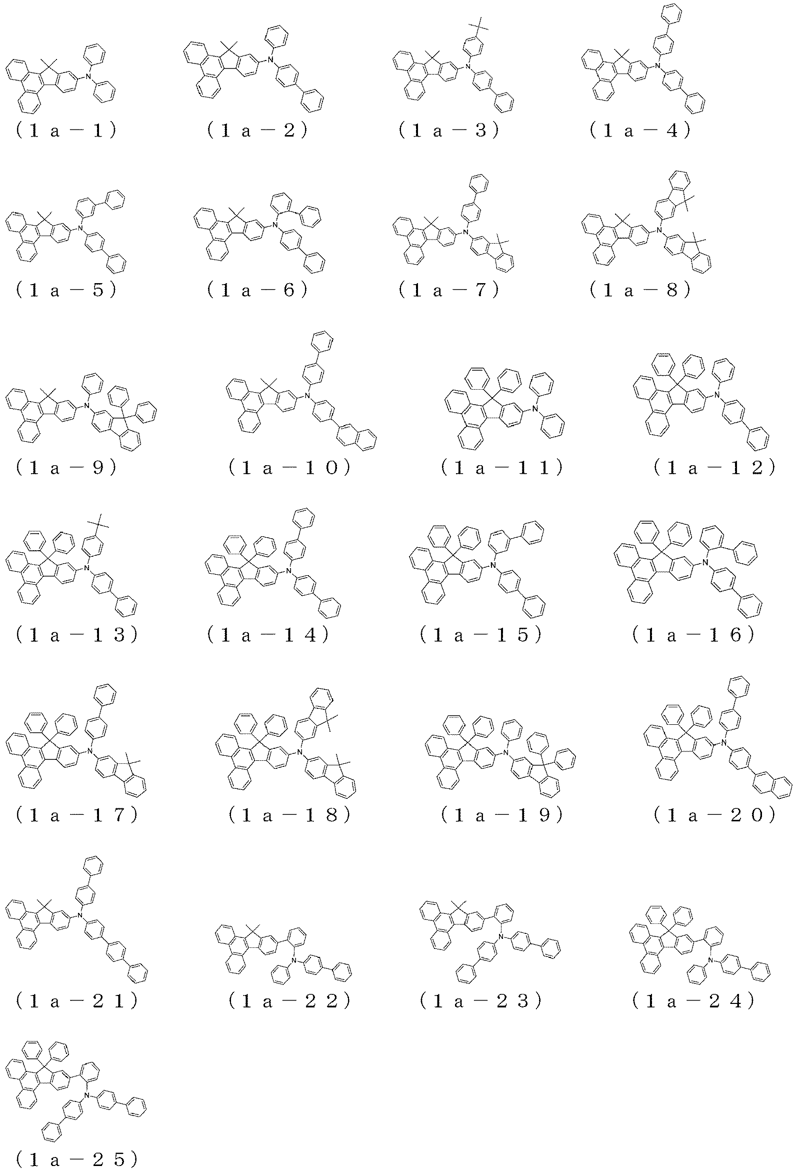

Specific examples of preferred compounds, among the indenophenanthrene compounds which are represented by the foregoing general formula (1b) and are preferably used in the organic EL device of the present embodiment, are shown below. However, the present invention is not limited to these compounds.

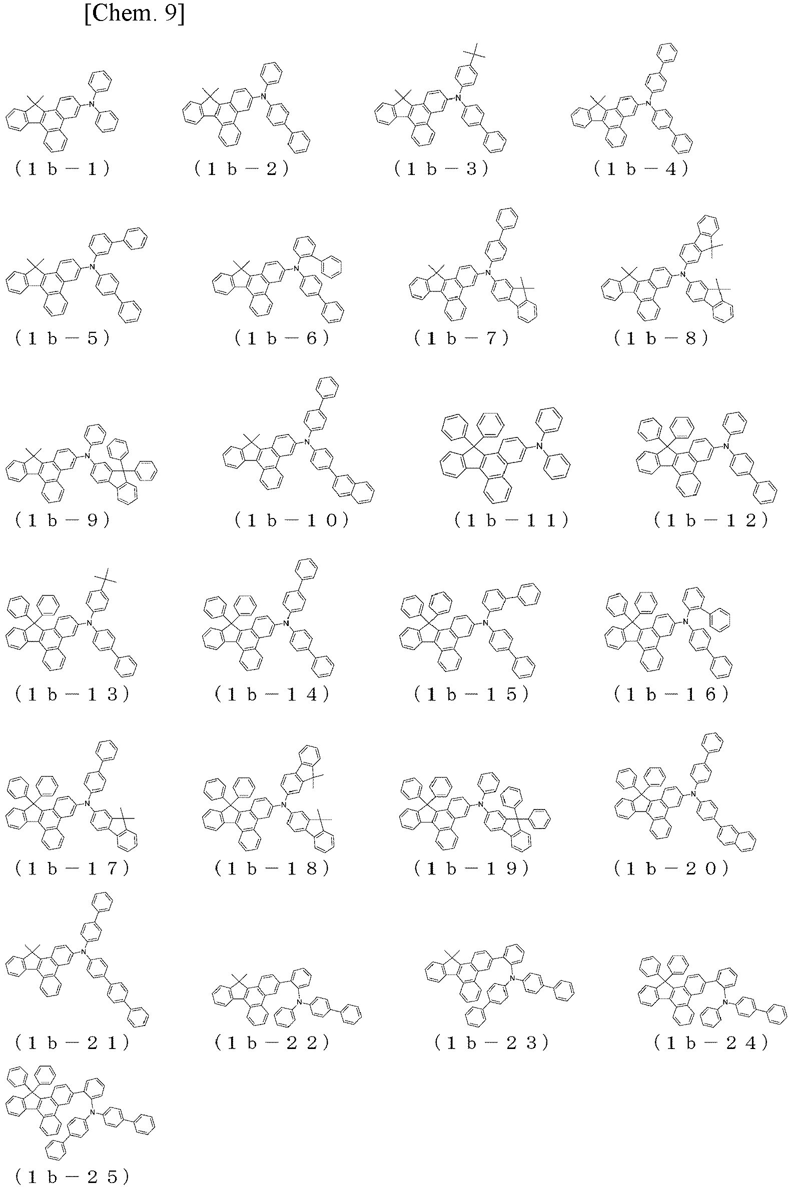

Specific examples of preferred compounds, among the compounds which have a pyrimidine ring structure, represented by the foregoing general formula (2) and are preferably used in the organic EL device of the present embodiment, are shown below. However, the present invention is not limited to these compounds.

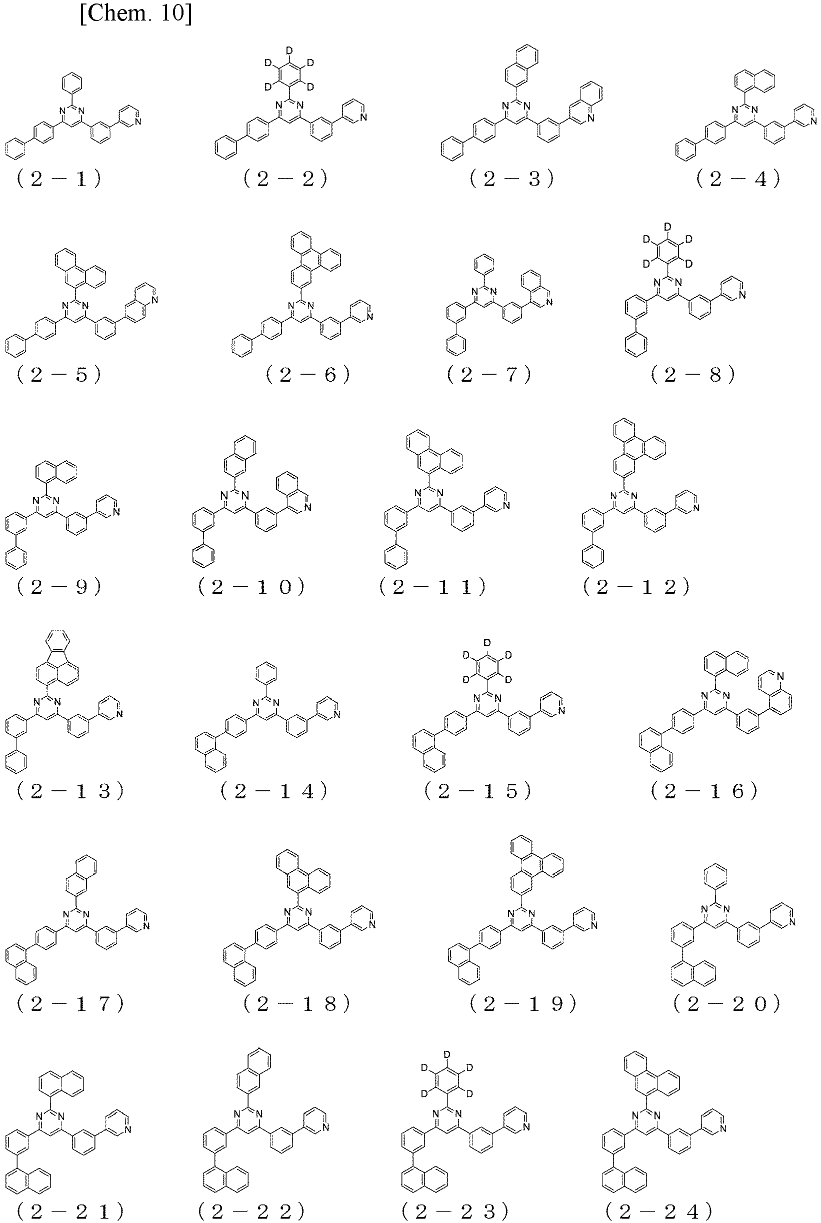

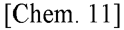

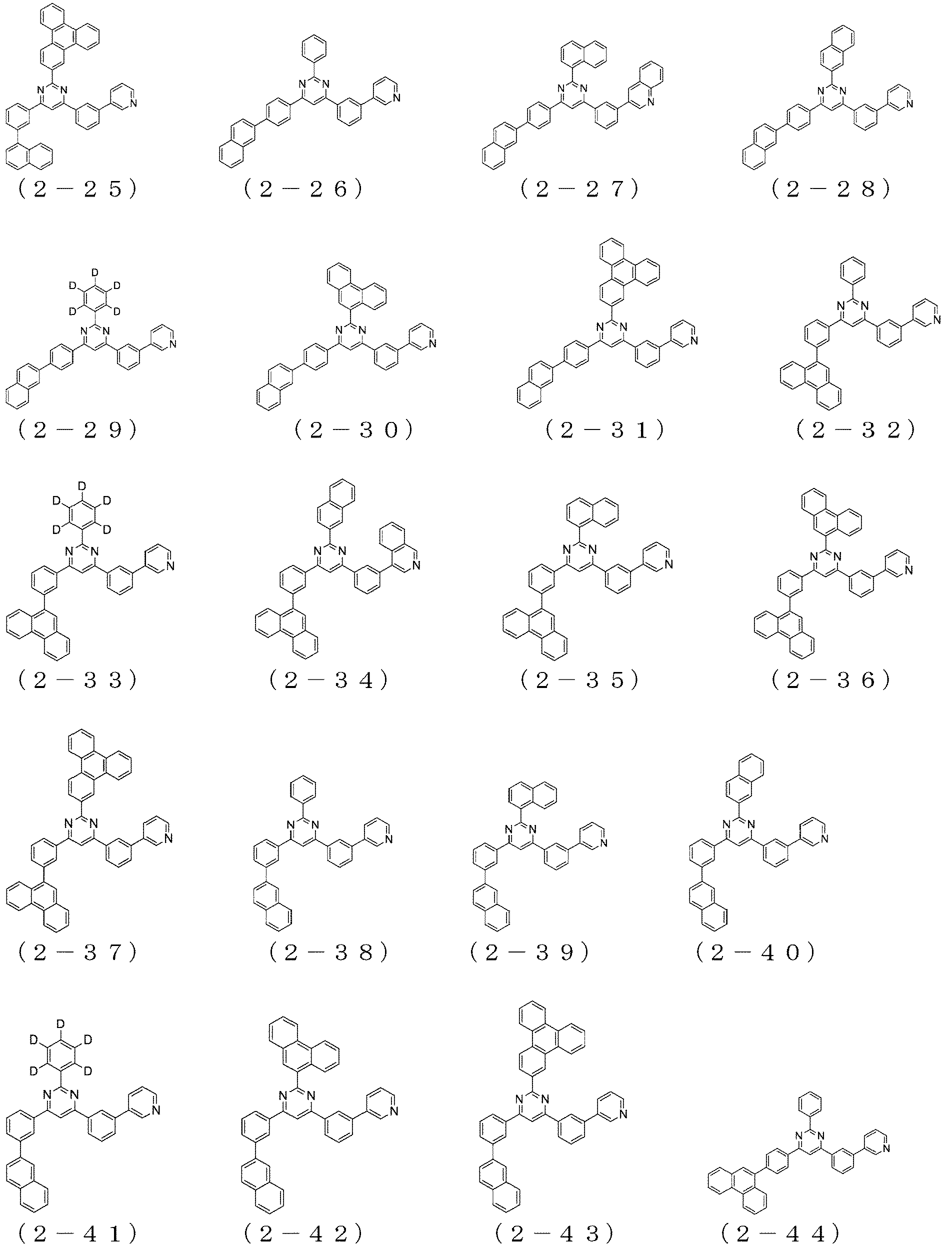

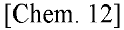

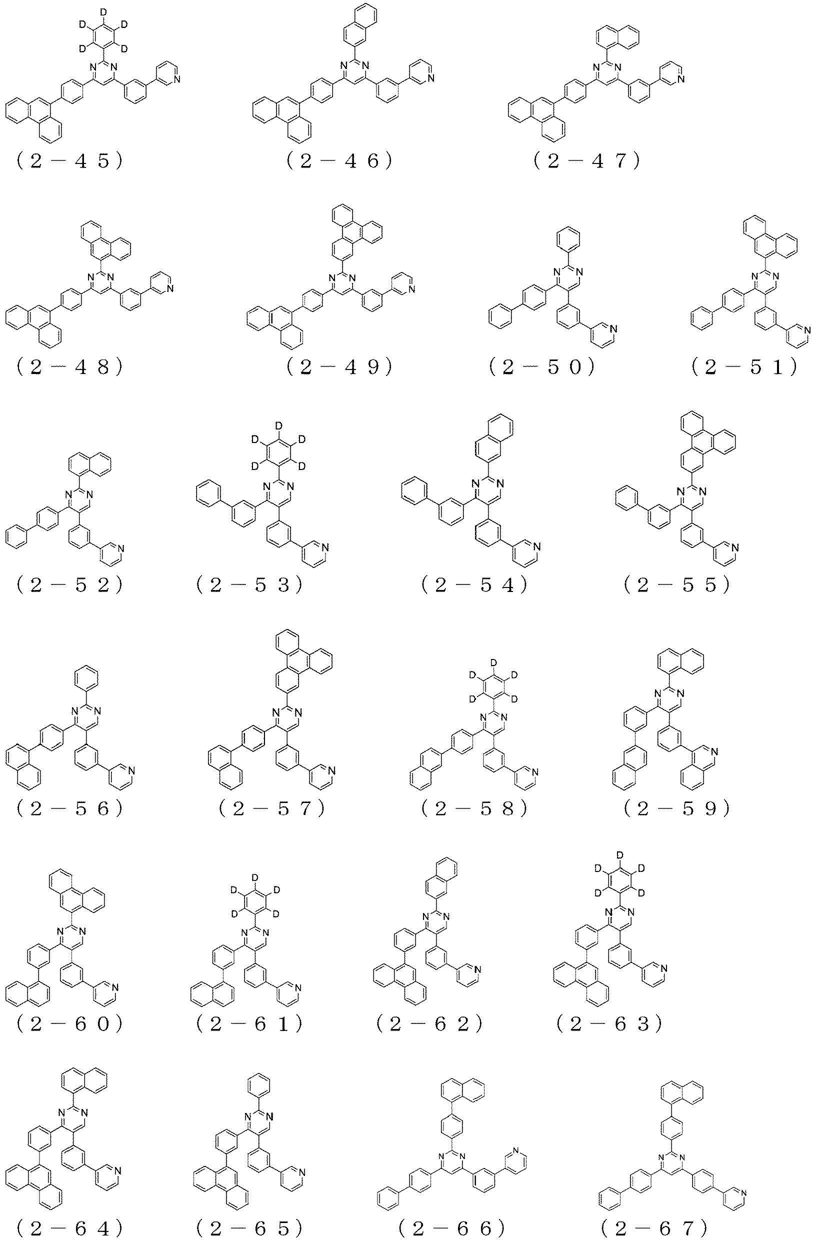

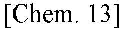

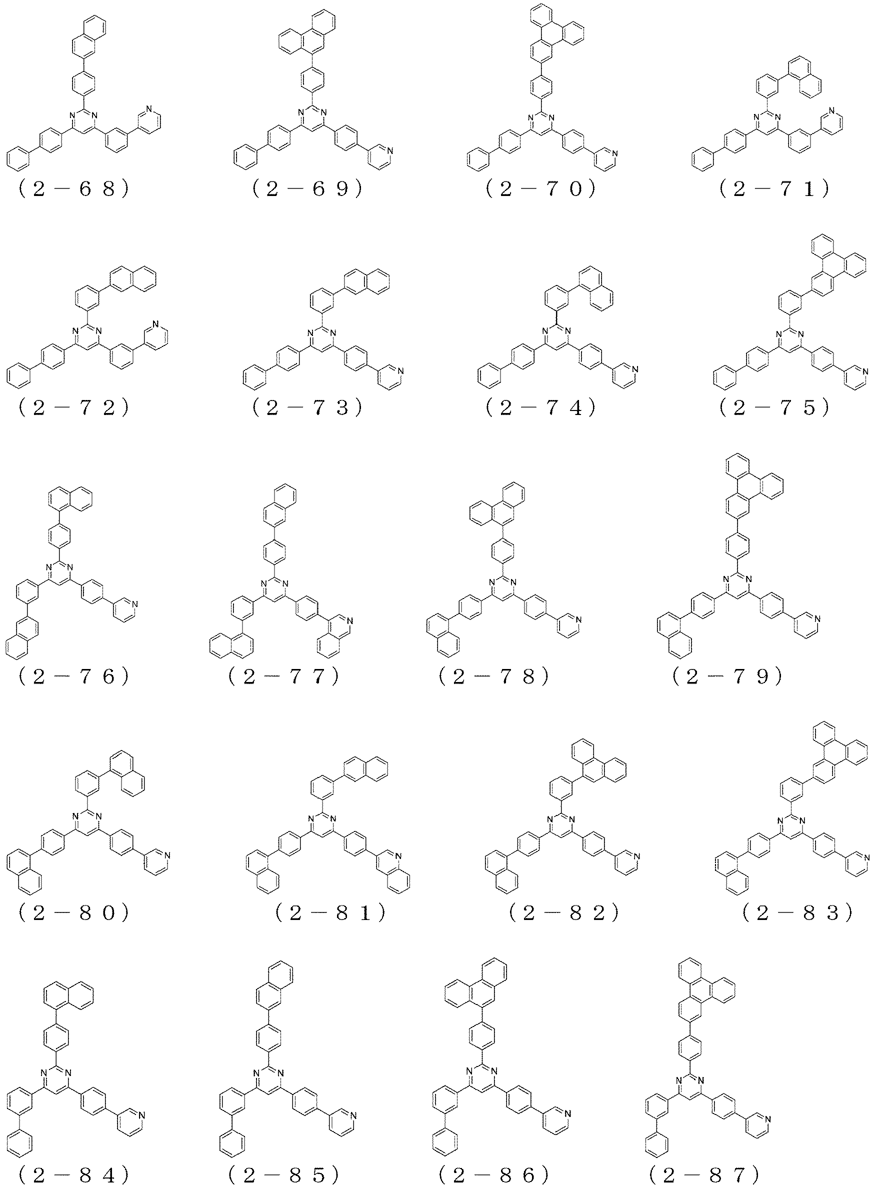

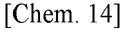

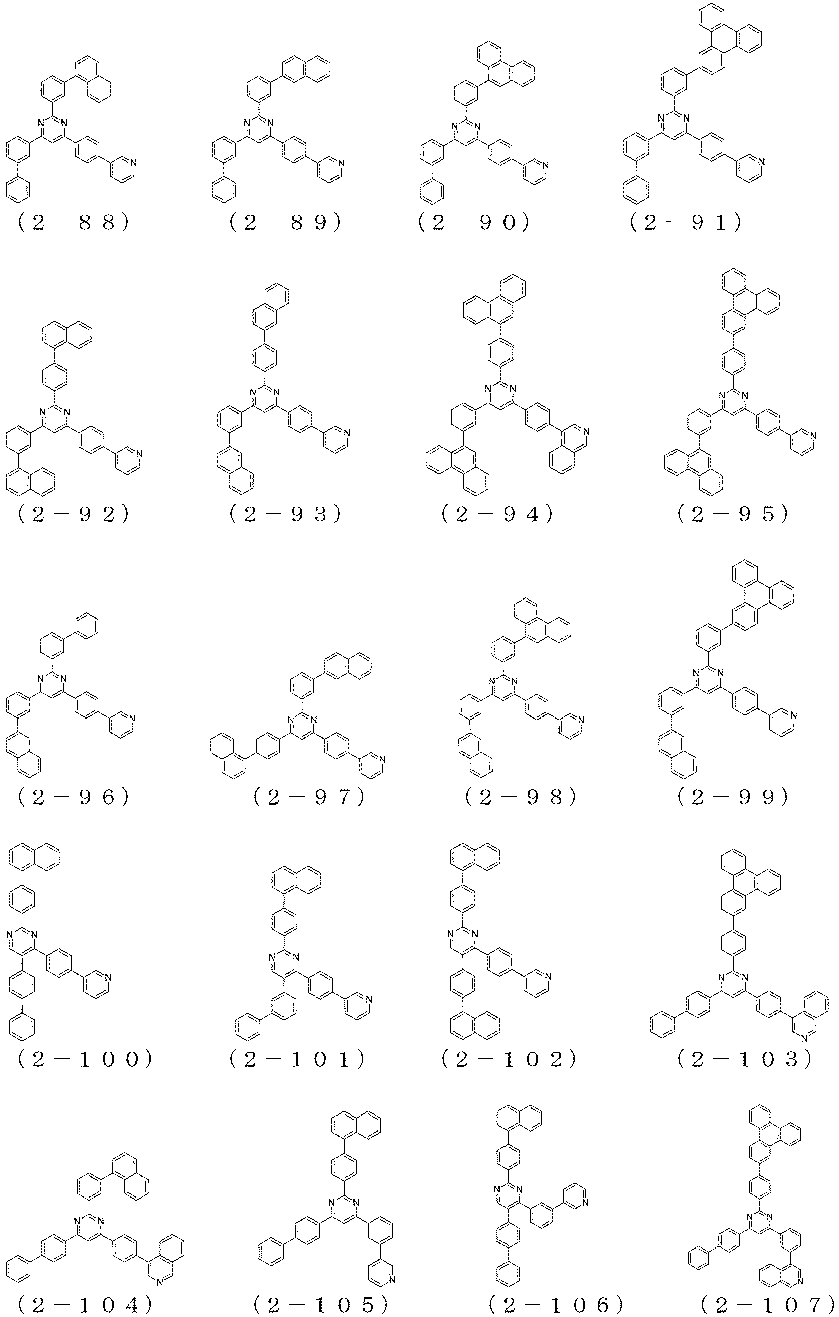

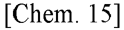

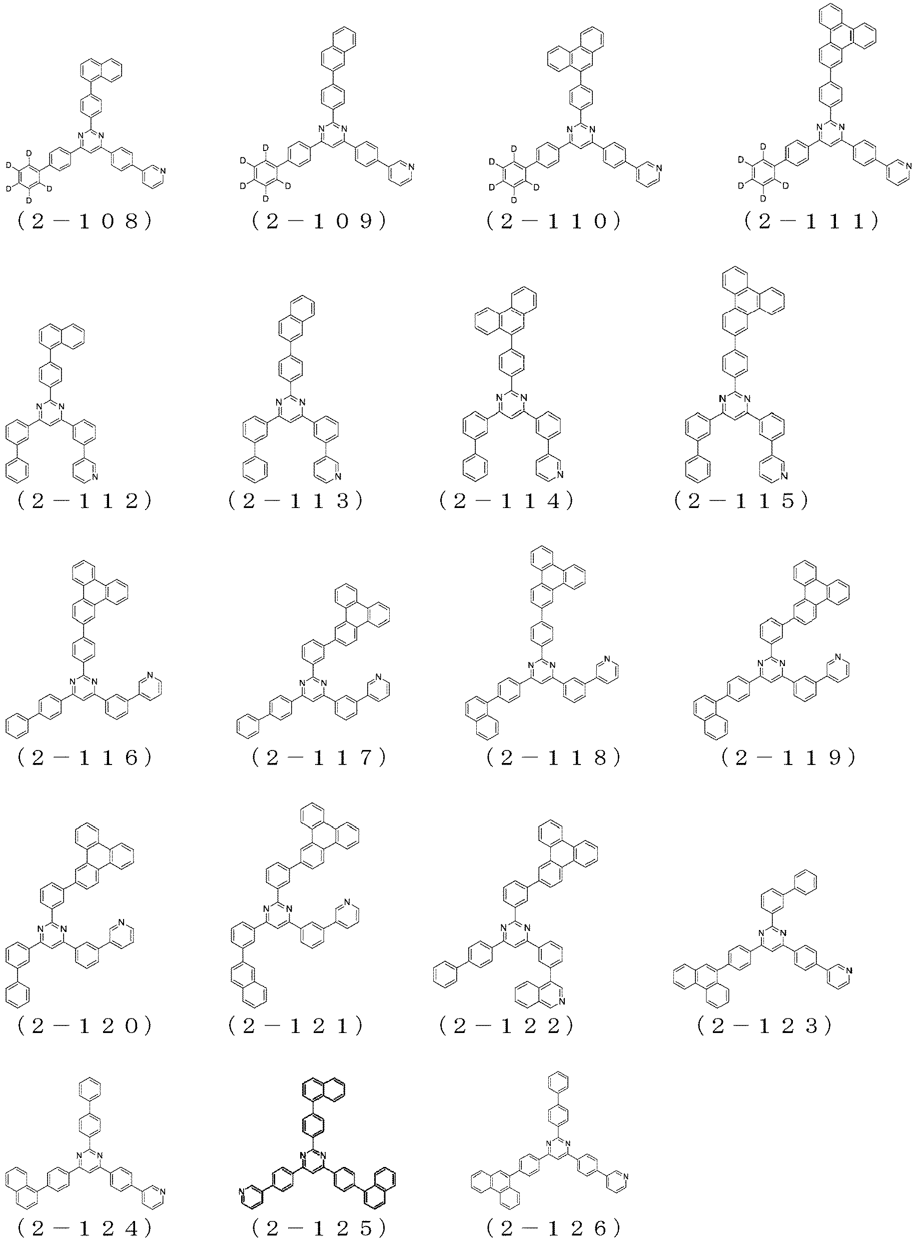

The above-mentioned compound having a pyrimidine ring structure can be synthesized according to a known method per se.

Specific examples of preferred compounds, among the benzoxazole compounds which are represented by the foregoing general formula (3) and are preferably used in the organic EL device of the present embodiment, are shown below. However, the present invention is not limited to these compounds.

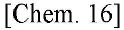

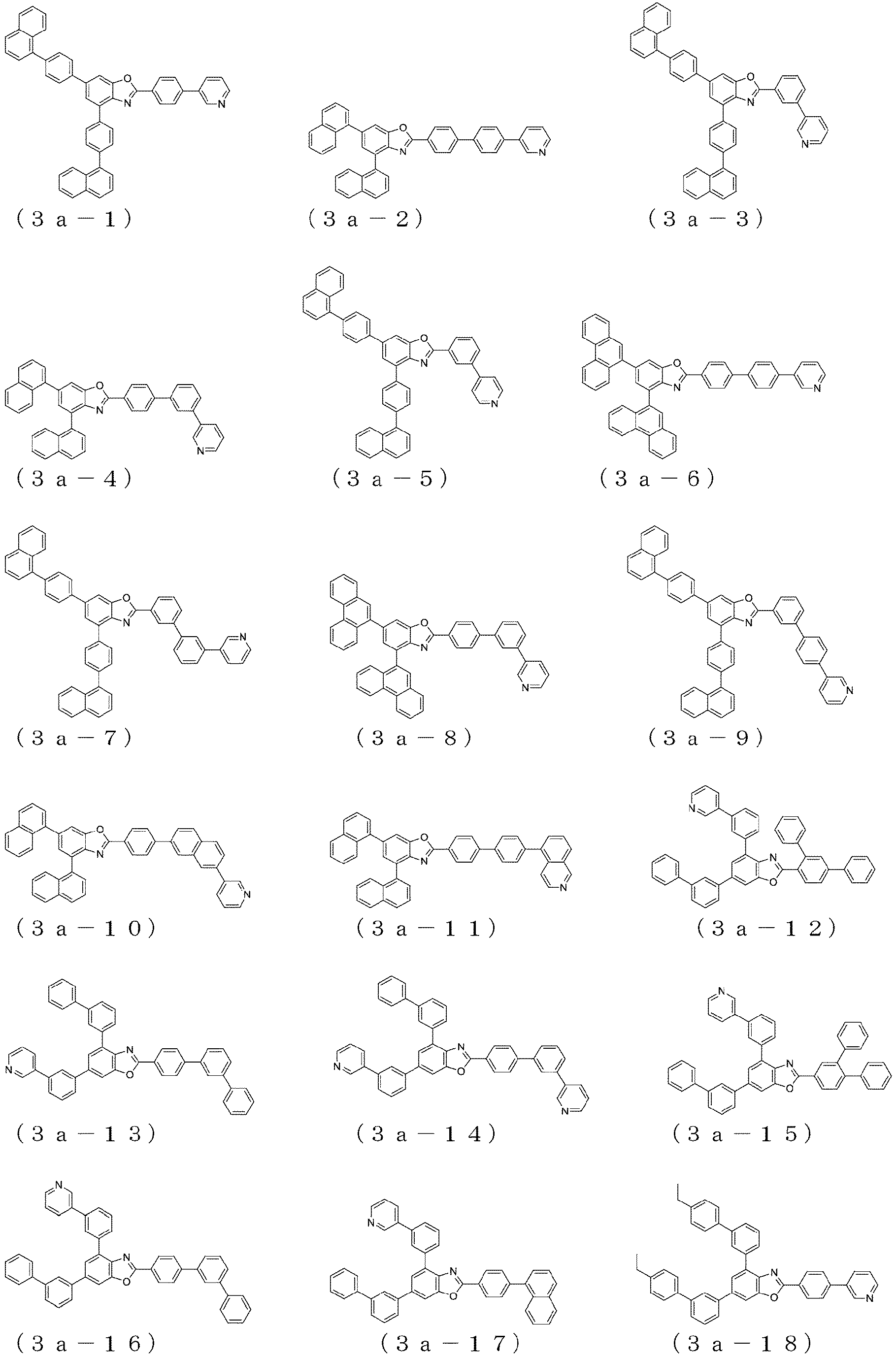

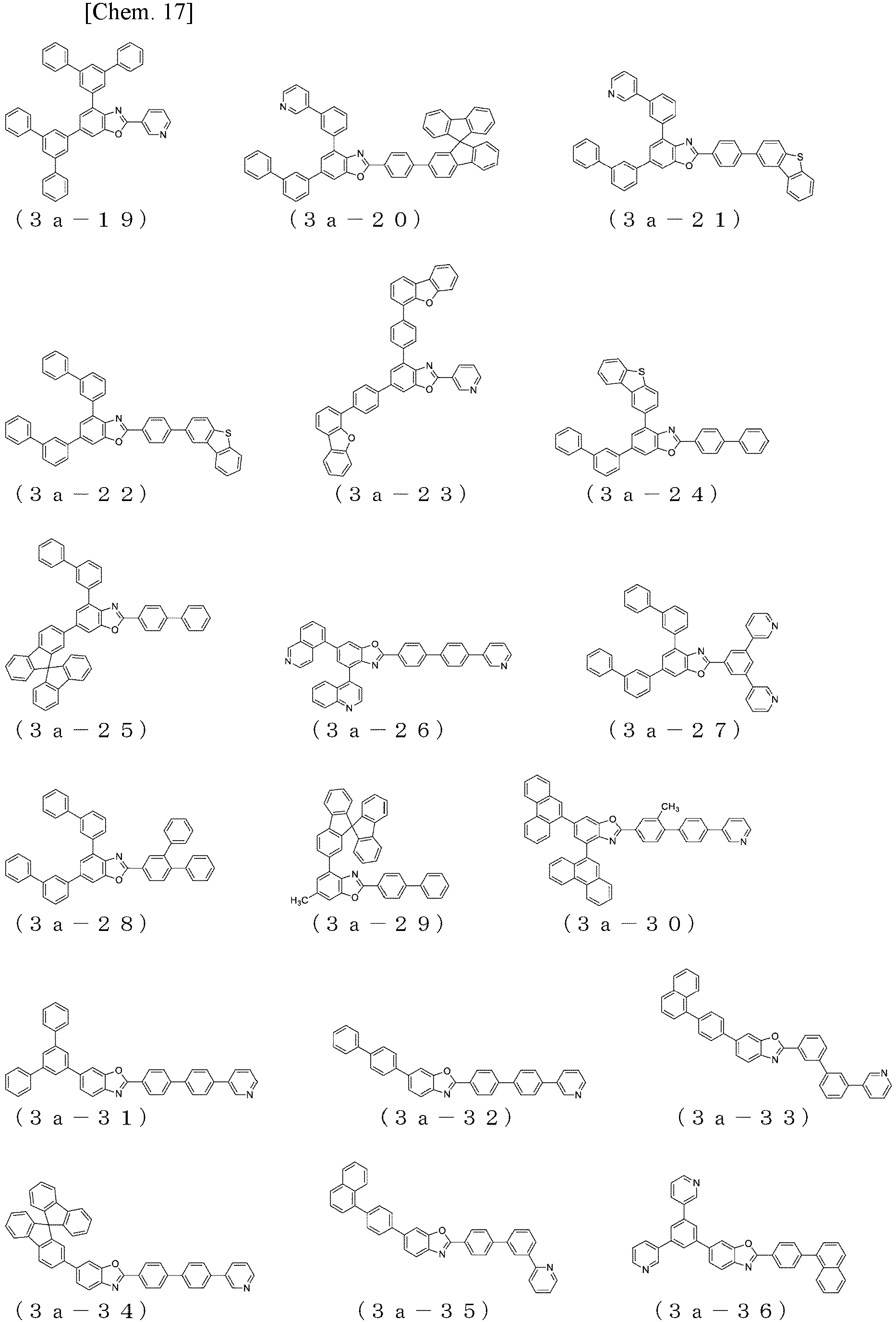

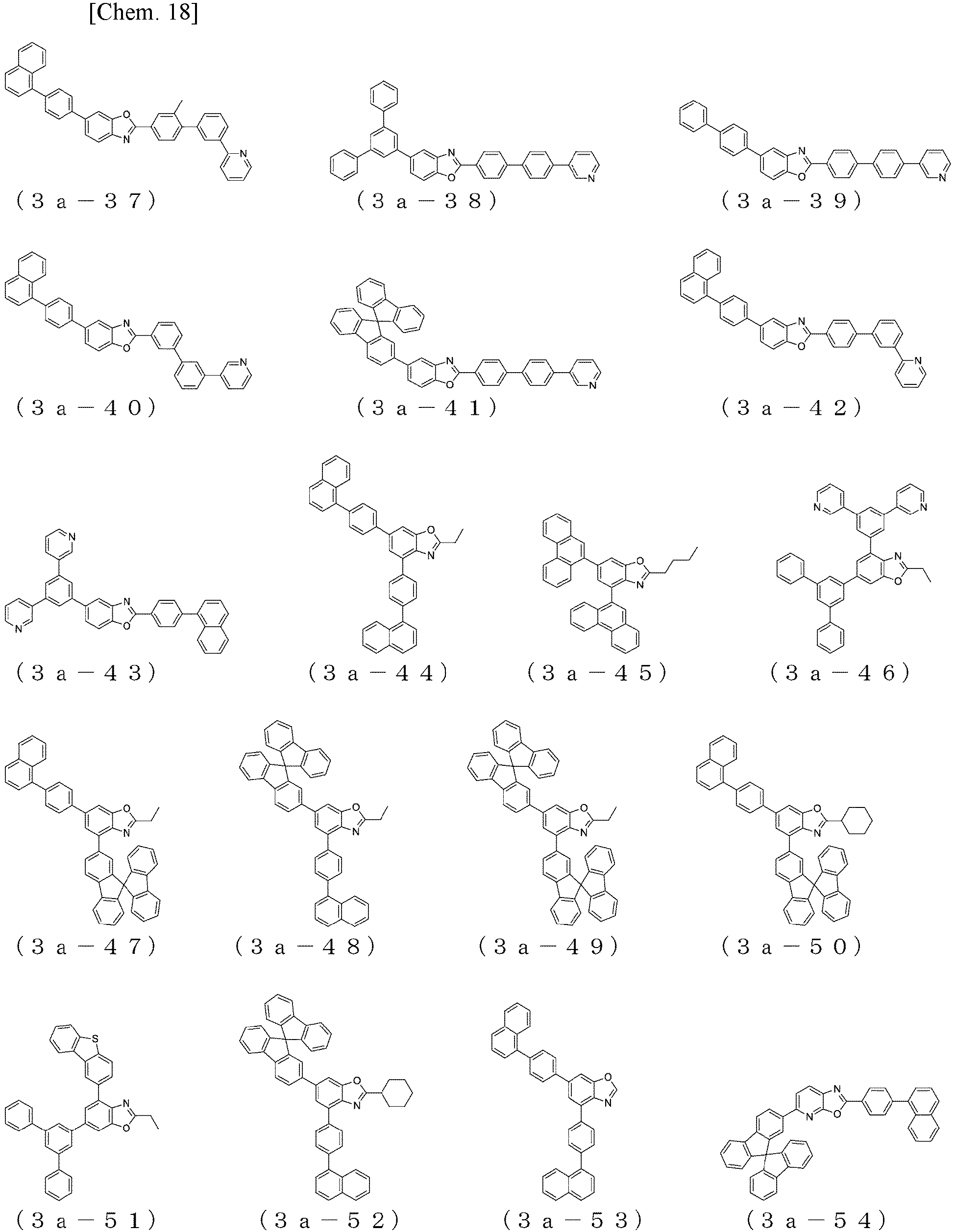

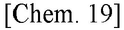

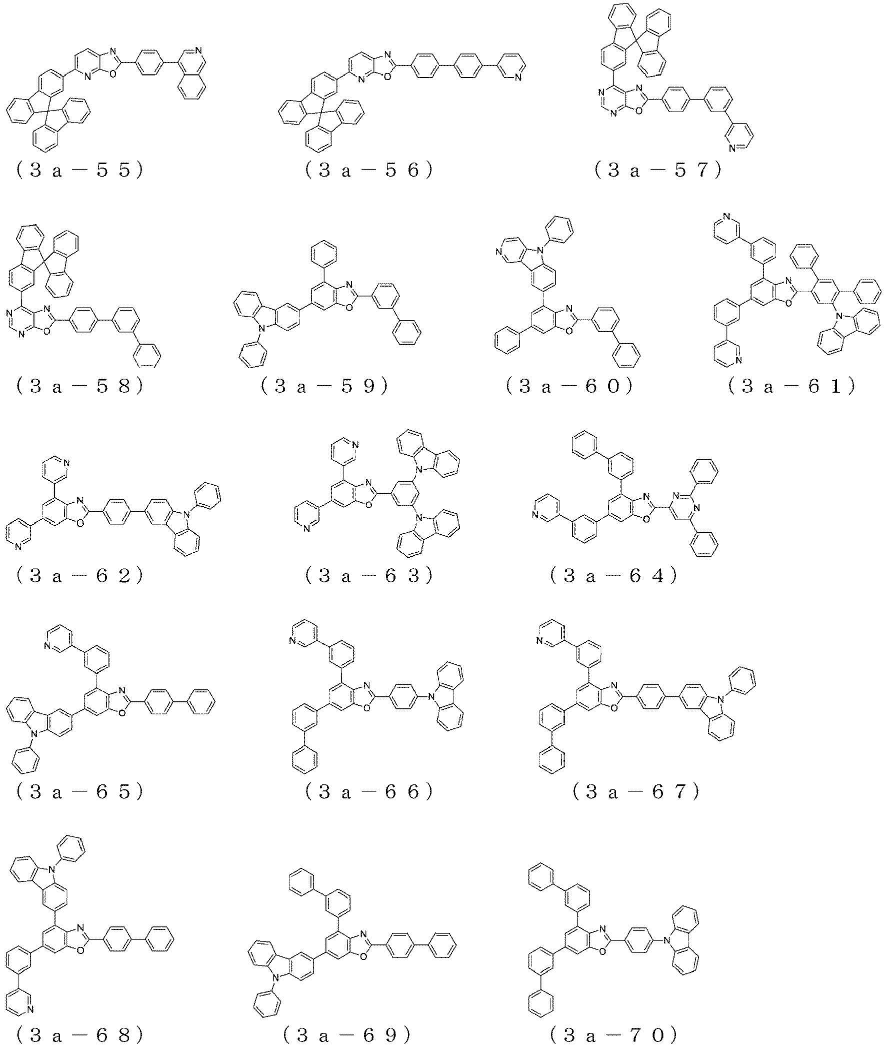

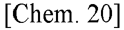

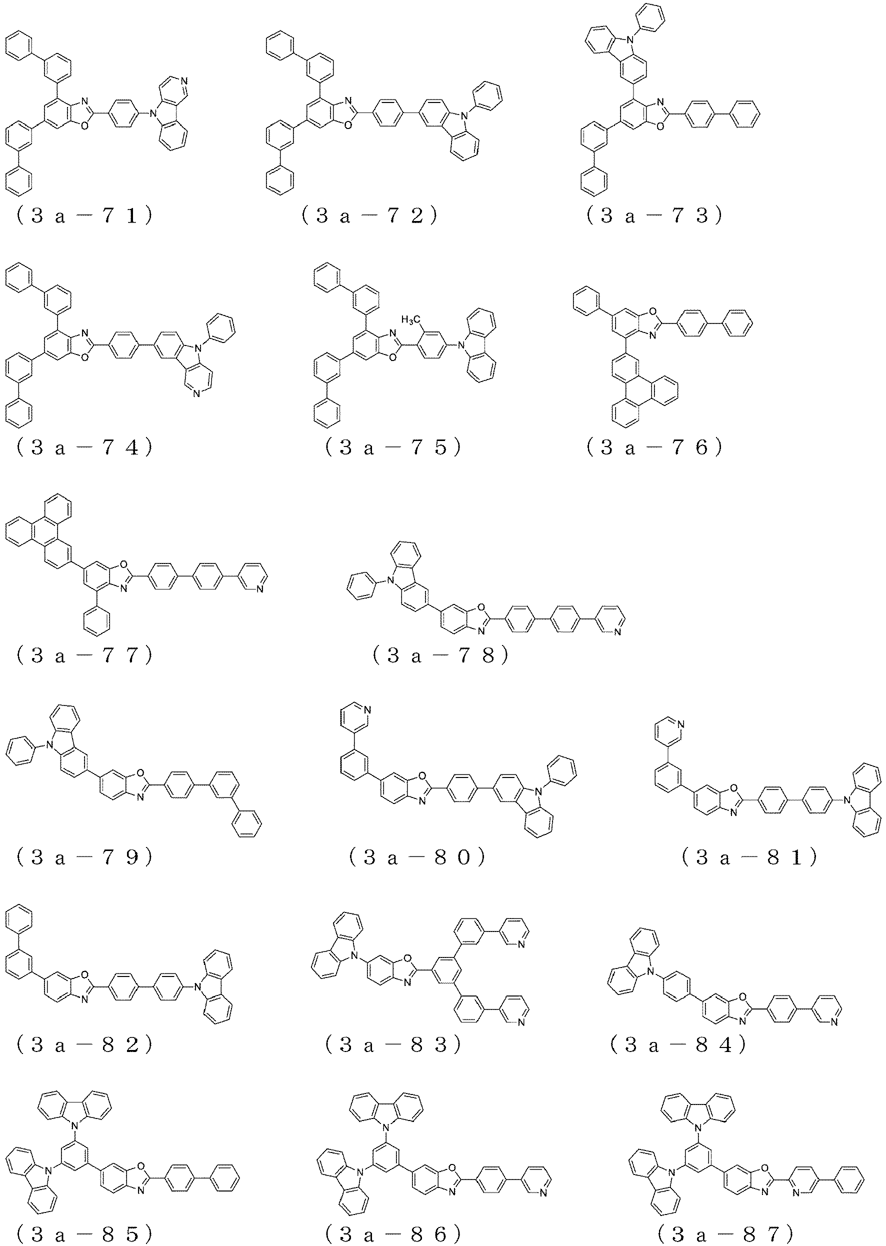

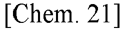

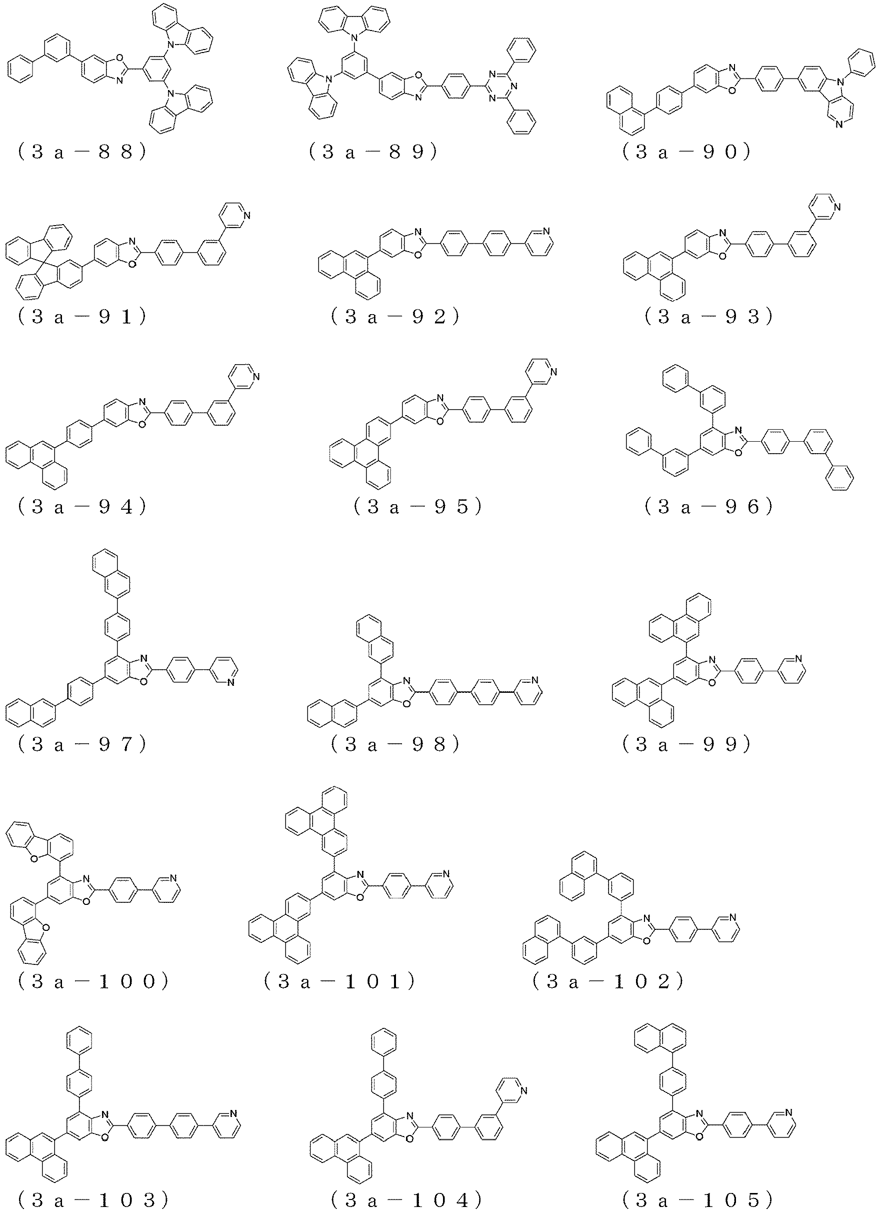

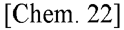

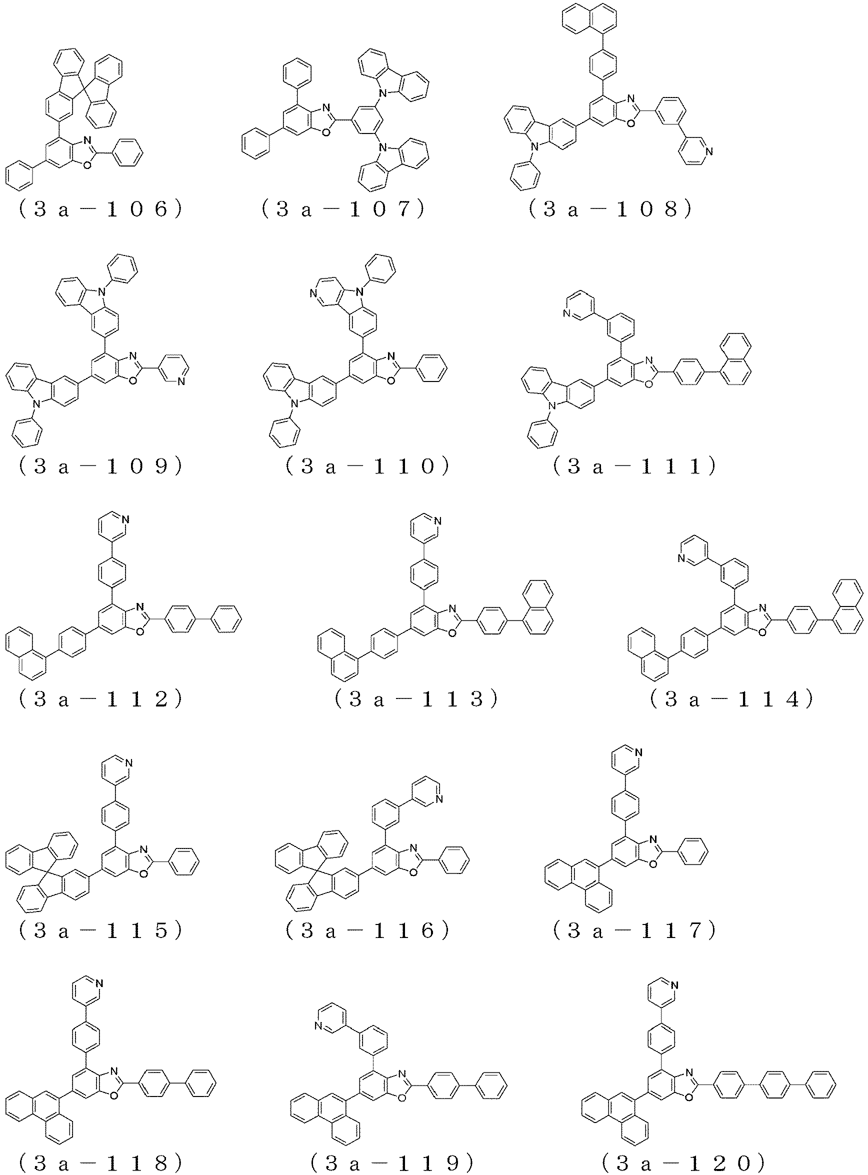

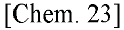

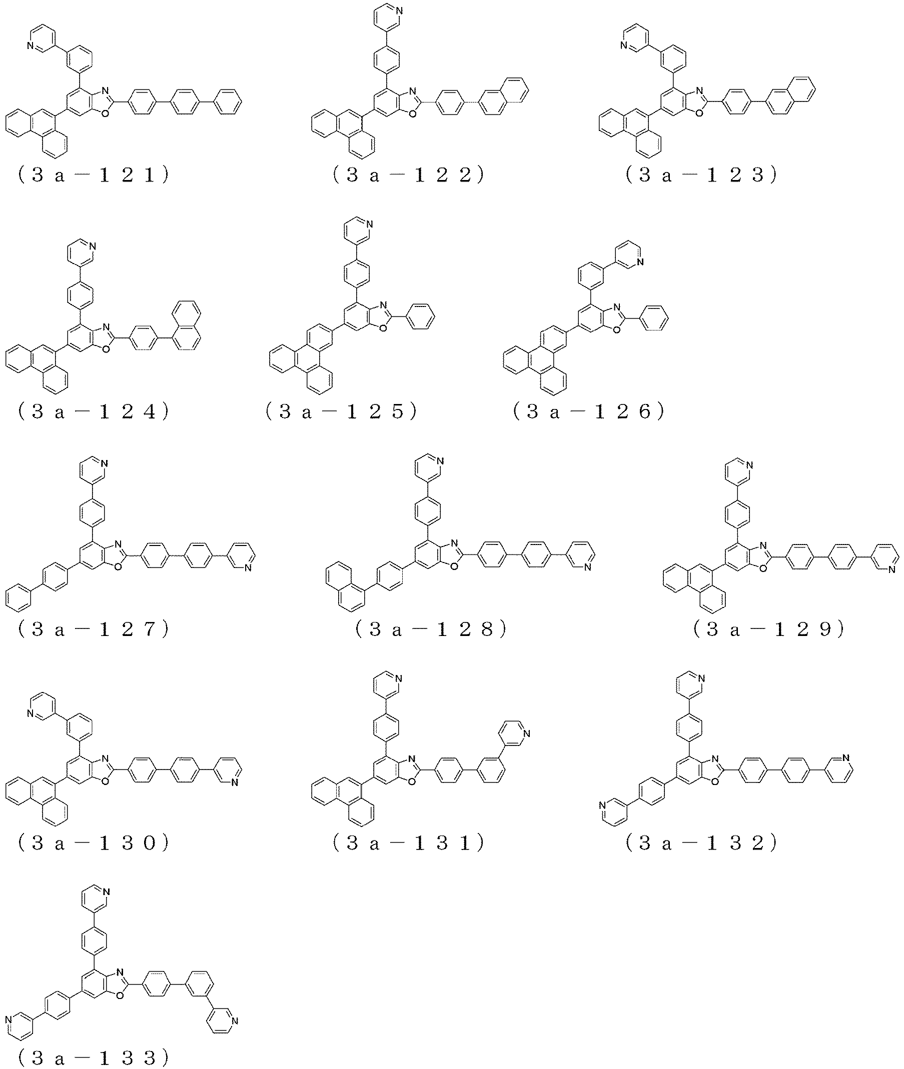

Specific examples of preferred compounds, among the benzothiazole compounds which are represented by the foregoing general formula (3) and are preferably used in the organic EL device of the present embodiment, are shown below. However, the present invention is not limited to these compounds.

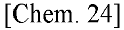

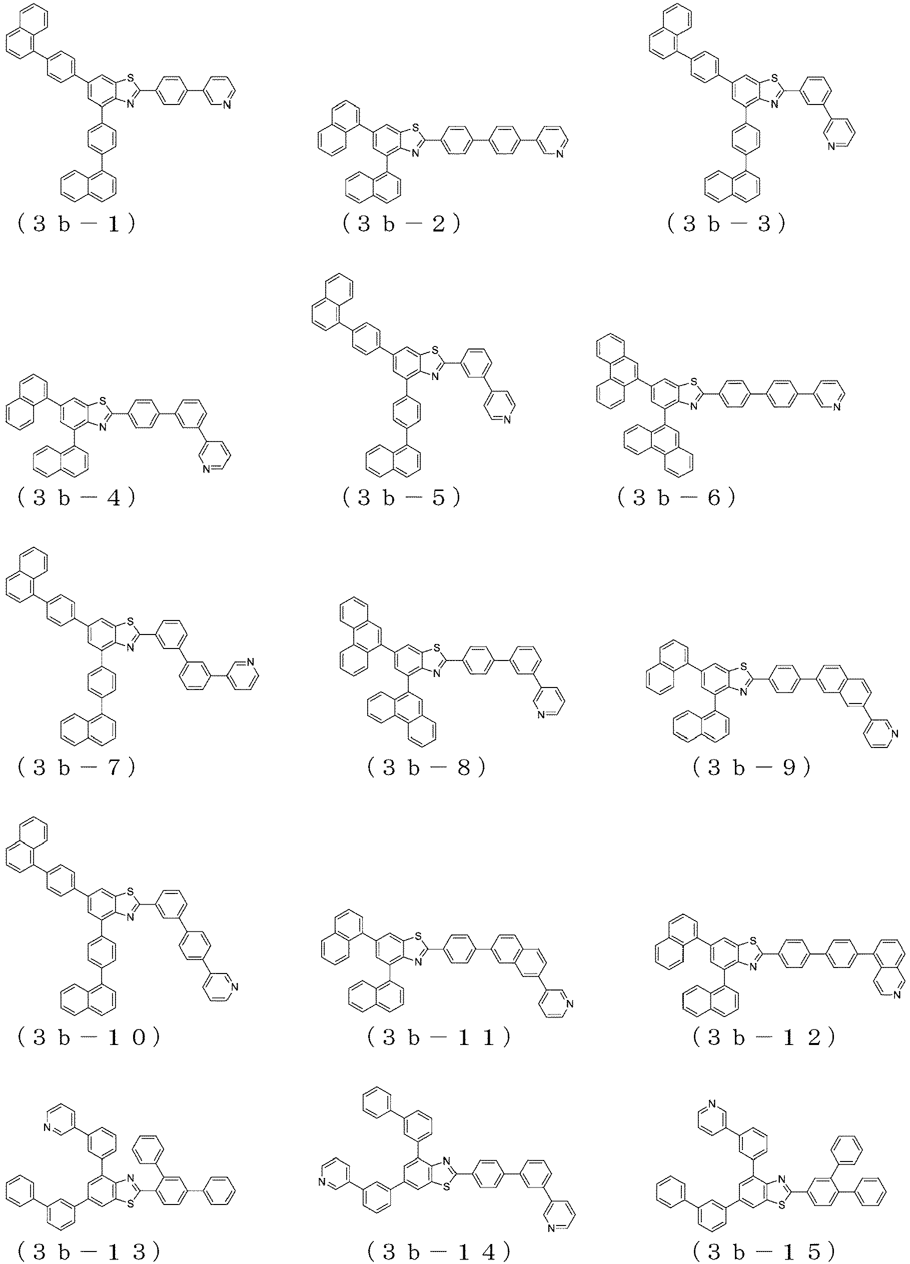

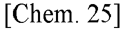

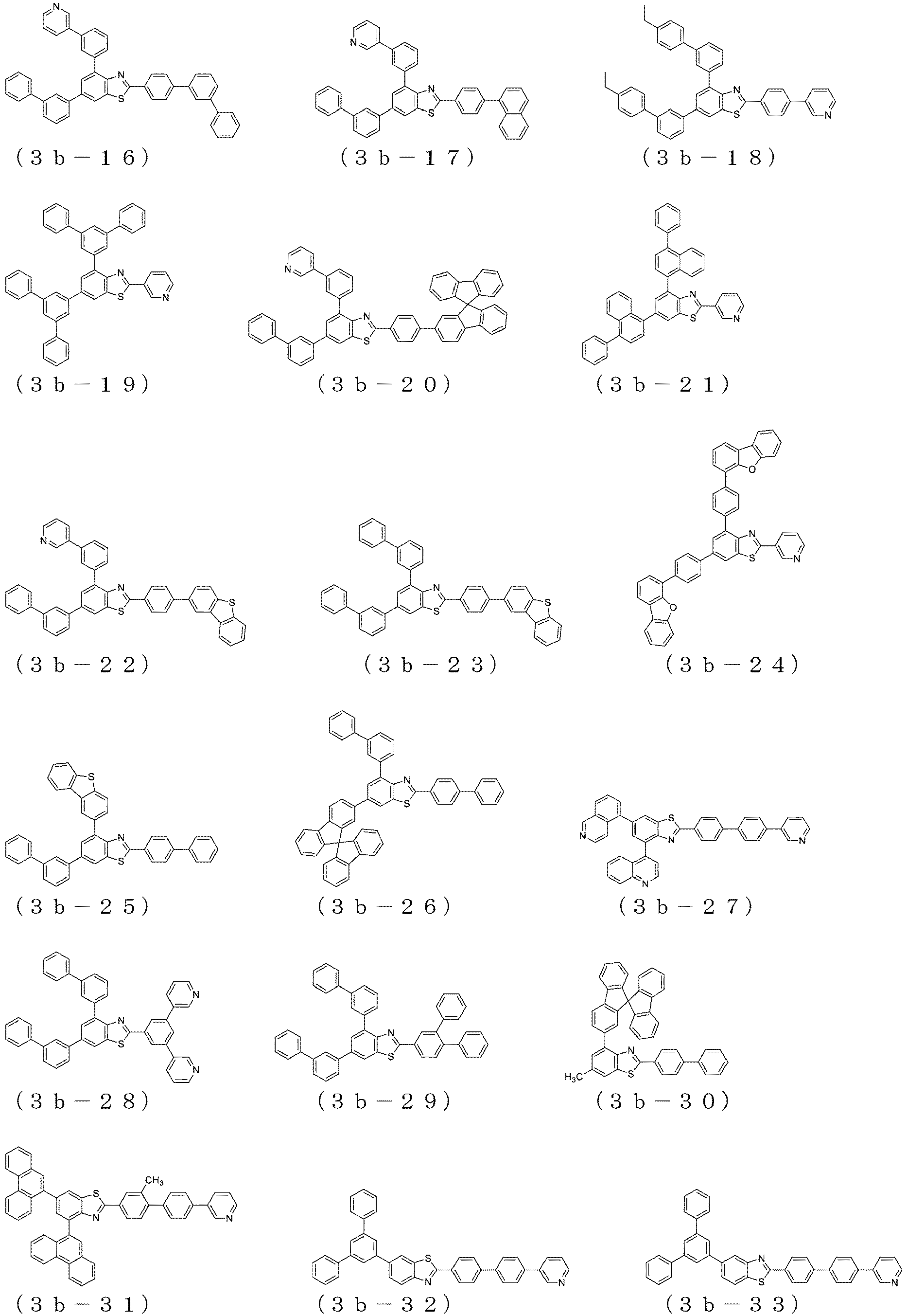

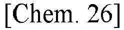

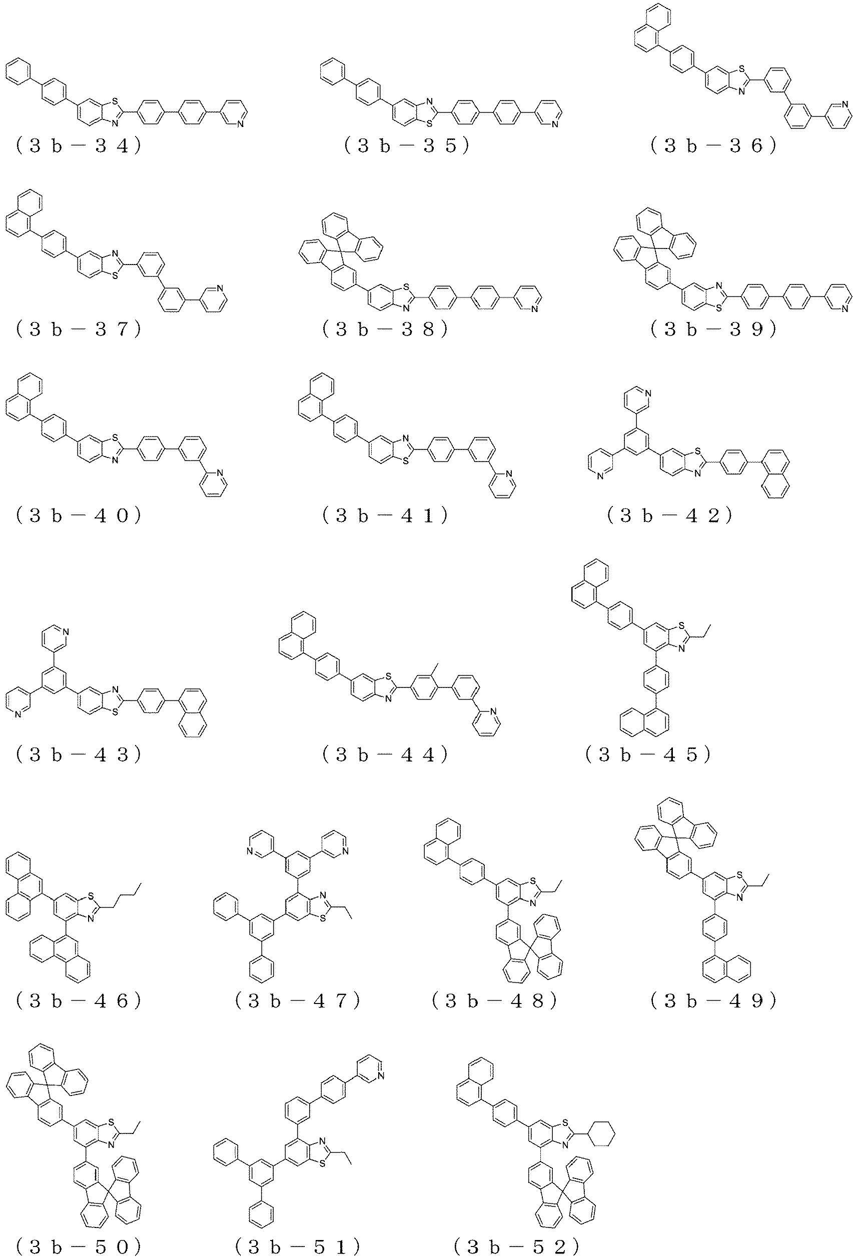

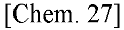

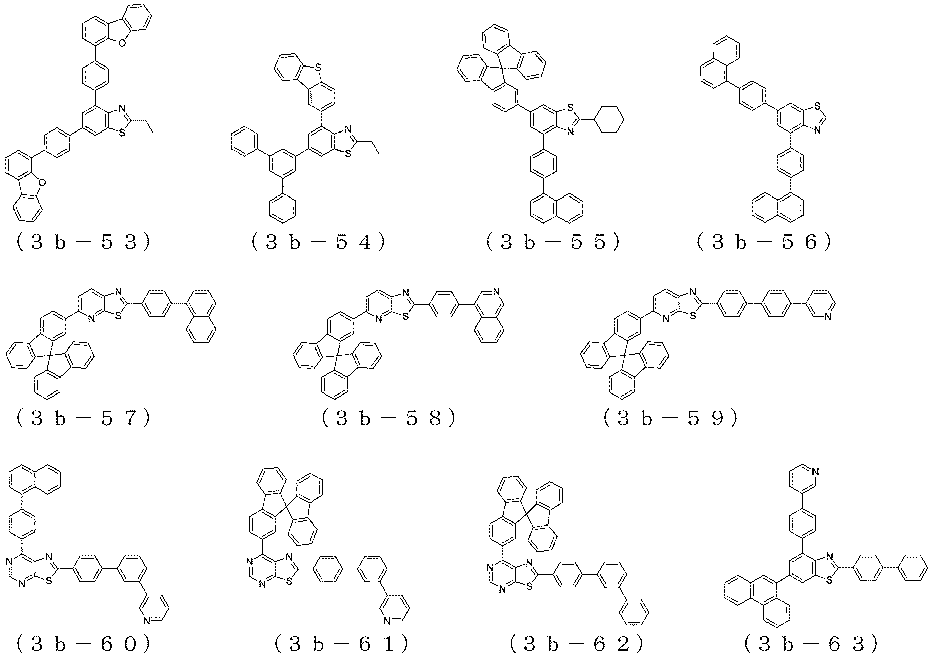

Specific examples of preferred compounds, among the arylamine compounds which are represented by the foregoing general formula (4) and are preferably used in the organic EL device of the present embodiment, are shown below. However, the present invention is not limited to these compounds.

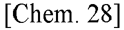

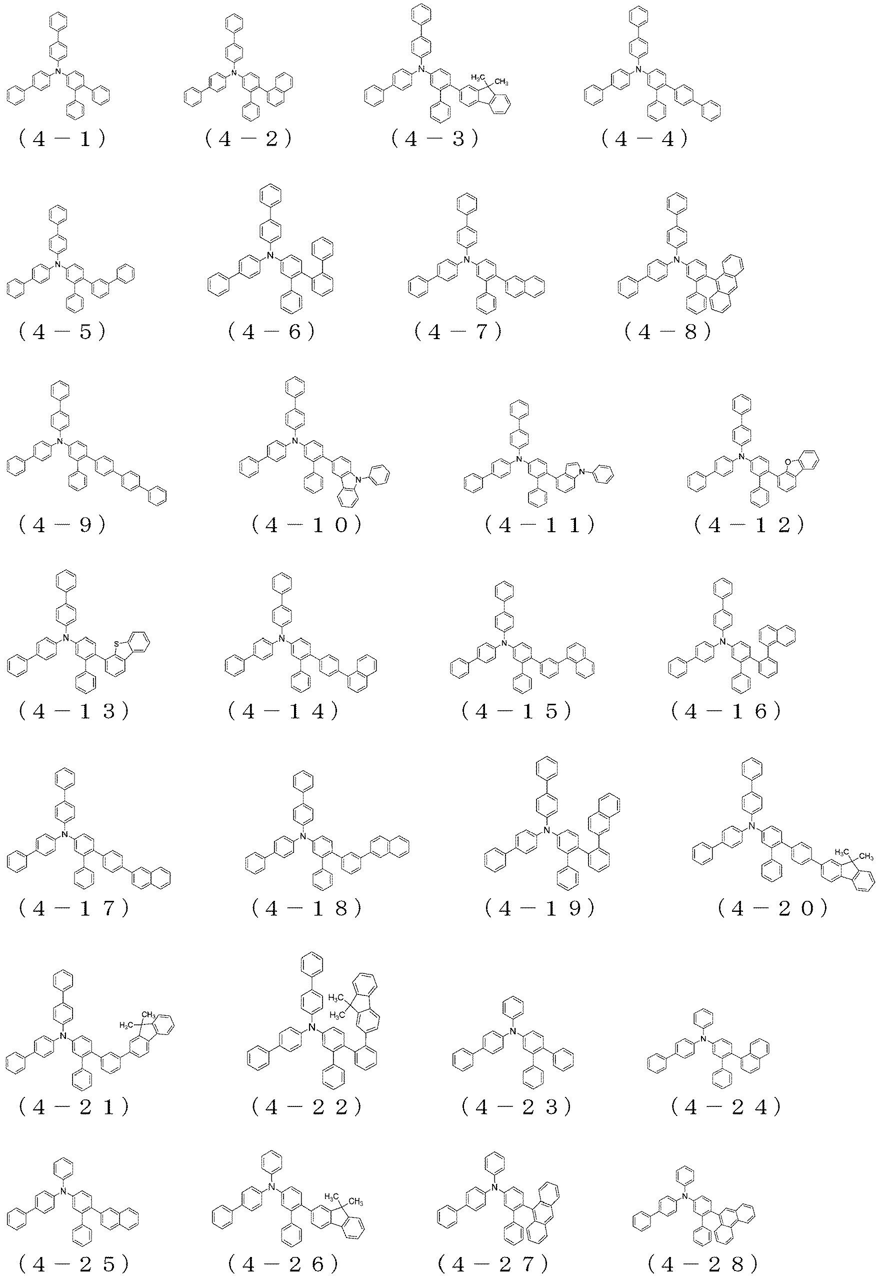

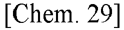

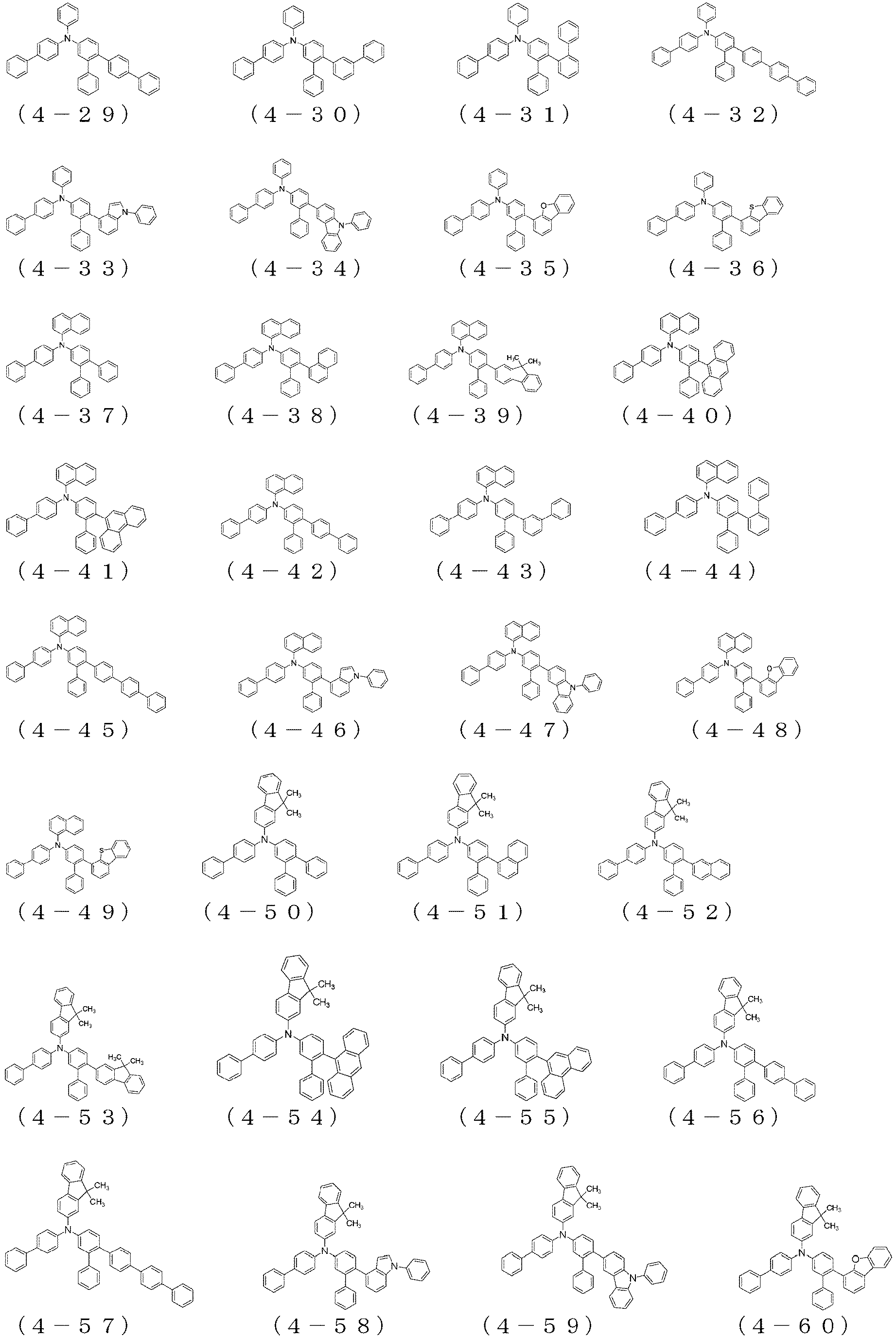

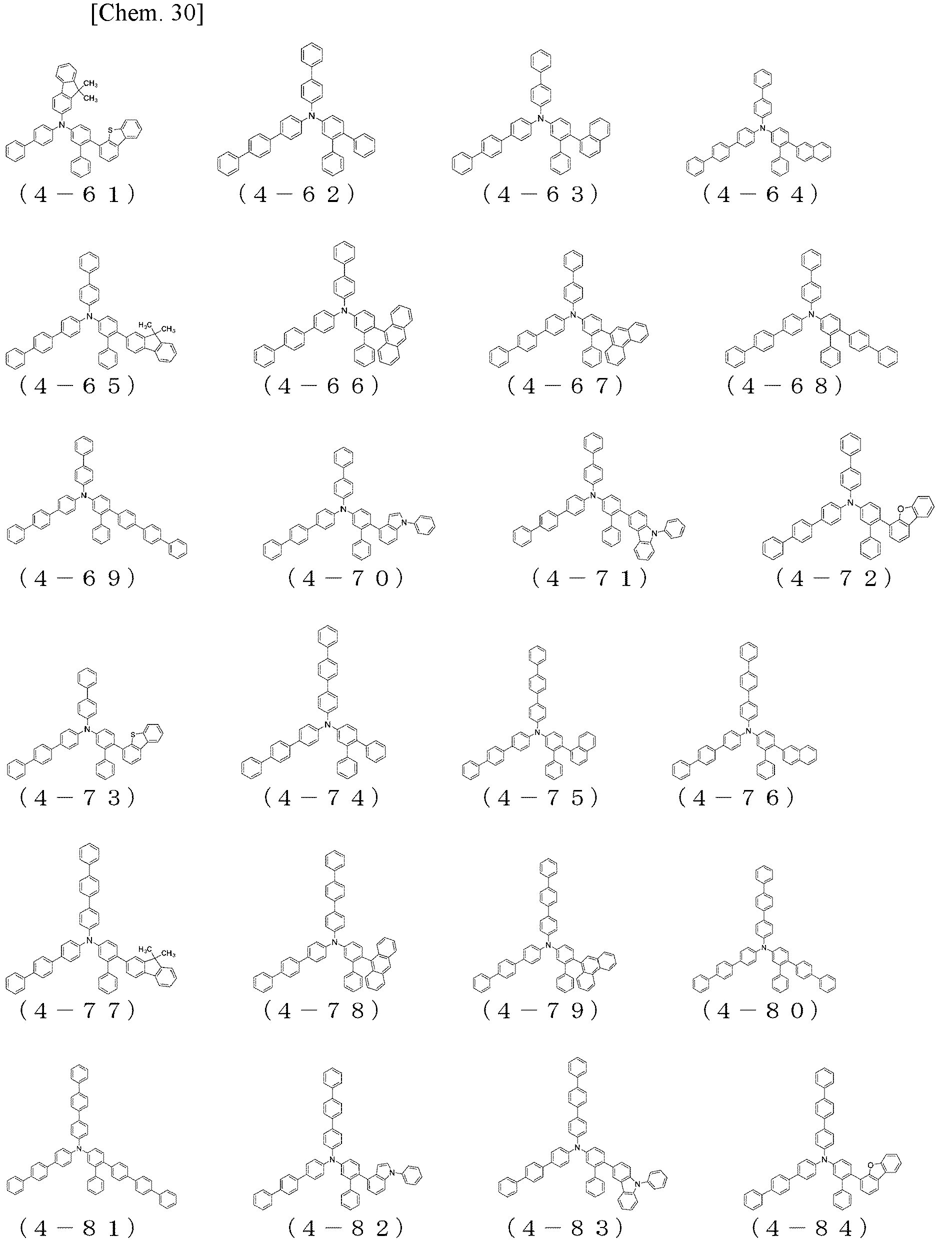

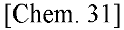

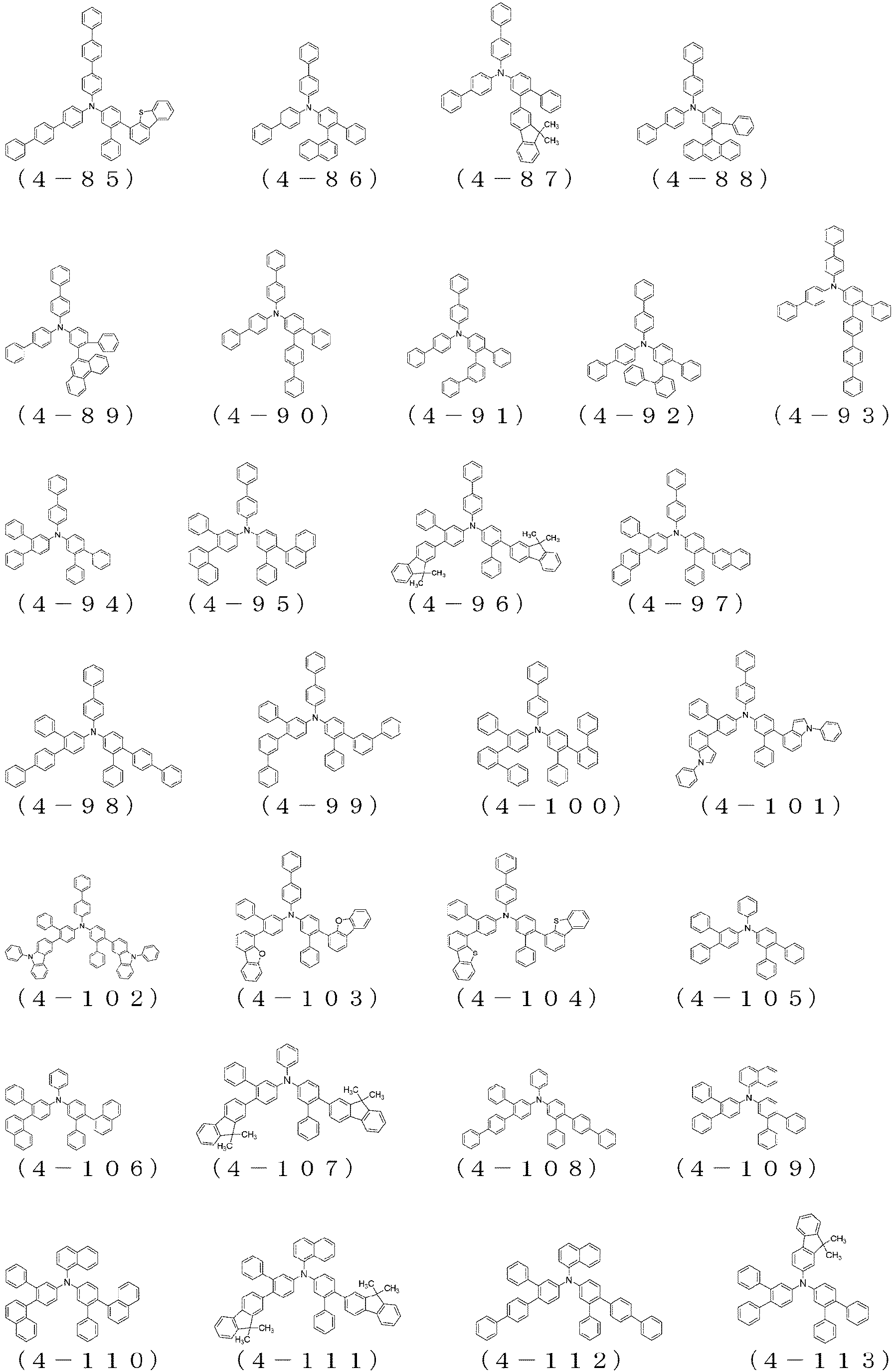

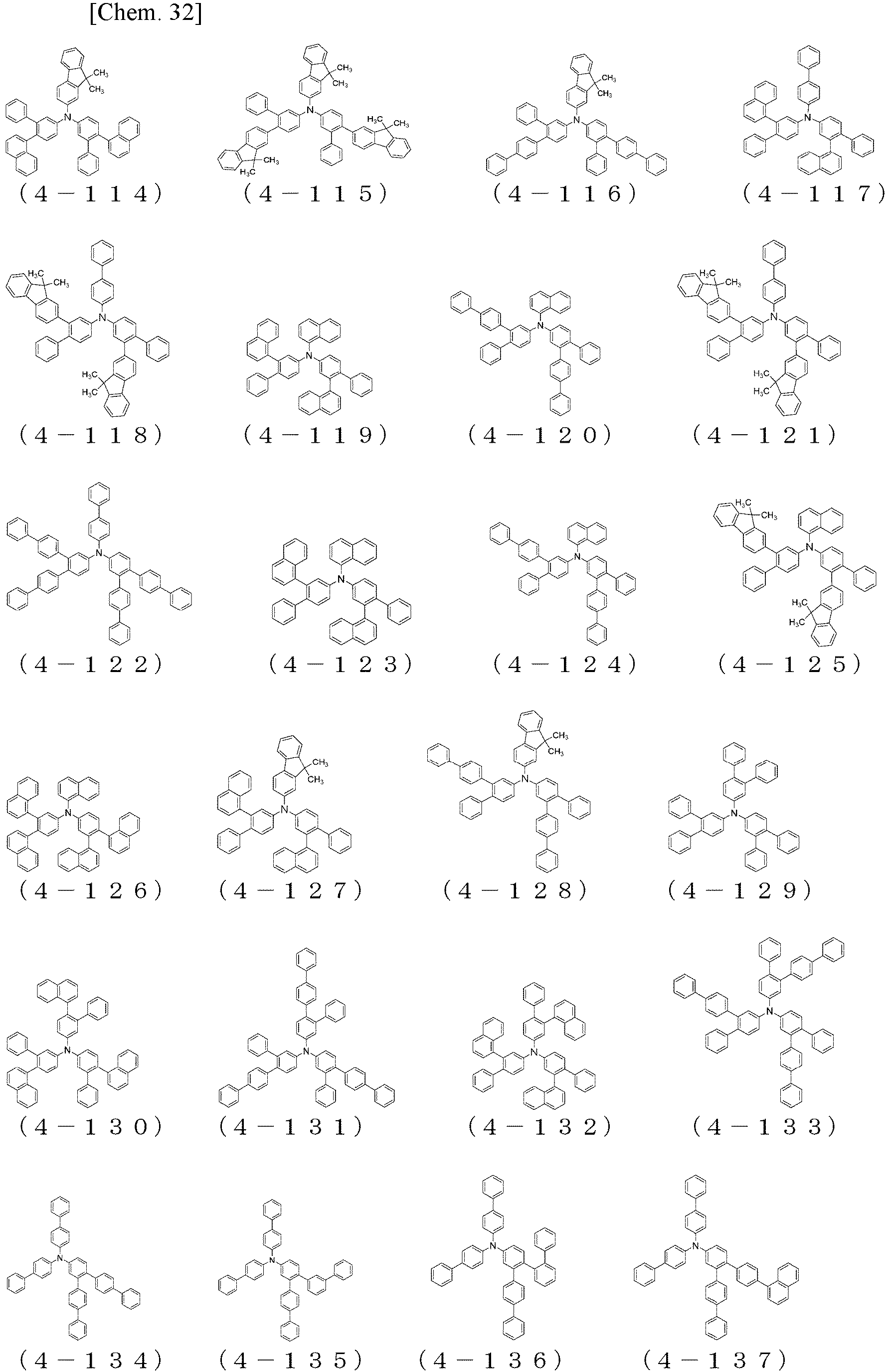

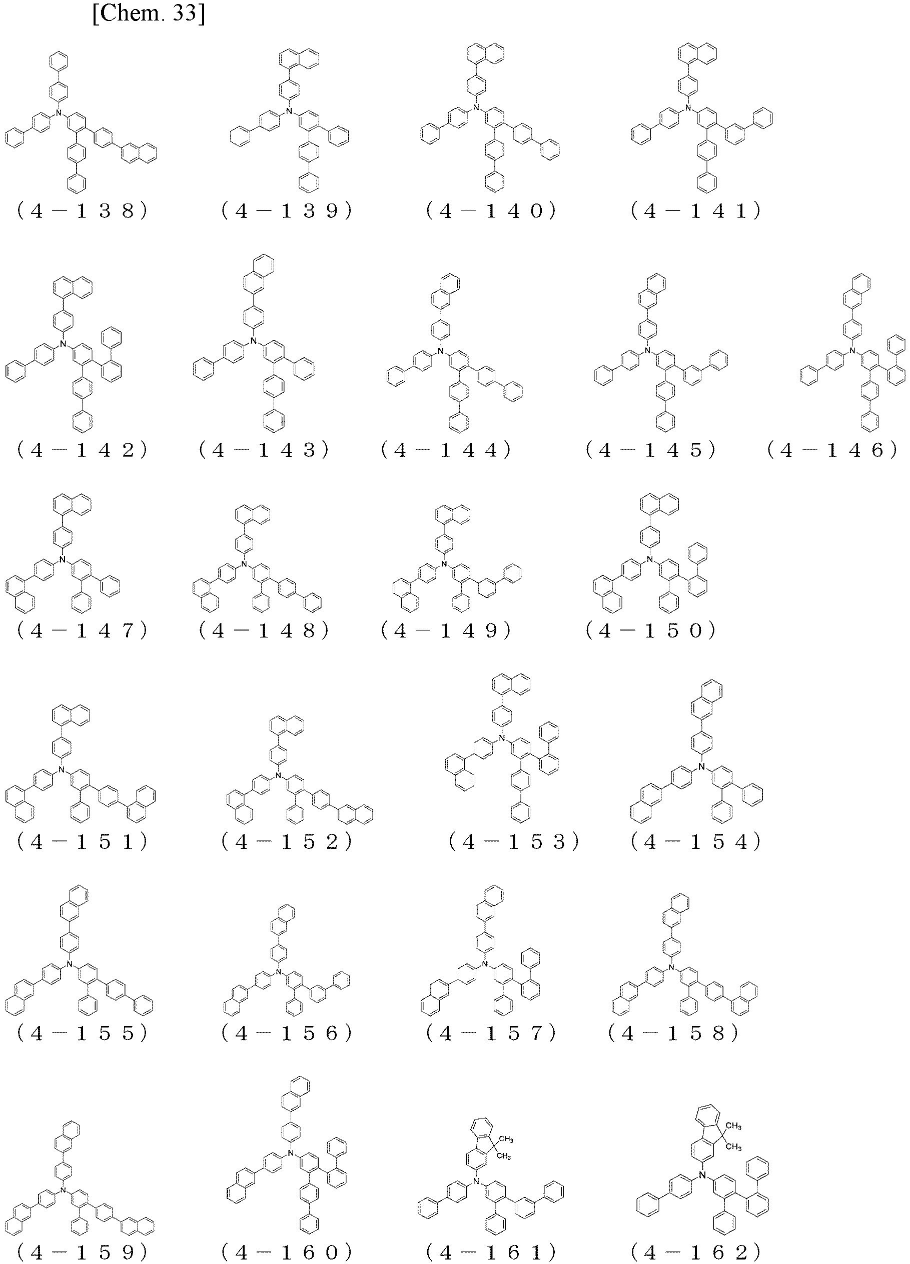

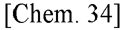

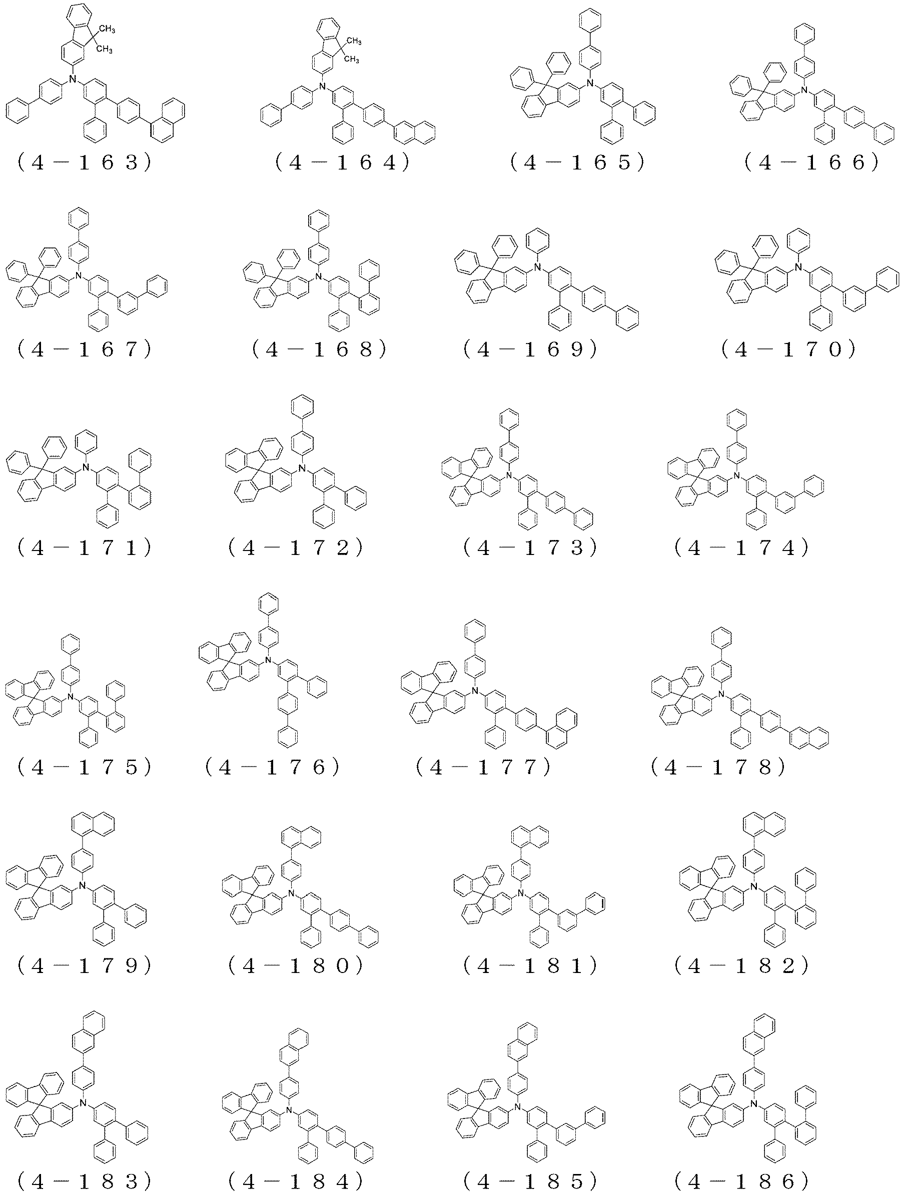

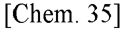

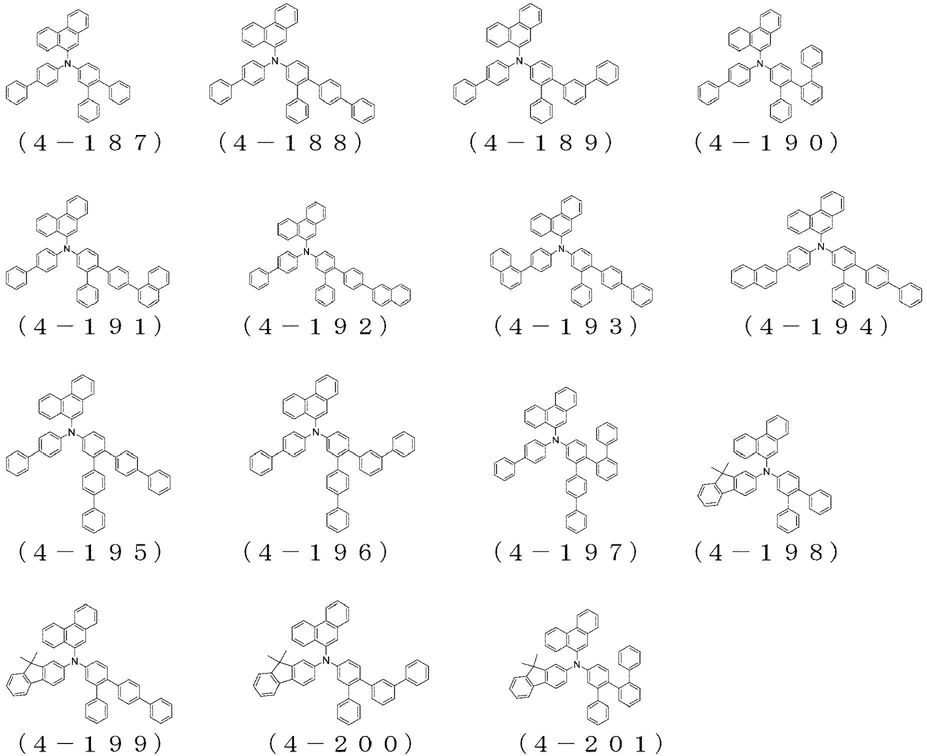

Purification of compounds represented by the general formulas (1a), (1b), and (2) to (4) is performed by purification using column chromatography, adsorption purification using silica gel, activated carbon, activated clay, and the like, recrystallization and crystallization using a solvent, and the like, and finally, purification using sublimation purification or the like is performed. The compounds are identified by NMR analysis. As physical property values, a glass transition point (Tg) and a work function are measured. The glass transition point (Tg) is an index of stability of a state of a thin film, and the work function is an index of a hole-transporting property.

The melting point and the glass transition point (Tg) are measured with a high sensitivity differential scanning calorimeter (DSC 3100 SA, manufactured by Bruker AXS GmbH) by using a powder of the compounds. The melting point of the compounds represented by the general formula (1a) or (1b), which are contained in the hole transport layer, is preferably 200°C or higher and more preferably 240°C or higher. The upper limit of the melting point is not particularly limited, and, for example, a compound having a melting point of 400°C or lower can be adopted. The glass transition point of the compounds represented by the general formula (1a) or (1b), which are contained in the hole transport layer, is preferably 100°C or higher and more preferably 130°C or higher from the viewpoint of the stability of the formed thin film. The upper limit of the glass transition point is not particularly limited, and, for example, a compound having a glass transition point of 250°C or lower can be adopted.

The work function is determined by producing a thin film of 100 nm on an ITO substrate and measuring with an ionization potential measuring device (PYS-202, manufactured by Sumitomo Heavy Industries, Ltd.). The work function of a vapor deposition film having a film thickness of 100 nm, which is prepared on an ITO substrate by using the compounds represented by the general formula (1a) or (1b), contained in the hole transport layer, is preferably larger than 5.4 eV and more preferably 5.5 eV or more from the viewpoint of the hole-transporting property. The upper limit of the work function of this vapor deposition film is not particularly limited, and, for example, a vapor deposition film having a work function of 6.0 eV or lower can be adopted.

Examples of the structure of the organic EL device of the present embodiment include a structure having an anode, a hole injection layer, a hole transport layer, a light emitting layer, an electron transport layer, an electron injection layer, and a cathode in this order on a substrate, a structure further including an electron blocking layer between the hole transport layer and the light emitting layer, and a structure further including a hole blocking layer between the light emitting layer and the electron transport layer. In these multilayer structures, it is possible to omit or combine several layers of the organic layers, and the structure can have, for example, a configuration in which a hole injection layer and a hole transport layer are combined, a configuration in which an electron injection layer and an electron transport layer are combined, or the like. The structure can have a configuration in which two or more organic layers having the same function are laminated, and the structure can have, for example, a configuration in which two hole transport layers are laminated, a configuration in which two light emitting layers are laminated, a configuration in which two electron transport layers are laminated, or the like.

As the anode of the organic EL device of the present embodiment, an electrode material having a large work function, such as ITO and gold, is used. As the hole injection layer of the organic EL device of the present embodiment, the indenophenanthrene compounds represented by the foregoing general formula (1a) or (1b) can be used. In addition, it is possible to use a material such as a starburst type triphenyl amine derivative and various triphenyl amine tetramers; a porphyrin compound represented by copper phthalocyanine; and a heterocyclic compound having acceptor properties, such as hexacyano azatriphenylene, and a coating type polymer material. As the electron acceptor, at least one electron acceptor selected from the group consisting of trisbromophenylamine hexachloroantimony, tetracyanoquinone dimethane (TCNQ), 2,3,5,6-tetrafluoro-tetracyano-1,4-benzoquinone dimethane (F4TCNQ), and radialene derivatives can be used. These materials may be used to form a film alone, may be used as a single layer formed by being mixed with another material, or may be used in a laminated structure of layers each formed by alone, layers each formed by being mixed with another material, or a layer formed by alone and a layer formed by being mixed. A layer, which is formed by mixing different compounds among the indenophenanthrene compounds represented by the general formula (1a) or (1b), may be used. For example, a compound represented by the general formula (1a) and a compound represented by the general formula (1b) may be mixed and used, or different compounds among the compounds represented by the general formula (1a) may be mixed and used. The different compounds among the indenophenanthrene compounds represented by the general formula (1a) or (1b) may be separately formed as single layers respectively by alone, and laminated. A layer, which is formed by mixing different compounds among the indenophenanthrene compounds represented by the general formula (1a) or (1b), may be laminated with a layer formed by one kind among the different compounds. In the case where the different compounds among the indenophenanthrene compounds represented by the general formula (1a) or (1b) are mixed, a mixing ratio of the different compounds can be set appropriately. In the case where the indenophenanthrene compounds represented by the general formula (1a) or (1b) are used in combination with other materials, a mixing ratio thereof may be indenophenanthrene compounds represented by the general formula (1a) or (1b) : other materials = 100 1 to 1 1, and preferably indenophenanthrene compounds : other materials = 100 1 to 4 1. These materials can form a thin film by a common method such as a spin coating method and an inkjet method in addition to a vapor deposition method.

As the hole transport layer of the organic EL device of the present embodiment, the indenophenanthrene compounds represented by the foregoing general formula (1a) or (1b) are used. These materials may be used to form a film alone, may be used as a single layer formed by being mixed with another material, or may be used in a laminated structure of layers each formed by alone, layers each formed by being mixed with another material, or a layer formed by alone and a layer formed by being mixed with another material. A layer, which is formed by mixing different compounds among the indenophenanthrene compounds represented by the general formula (1a) or (1b), may be used. For example, a compound represented by the general formula (1a) and a compound represented by the general formula (1b) may be mixed and used, or different compounds among the compounds represented by the general formula (1a) may be mixed and used. The different compounds among the indenophenanthrene compounds represented by the general formula (1a) or (1b) may be separately formed as single layers respectively alone, and laminated. A layer, which is formed by mixing different compounds among the indenophenanthrene compounds represented by the general formula (1a) or (1b), may be laminated with a layer formed by one kind among the different compounds. In the case where the different compounds among the indenophenanthrene compounds represented by the general formula (1a) or (1b) are mixed, a mixing ratio of the different compounds can be set appropriately. In the case where the indenophenanthrene compounds represented by the general formula (1a) or (1b) are used in combination with other materials, a mixing ratio thereof may be indenophenanthrene compounds represented by the general formula (1a) or (1b): other materials = 100 1 to 1 1, and preferably indenophenanthrene compounds : other materials = 100 : 1 to 4 : 1. These materials can form a thin film by a common method such as a spin coating method and an inkjet method in addition to a vapor deposition method.

Examples of materials having a hole-transporting property, which can be mixed or simultaneously used with the indenophenanthrene compounds represented by the foregoing general formula (1a) or (1b) as the hole transport layer of the organic EL device of the present embodiment, include: benzidine derivatives such as N,N'-diphenyl-N,N'-di(m-tolyl)benzidine (TPD), N,N'-diphenyl-N,N'-di(α-naphthyl)benzidine (NPD), and N,N,N',N'-tetrabiphenylylbenzidine; arylamine compounds having a structure, in which two triphenylamine structures are linked by a single bond or a divalent group containing no heteroatoms, in its molecule, such as 1,1-bis[4-(di-4-tolylamino)phenyl]cyclohexane (TAPC); arylamine compounds having a structure, in which four triphenylamine structures are linked by single bonds or divalent groups containing no heteroatoms, in its molecule; various triphenylamine trimers; and the like. As a hole injection and transport layer, a coating type polymer material such as poly(3,4-ethylene dioxythiophene) (PEDOT)/poly(styrene sulfonate) (PSS) can be used.

In the hole injection layer or the hole transport layer, a material obtained by further P-doping trisbromophenylamine hexachloroantimony or radialene derivatives (see, e.g., Patent Literature 6) with a material generally used for the layer, a polymer compound having a structure of a benzidine derivative such as TPD in its partial structure, and the like can be used.

As the electron blocking layer of the organic EL device of the present embodiment, arylamine compounds represented by the foregoing general formula (4) can be used. In addition, it is possible to use compounds having an electron blocking effect, such as arylamine compounds having a structure, in which four triphenylamine structures are linked by single bonds or divalent groups containing no heteroatoms, in its molecule, arylamine compounds having a structure, in which two triphenylamine structures are linked by a single bond or a divalent group containing no heteroatoms, in its molecule, carbazole derivatives such as 4,4',4"-tri(N-carbazolyl)triphenylamine (TCTA), 9,9-bis[4-(carbazol-9-yl)phenyl]fluorene, 1,3-bis(carbazol-9-yl)benzene (mCP), and 2,2-bis(4-carbazol-9-ylphenyl)adamantane (Ad-Cz), and compounds having a triphenylsilyl group and a triarylamine structure, which is represented by 9-[4-(carbazol-9-yl)phenyl]-9-[4-(triphenylsilyl)phenyl]-9H-fluorene. These materials may be used to form a film alone, may be used as a single layer formed by being mixed with another material, or may be used in a laminated structure of layers each formed by alone, layers each formed by being mixed with another material, or a layer formed by alone and a layer formed by being mixed with another material. In the case where the arylamine compounds represented by the general formula (4) are used in combination with other materials, a mixing ratio thereof may be arylamine compounds represented by the general formula (4) : other materials = 100 : 1 to 1 : 100, preferably arylamine compounds represented by the general formula (4) : other materials = 100 : 1 to 1 : 1, and more preferably arylamine compounds represented by the general formula (4): other materials = 100 : 1 to 4 : 1. These materials can form a thin film by a common method such as a spin coating method and an inkjet method in addition to a vapor deposition method.

As the light emitting layer of the organic EL device of the present embodiment, various metal complexes, anthracene derivatives, bis styryl benzene derivatives, pyrene derivatives, oxazole derivatives, polyparaphenylene vinylene derivatives, and the like can be used in addition to the metal complexes of the quinolinol derivatives, which includes Alq₃ typically. The light emitting layer may be constituted by a host material and a dopant material. As the host material, the anthracene derivatives are preferably used, and in addition to the foregoing light-emitting material, use can be made of heterocyclic compounds having an indole ring as a partial structure of a condensed ring, heterocyclic compounds having a carbazole ring as a partial structure of a condensed ring, carbazole derivatives, thiazole derivatives, benzimidazole derivatives, polydialkyl fluorene derivatives, and the like. As the dopant material, pyrene derivatives, and amine derivatives having a fluorene ring as a partial structure of a condensed ring are preferably used, and further, use can be made of quinacridone, coumarin, rubrene, perylene, and derivatives thereof, benzopyran derivatives, indenophenanthrene derivatives, rhodamine derivatives, aminostyryl derivatives, and the like. These materials may be used to form a film alone, may be used as a single layer formed by being mixed with another material, or may be used in a laminated structure of layers each formed by alone, layers each formed by being mixed with another material, or a layer formed by alone and a layer formed by being mixed with another material.

A phosphorescence emitter can also be used as the light-emitting material. As the phosphorescence emitter, a phosphorescence emitter of a metal complex of iridium, platinum, or the like can be used. Green phosphorescence emitters such as Ir(ppy)₃, blue phosphorescence emitters such as FIrpic and FIr₆, red phosphorescence emitters such as Btp₂Ir(acac), and the like can be used, and as the host material at this time, carbazole derivatives such as 4,4'-di(N-carbazolyl)biphenyl (CBP), TCTA, and mCP can be used as the host material having hole injection and transport properties. As the host material having an electron-transporting property, p-bis(triphenyl silyl)benzene (UGH2), 2,2',2"-(1,3,5-phenylene)-tris(1-phenyl-1H-benzimidazole) (TPBI), and the like can be used, and an organic EL device having high performance can be produced.

In order to avoid concentration quenching, a phosphorescent light-emitting material is preferably doped into the host material by co-deposition in a range of 1 to 30 weight percent(s) relative to the entire light emitting layer.

Materials that emit delayed fluorescence, such as PIC-TRZ, CC2TA, PXZ-TRZ, and CDCB derivatives such as 4CzIPN can also be used as the light-emitting material (See, e.g., Non-Patent Literature 3).

These materials can form a thin film by a common method such as a spin coating method and an inkjet method in addition to a vapor deposition method.

As the hole blocking layer of the organic EL device of the present embodiment, use can be made of compounds having a hole-blocking effect, such as phenanthroline derivatives such as bathocuproine (BCP), metal complexes of quinolinol derivatives such as aluminum (III) bis(2-methyl-8-quinolinate)-4-phenyl phenolate (BAlq), various rare earth complexes, triazole derivatives, triazine derivatives, and oxadiazole derivatives. These materials may also double as materials of the electron transport layer. These materials may be used to form a film alone, may be use as a single layer formed by being mixed with another material, or may be used in a laminated structure of layers each formed by alone, layers each formed by being mixed with another material, or a layer formed by alone and a layer formed by being mixed with another material. These materials can form a thin film by a common method such as a spin coating method and an inkjet method in addition to a vapor deposition method.

As the electron transport layer of the organic EL device of the present embodiment, use can be made of the compounds having a pyrimidine ring structure, which are represented by the foregoing general formula (2), the compounds having a benzazole ring structure, which are represented by the foregoing general formula (3), or both of them. In addition, it is possible to use metal complexes of quinolinol derivatives including Alq₃ and BAlq, various metal complexes, triazole derivatives, triazine derivatives, oxadiazole derivatives, pyridine derivatives, pyrimidine derivatives, benzimidazole derivatives, thiadiazole derivatives, anthracene derivatives, carbodiimide derivatives, quinoxaline derivatives, pyridoindole derivatives, phenanthroline derivatives, silole derivatives, and the like. These materials may be used to form a film alone, may be used as a single layer formed by being mixed with another material, or may be used in a laminated structure of layers each formed by alone, layers each formed by being mixed with another material, a layer formed by alone and a layer formed by being mixed with another material. In the case where the compounds having a pyrimidine ring structure represented by the general formula (2) are used in combination with other materials, a mixing ratio thereof may be compounds having a pyrimidine ring structure represented by the general formula (2) : other materials = 100 : 1 to 1 : 100, and preferably compounds having a pyrimidine ring structure represented by the general formula (2) : other materials = 4 : 1 to 1 : 4. In the case where the compounds having a benzazole ring structure represented by the general formula (3) are used in combination with other materials, a mixing ratio thereof may be compounds having a benzazole ring structure represented by the general formula (3): other materials = 100 : 1 to 1 : 100, and preferably compounds having a benzazole ring structure represented by the general formula (3) : other materials = 4 : 1 to 1 : 4. These materials can form a thin film by a common method such as a spin coating method and an inkjet method in addition to a vapor deposition method.

As the electron injection layer of the organic EL device of the present embodiment, use can be made of alkali metal salts such as lithium fluoride and cesium fluoride, alkaline earth metal salts such as magnesium fluoride, metal oxides such as aluminum oxide, metals such as ytterbium (Yb), samarium (Sm), calcium (Ca), strontium (Sr), and cesium (Cs) and the like, but this can be omitted in the preferred selection of the electron transport layer and the cathode.

As the cathode of the organic EL device of the present embodiment, an electrode material having a low work function such as aluminum, an alloy having a lower work function such as a magnesium silver alloy, a magnesium indium alloy, and an aluminum magnesium alloy, and the like can be used as an electrode material.

The embodiments of the present invention will be described more specifically by Examples below, but the present invention is not limited to the following Examples.

### [Example 1]

### <Synthesis of N,N-bis(biphenyl-4-yl)-13,13-dimethylindeno[1,2-l]phenanthrene-11-amine (Compound 1a-4)>

To a reaction vessel in which the atmosphere was replaced with nitrogen gas, 18.9 g of bisbiphenylamine, 20.0 g of 11-bromo-13,13-dimethylindeno[1,2-l]phenanthrene, 6.2 g of t-butoxy sodium, and 200 mL of toluene were added, and nitrogen gas was introduced thereto while irradiating the mixture with ultrasonic waves for 30 minutes. To the solution to which the nitrogen gas was introduced, 0.24 g of palladium acetate, 0.43 mL of a 50% (w/v) toluene solution of t-butyl phosphine were added, and the thus-obtained solution was heated and was stirred at 100°C for 4 hours. After the stirring, the reaction liquid was cooled and was subjected to liquid separation by adding water thereto, and then concentration was performed. Subsequently, recrystallization was performed with tetrahydrofuran and acetone, and the solid was collected by filtration to obtain 20.8 g (yield: 63%) of N,N-bis(biphenyl-4-yl)-13,13-dimethylindeno[1,2-l]phenanthrene-11-amine (Compound 1a-4) as a yellowish-white powder.

A structure of the obtained yellowish-white powder was identified with NMR.

Signals of the following 35 hydrogens were detected with ¹H-NMR (CDCl₃).
δ (ppm) = 8.87-8.92 (3H), 8.34-8.37 (2H), 7.26-7.79 (24H), 1.79 (6H).

### [Example 2]

### <Synthesis of N-(biphenyl-4-yl)-N-(9,9-dimethylfluoren-2-yl)-13,13-dimethylindeno[1,2-l]phenanthrene-11-amine (Compound 1a-7)>

To a reaction vessel in which the atmosphere was replaced with nitrogen gas, 5.0 g of N-(biphenyl-4-yl)-9,9-dimethylfluoren-2-amine, 5.9 g of 11-bromo-13,13-dimethylindeno[1,2-l]phenanthrene, 1.6 g of t-butoxy sodium, and 50 mL of toluene were added, and nitrogen gas was introduced thereto while irradiating the mixture with ultrasonic waves for 30 minutes. To the solution to which the nitrogen gas was introduced, 0.1 g of palladium acetate, 0.2 mL of a 50% (w/v) toluene solution of t-butyl phosphine were added, and the thus-obtained solution was heated and was stirred at 100°C for 3 hours. After the stirring, the reaction liquid was cooled and was subjected to a heat filtration at 80°C by using Celite, and the filtrate was concentrated. Subsequently, the resultant was purified with column chromatography to obtain 4.8 g (yield: 53%) of N-(biphenyl-4-yl)-N-(9,9-dimethylfluoren-2-yl)-13,13-dimethylindeno[1,2-l]phenanthrene-11-amine (Compound 1a-7) as a yellowish-white powder.

A structure of the obtained yellowish-white powder was identified with NMR.

Signals of the following 39 hydrogens were detected with ¹H-NMR (CDCl₃).
δ (ppm) = 8.87-8.92 (3H), 8.34-8.37 (2H), 7.26-7.79 (22H), 1.78 (6H), 1.50 (6H).

### [Example 3]

### <Synthesis of N-(biphenyl-4-yl)-N-{4-(naphthalen-2-yl)phenyl}-13,13-dimethylindeno[1,2-l]phenanthrene-11-amine (Compound 1a-10)>

To a reaction vessel in which the atmosphere was replaced with nitrogen gas, 5.4 g of N-(2-naphthylphenyl)biphenylamine, 6.0 g of 11-bromo-13,13-dimethylindeno[1,2-l]phenanthrene, 1.7 g of t-butoxy sodium, and 54 mL of toluene were added, and nitrogen gas was introduced thereto while irradiating the mixture with ultrasonic waves for 30 minutes. To the solution to which the nitrogen gas was introduced, 0.1 g of palladium acetate, 0.2 mL of a 50% (w/v) toluene solution of t-butyl phosphine were added, and the thus-obtained solution was heated and was stirred at 100°C for 3 hours. After the stirring, the reaction liquid was cooled and was subjected to the heat filtration at 80°C by using Celite, and the filtrate was concentrated. Subsequently, the resultant was purified with column chromatography to obtain 5.8 g (yield: 60%) of N-(biphenyl-4-yl)-N-{4-(naphthalen-2-yl)phenyl}-13,13-dimethylindeno[1,2-l]phenanthrene-11-amine (Compound 1a-10) as a yellowish-white powder.

A structure of the obtained yellowish-white powder was identified with NMR.

Signals of the following 37 hydrogens were detected with ¹H-NMR (CDCl₃).
δ (ppm) = 8.87-8.93 (3H), 8.34-8.39 (2H), 7.94 (1H), 7.28-7.84 (25H), 1.81 (6H).

### [Example 4]

### <Synthesis of N,N-bis(biphenyl-4-yl)-13,13-diphenylindeno[1,2-l]phenanthrene-11-amine (Compound 1a-14)>

To a reaction vessel in which the atmosphere was replaced with nitrogen gas, 5.7 g of bisbiphenylamine, 8.0 g of 11-bromo-13,13-diphenylindeno[1,2-l]phenanthrene, 1.9 g of t-butoxy sodium, and 80 mL of toluene were added, and nitrogen gas was introduced thereto while irradiating the mixture with ultrasonic waves for 30 minutes. To the solution to which the nitrogen gas was introduced, 0.1 g of palladium acetate, 0.13 mL of a 50% (w/v) toluene solution of t-butyl phosphine were added, and the thus-obtained solution was heated and was stirred at 100°C for 5 hours. After the stirring, the reaction liquid was cooled and was extracted with toluene after adding water thereto, and an organic layer was concentrated. Subsequently, recrystallization was performed with toluene and acetone to obtain 7.5 g (yield: 63%) of N,N-bis(biphenyl-4-yl)-13,13-diphenylindeno[1,2-l]phenanthrene-11-amine (Compound 1a-14) as a yellowish-white powder.

A structure of the obtained yellowish-white powder was identified with NMR.

Signals of the following 39 hydrogens were detected with ¹H-NMR (CDCl₃).
δ (ppm) = 8.99-9.00 (1H), 8.90-8.97 (1H), 8.76-8.79 (1H), 8.34-8.37 (1H), 7.78-7.85 (3H), 7.18-7.66 (32H).

### [Example 5]

### <Synthesis of N-(biphenyl-4-yl)-N-(9,9-dimethylfluoren-2-yl)-13,13-diphenylindeno[1,2-l]phenanthrene-11-amine (Compound 1a-17)>

To a reaction vessel in which the atmosphere was replaced with nitrogen gas, 6.4 g of N-(biphenyl-4-yl)-9,9-dimethylfluoren-2-amine, 8.0 g of 11-bromo-13,13-diphenylindeno[1,2-l]phenanthrene, 1.9 g of t-butoxy sodium, and 80 mL of toluene were added, and nitrogen gas was introduced thereto while irradiating the mixture with ultrasonic waves for 30 minutes. To the solution to which the nitrogen gas was introduced, 0.1 g of palladium acetate, 0.13 mL of a 50% (w/v) toluene solution of t-butyl phosphine were added, and the thus-obtained solution was heated and was stirred at 100°C for 6 hours. After the stirring, the reaction liquid was cooled and was extracted with toluene after adding water thereto, and an organic layer was concentrated. Subsequently, recrystallization was performed with toluene and acetone to obtain 9.8 g (yield: 78%) of N-(biphenyl-4-yl)-N-(9,9-dimethylfluoren-2-yl)-13,13-diphenylindeno[1,2-l]phenanthrene (Compound 1a-17) as a yellowish-white powder.

A structure of the obtained yellowish-white powder was identified with NMR.

Signals of the following 43 hydrogens were detected with ¹H-NMR (CDCl₃).
δ (ppm) = 8.99-9.03 (1H), 8.92-8.97 (1H), 8.76-8.79 (1H), 8.34-8.37 (1H), 7.16-7.82 (33H), 1.40 (6H).

### [Example 6]

### <Synthesis of N-(biphenyl-4-yl)-N-{4-(naphthalen-2-yl)phenyl}-13,13-diphenylindeno[1,2-l]phenanthrene-11-amine (Compound 1a-20)>

To a reaction vessel in which the atmosphere was replaced with nitrogen gas, 6.6 g of N-(2-naphthylphenyl)biphenylamine, 8.0 g of 11-bromo-13,13-diphenylindeno[1,2-l]phenanthrene, 1.9 g of t-butoxy sodium, and 80 mL of toluene were added, and nitrogen gas was introduced thereto while irradiating the mixture with ultrasonic waves for 30 minutes. To the solution to which the nitrogen gas was introduced, 0.1 g of palladium acetate, 0.19 mL of a 50% (w/v) toluene solution of t-butyl phosphine were added, and the thus-obtained solution was heated and was stirred at 100°C for 7 hours. After the stirring, the reaction liquid was cooled and was extracted with toluene after adding water thereto, and an organic layer was concentrated. Subsequently, recrystallization was performed with toluene and acetone to obtain 8.6 g (yield: 68%) of N-(biphenyl-4-yl)-N-{4-(naphthalen-2-yl)phenyl}-13,13-diphenylindeno[1,2-l]phenanthrene-11-amine (Compound 1a-20) as a yellowish-white powder.

A structure of the obtained yellowish-white powder was identified with NMR.

Signals of the following 41 hydrogens were detected with ¹H-NMR (CDCl₃).
δ (ppm) = 8.99-9.03 (1H), 8.89-8.95 (1H), 8.76-8.79 (1H), 8.35-8.38 (1H), 8.09 (1H), 7.20-7.98 (36H).

### [Example 7]

### <Synthesis of N,N-bis(biphenyl-4-yl)-{2-(13,1-yl)phenyl}amine (Compound 1a-23)>

To a reaction vessel in which the atmosphere was replaced with nitrogen gas, 5.2 g of bis(biphenyl-4-yl)[2-(4,4,5,5-tetramethyl-[1,3,2]dioxaborolan-2-yl)phenyl]amine, 4.0 g of 11-bromo-13,13-dimethylindeno[1,2-l]phenanthrene, 35 mL of toluene, 20 mL of ethanol, and a solution obtained by dissolving 2.2 g of potassium carbonate in 15 mL of water were added, and nitrogen gas was introduced thereto while irradiating the mixture with ultrasonic waves for 30 minutes. To the solution to which the nitrogen gas was introduced, 0.3 g of tetrakis(triphenylphosphine)palladium was added, and the thus-obtained solution was heated and was stirred at 75°C for 12 hours. After the stirring, the reaction liquid was cooled, followed by adding 100 mL of methanol thereto at the room temperature, and the precipitated solid was collected by filtration. The obtained solid was purified with column chromatography to obtain 2.7 g (yield: 37%) of N,N-bis(biphenyl-4-yl)-{2-(13,13-dimethylindeno[1,2-l]phenanthren-11-yl)phenyl}amine (Compound 1a-23) as a white powder.

A structure of the obtained white powder was identified with NMR.

Signals of the following 39 hydrogens were detected with ¹H-NMR (CDCl₃).
δ (ppm) = 8.85-8.93 (3H), 8.26-8.35 (2H), 7.68-7.77 (4H), 6.98-7.56 (24H), 1.64 (6H).

### [Example 8]

### <Synthesis of N,N-bis(biphenyl-4-yl)-13,13-dimethylindeno[1,2-l]phenanthrene-3-amine (Compound 1b-4)>

To a reaction vessel in which the atmosphere was replaced with nitrogen gas, 30.0 g of 9-phenanthreneboronic acid, 34.9 g of methyl 2-bromobenzoate, 240 mL of toluene, 120 mL of ethanol, and a solution obtained by dissolving 28.0 g of potassium carbonate in 95 mL of water were added, and nitrogen gas was introduced thereto while irradiating the mixture with ultrasonic waves for 30 minutes. To the solution to which the nitrogen gas was introduced, 3.1 g of tetrakis(triphenylphosphine)palladium was added, and the thus-obtained solution was heated and was stirred at 72°C for 6 hours. After the stirring, the reaction liquid was separated, the thus-obtained organic layer was washed sequentially with water and saturated saline and then the organic layer was dried with anhydrous magnesium sulfate. The drying agent was removed by filtration, and the filtrate was concentrated. The residue was purified by column chromatography to obtain 35.4 g (yield: 81.2%) of methyl 2-(9-phenanthrenyl)benzoate as a yellowish-white powder.

To a reaction vessel, 35.0 g of methyl 2-(9-phenanthrenyl)benzoate, 280 mL of ethanol, and 5.4 g of sodium hydroxide were added, and the mixture was heated and was stirred at 70°C for 5 hours. After the stirring, the reaction liquid was cooled, followed by adding 2M hydrochloric acid to neutralize the reaction liquid, and the reaction liquid was stirred at the room temperature for 1 hour. The precipitated solid was collected by filtration and washed sequentially with water and methanol to obtain 27.4 g (yield: 94.5%) of 2-(9-phenanthrenyl)benzoic acid as a yellow powder.

To a reaction vessel, 32.0 g of 2-(9-phenanthrenyl)benzoic acid and 260 mL of methanesulfonic acid were added, and the mixture was heated and was stirred at 50°C for 3 days. After the stirring, the reaction liquid was cooled and was slowly added to ice water, and the precipitated solid was collected by filtration. To the obtained solid, 640 mL of chlorobenzene was added, followed by heating the mixture and removing water from the mixture, and then silica gel was added and stirring was performed for 1 hour. The silica gel was removed by heat filtration at 80°C, and the filtrate was concentrated. The residue was purified by recrystallization with chlorobenzene and acetone to obtain 27.3 g (yield: 90.7%) of indolo[1,2-l]phenanthrene-13-one as an orange powder.

To a reaction vessel in which the atmosphere was replaced with nitrogen gas, 27.0 g of indolo[1,2-l]phenanthrene-13-one and 216 mL of dichloromethane were added, and the mixture was cooled with an ice bath. A solution obtained by mixing 18.5 g of bromine with 54 mL of dichloromethane was added thereto dropwise over 30 minutes, and the thus-obtained solution was stirred at room temperature for 1 day. After the stirring, an aqueous sodium thiosulfate solution was added thereto, and stirring was performed for 1 hour. The precipitated solid was collected by filtration and was purified by recrystallization with chlorobenzene and acetone, to obtain 33.6 g (yield: 100%) of 3-bromoindolo[1,2-l]phenanthrene-13-one as a yellow powder.

To a reaction vessel, 240 mL of acetic acid, 19.6 g of iodine, and 83.0 g of hypophosphorous acid were added, and the mixture was heated to 80°C. A solution obtained by dissolving 33.6 g of 3-bromoindolo[1,2-l]phenanthrene-13-one to 35 mL of acetic acid was added dropwise to the mixture, and stirring was performed at 100°C for 1 day. After the stirring, the thus-obtained solution was cooled to the room temperature, followed by adding 200 mL of water thereto, and the precipitated solid was collected by filtration. The solid was washed sequentially with water and methanol to obtain 30.5 g (yield: 94.4%) of 3-bromoindolo[1,2-l]phenanthrene as a yellow powder.

To a reaction vessel in which the atmosphere was replaced with nitrogen gas, 30.0 g of 3-bromoindolo[1,2-l]phenanthrene and 300 mL of tetrahydrofuran were added, and the mixture was cooled with an ice bath. To the mixture, 34.1 g of potassium t-butoxide was added slowly, followed by increasing the temperature to the room temperature, and stirring was performed for 2 hours. After the stirring, the thus-obtained mixture was cooled with ice bath again, and 49.3 g of iodomethane was slowly added thereto dropwise. The temperature was raised to room temperature, and stirring was performed for one night. After the stirring, the reaction liquid was separated, the thus-obtained organic layer was washed sequentially with water and saturated saline and then, the organic layer was dried with anhydrous magnesium sulfate. The drying agent was removed by filtration, and the filtrate was concentrated. The residue was purified with column chromatography to obtain 22.1 g (yield: 68.1%) of 3-bromo-13,13-dimethylindolo[1,2-l]phenanthrene as a yellowish-white powder.

To a reaction vessel in which the atmosphere was replaced with nitrogen gas, 4.3 g of bisbiphenylamine, 5.5 g of 3-bromo-13,13-dimethylindeno[1,2-l]phenanthrene, 1.5 g of t-butoxy sodium, and 43 mL of toluene were added, and nitrogen gas was introduced thereto while irradiating the mixture with ultrasonic waves for 30 minutes. To the solution to which the nitrogen gas was introduced, 0.06 g of palladium acetate, 0.20 mL of a 50% (w/v) toluene solution of t-butyl phosphine were added, and the thus-obtained solution was heated and was stirred at 100°C for 3 hours. After the stirring, the reaction liquid was cooled to 80°C, followed by adding 8.2 g of silica gel and 50 mL of toluene, and a solid was removed by heat filtration. The filtrate was concentrated and the residue was purified by recrystallization with toluene and acetone, to obtain 4.5 g (yield: 55%) of N,N-bis(biphenyl-4-yl)-13,13-dimethylindeno[1,2-l]phenanthrene-3-amine (Compound 1b-4) as a yellowish-white powder.

A structure of the obtained yellowish-white powder was identified with NMR.

Signals of the following 35 hydrogens were detected with ¹H-NMR (CDCl₃).
δ (ppm) = 8.96-8.98 (1H), 8.66 (1H), 8.55-8.58 (1H), 8.46-8.49 (1H), 8.30-8.33 (1H), 7.36-7.76 (24H), 1.84 (6H).

### [Example 9]

### <Synthesis of N-(biphenyl-4-yl)-N-{4-(naphthalen-2-yl)phenyl}-13,13-dimethylindeno[1,2-l]phenanthrene-3-amine (Compound 1b-10)>

To a reaction vessel in which the atmosphere was replaced with nitrogen gas, 5.0 g of N-(2-naphthylphenyl)biphenylamine, 5.5 g of 3-bromo-13,13-dimethylindeno[1,2-l]phenanthrene, 1.5 g of t-butoxy sodium, and 50 mL of toluene were added, and nitrogen gas was introduced thereto while irradiating the mixture with ultrasonic waves for 30 minutes. To the solution to which the nitrogen gas was introduced, 0.06 g of palladium acetate, 0.2 mL of a 50% (w/v) toluene solution of t-butyl phosphine were added, and the thus-obtained solution was heated and was stirred at 100°C for 3 hours. After the stirring, the reaction liquid was cooled and was subjected to the heat filtration at 80°C by using Celite, and the filtrate was concentrated. The residue was purified by recrystallization with toluene and acetone to obtain 5.6 g (yield: 63%) of N-(biphenyl-4-yl)-N-{4-(naphthalen-2-yl)phenyl}-13,13-dimethylindeno[1,2-l]phenanthrene-3-amine (Compound 1b-10) as a yellowish-white powder.

A structure of the obtained yellowish-white powder was identified with NMR.

Signals of the following 37 hydrogens were detected with ¹H-NMR (CDCl₃).
δ (ppm) = 8.99-9.02 (1H), 8.71(1H), 8.59-8.61 (1H), 8.49-8.52 (1H), 8.33-8.36 (1H), 8.13 (1H), 7.39-7.98 (25H), 1.86 (6H).

### [Example 10]

A melting point and a glass transition point of the indenophenanthrene compounds represented by the general formula (1a) or (1b) were determined with a high sensitivity differential scanning calorimeter (DSC 3100 S manufactured by Bruker AXS GmbH).

| | Melting point | Glass transition point |
|---|---|---|
| Compound of Example 1 | not observed | 130°C |
| Compound of Example 2 | not observed | 148°C |
| Compound of Example 3 | not observed | 137°C |
| Compound of Example 4 | 281°C | 153°C |
| Compound of Example 5 | 290°C | 163°C |
| Compound of Example 6 | not observed | 157°C |
| Compound of Example 7 | 305°C | 136°C |
| Compound of Example 8 | 245°C | 139°C |
| Compound of Example 9 | not observed | 142°C |

The indenophenanthrene compounds represented by the general formula (1a) or (1b) have a glass transition point of 100°C or higher. This indicates that the state of the thin film is stable.

### [Example 11]

The indenophenanthrene compounds represented by the general formula (1a) or (1b) were used to prepare a vapor deposition film having a film thickness of 100 nm on an ITO substrate, and a work function of the film was measured by an ionization potential measuring device (PYS-202, manufactured by Sumitomo Heavy Industries, Ltd.).

| | Work function |
|---|---|
| Compound of Example 1 | 5.58 eV |
| Compound of Example 2 | 5.53 eV |
| Compound of Example 3 | 5.57 eV |
| Compound of Example 4 | 5.58 eV |
| Compound of Example 5 | 5.54 eV |
| Compound of Example 6 | 5.59 eV |
| Compound of Example 7 | 5.69 eV |
| Compound of Example 8 | 5.61 eV |
| Compound of Example 9 | 5.60 eV |

It can be found that the indenophenanthrene compounds represented by the general formula (1a) or (1b) exhibit a suitable energy level as compared with a work function of 5.4 eV of the general hole-transporting material such as NPD and TPD, and that they have good hole-transporting ability.

### [Example 12]

As illustrated in FIG. 1, an organic EL device of this Example was prepared by depositing a hole injection layer 3, a hole transport layer 4, an electron blocking layer 5, a light emitting layer 6, an electron transport layer 7, an electron injection layer 8, and a cathode (aluminum electrode) 9 in this order on a glass substrate 1 on which an ITO electrode had been formed as a transparent anode 2 in advance.

Specifically, the organic EL device was prepared by the following procedure. The glass substrate 1 on which ITO having a film thickness of 50 nm had been formed was ultrasonically washed in isopropyl alcohol for 20 minutes, and then was dried for 10 minutes on a hot plate heated at 200°C. Thereafter, after performing a UV ozone treatment for 15 minutes, the glass substrate with ITO was mounted in a vacuum deposition machine, followed by evacuating to 0.001 Pa or lower. Subsequently, an electron acceptor (Acceptor-1) of the following structural formula and Compound (1a-4) of Example 1 were subjected to binary deposition on the transparent anode 2 at a deposition rate such that a deposition rate ratio of (Acceptor-1) : Compound (1a-4) = 3 : 97. As a result, the hole injection layer 3 to cover the transparent anode 2 was formed in a film thickness of 10 nm. On the hole injection layer 3, Compound (1a-4) of Example 1 was deposited to form the hole transport layer 4 in a film thickness of 50 nm. On the hole transport layer 4, Compound (4-158) of the following structural formula was deposited to form the electron blocking layer 5 in a film thickness of 5 nm. On the electron blocking layer 5, Compound (EMD-1) of the following structural formula and Compound (EMH-1) of the following structural formula were subjected to binary deposition at a deposition rate such that a deposition rate ratio of (EMD-1) : (EMH-1) = 5 : 95. As a result, the light emitting layer 6 was formed in a film thickness of 20 nm. On the light emitting layer 6, Compound (2-125) of the following structural formula and Compound (ETM-1) of the following structural formula were subjected to binary deposition at a deposition rate such that a deposition rate ratio of Compound (2-125) : (ETM-1) = 50 : 50. As a result, the electron transport layer 7 was formed in a film thickness of 30 nm. On the electron transport layer 7, lithium fluoride was deposited to form the electron injection layer 8 in a film thickness of 1 nm. Finally, aluminum was deposited to form the cathode 9 in a film thickness of 100 nm. The prepared organic EL device was measured for characteristics in the atmosphere at normal temperature. The results of measuring the luminescence characteristics upon applying a direct current voltage to the prepared organic EL device are summarized and shown in Table 1.

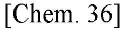

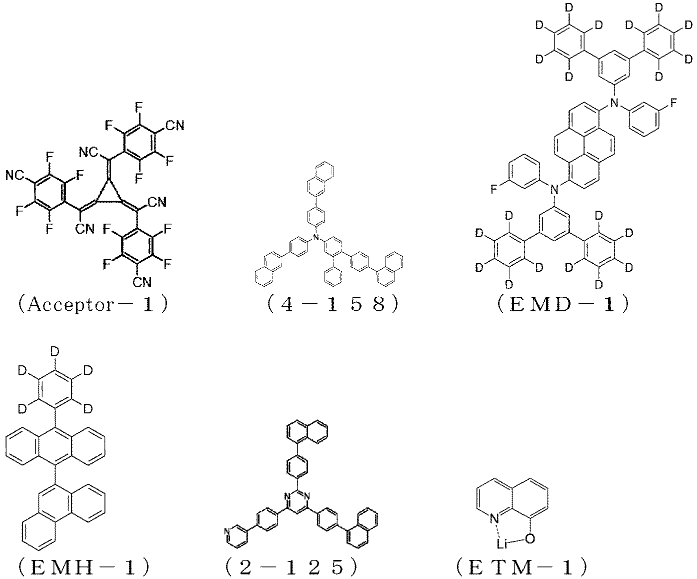

### [Example 13]

An organic EL device was prepared under the same conditions as in Example 12 except that Compound (1a-7) of Example 2 was used as a material of the hole injection layer 3 and the hole transport layer 4 instead of Compound (1a-4) of Example 1. The prepared organic EL device was measured for characteristics in the atmosphere at normal temperature. The results of measuring the luminescence characteristics upon applying a direct current voltage to the prepared organic EL device are summarized and shown in Table 1.

### [Example 14]

An organic EL device was prepared under the same conditions as in Example 12 except that Compound (1a-10) of Example 3 was used as a material of the hole injection layer 3 and the hole transport layer 4 instead of Compound (1a-4) of Example 1. The prepared organic EL device was measured for characteristics in the atmosphere at normal temperature. The results of measuring the luminescence characteristics upon applying a direct current voltage to the prepared organic EL device are summarized and shown in Table 1.

### [Example 15]

An organic EL device was prepared under the same conditions as in Example 12 except that Compound (1a-14) of Example 4 was used as a material of the hole injection layer 3 and the hole transport layer 4 instead of Compound (1a-4) of Example 1. The prepared organic EL device was measured for characteristics in the atmosphere at normal temperature. The results of measuring the luminescence characteristics upon applying a direct current voltage to the prepared organic EL device are summarized and shown in Table 1.

### [Example 16]

An organic EL device was prepared under the same conditions as in Example 12 except that Compound (1a-17) of Example 5 was used as a material of the hole injection layer 3 and the hole transport layer 4 instead of Compound (1a-4) of Example 1. The prepared organic EL device was measured for characteristics in the atmosphere at normal temperature. The results of measuring the luminescence characteristics upon applying a direct current voltage to the prepared organic EL device are summarized and shown in Table 1.

### [Example 17]

An organic EL device was prepared under the same conditions as in Example 12 except that Compound (1a-20) of Example 6 was used as a material of the hole injection layer 3 and the hole transport layer 4 instead of Compound (1a-4) of Example 1. The prepared organic EL device was measured for characteristics in the atmosphere at normal temperature. The results of measuring the luminescence characteristics upon applying a direct current voltage to the prepared organic EL device are summarized and shown in Table 1.

### [Example 18]

An organic EL device was prepared under the same conditions as in Example 12 except that Compound (1a-23) of Example 7 was used as a material of the hole injection layer 3 and the hole transport layer 4 instead of Compound (1a-4) of Example 1. The prepared organic EL device was measured for characteristics in the atmosphere at normal temperature. The results of measuring the luminescence characteristics upon applying a direct current voltage to the prepared organic EL device are summarized and shown in Table 1.

### [Example 19]

An organic EL device was prepared under the same conditions as in Example 12 except that Compound (1b-4) of Example 8 was used as a material of the hole injection layer 3 and the hole transport layer 4 instead of Compound (1a-4) of Example 1. The prepared organic EL device was measured for characteristics in the atmosphere at normal temperature. The results of measuring the luminescence characteristics upon applying a direct current voltage to the prepared organic EL device are summarized and shown in Table 1.

### [Example 20]

An organic EL device was prepared under the same conditions as in Example 12 except that Compound (1b-10) of Example 7 was used as a material of the hole injection layer 3 and the hole transport layer 4 instead of Compound (1a-4) of Example 1. The prepared organic EL device was measured for characteristics in the atmosphere at normal temperature. The results of measuring the luminescence characteristics upon applying a direct current voltage to the prepared organic EL device are summarized and shown in Table 1.

### [Example 21]

An organic EL device was prepared under the same conditions as in Example 12 except that Compound (3a-118) was used as a material of the electron transport layer 7 instead of Compound (2-125). The prepared organic EL device was measured for characteristics in the atmosphere at normal temperature. The results of measuring the luminescence characteristics upon applying a direct current voltage to the prepared organic EL device are summarized and shown in Table 1.

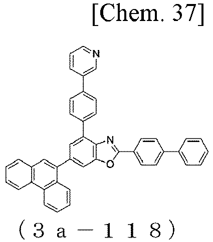

### [Example 22]

An organic EL device was prepared under the same conditions as in Example 12 except that Compound (1a-14) of Example 4 was used as a material of the hole injection layer 3 and the hole transport layer 4 instead of Compound (1a-4) of Example 1, and Compound (3a-118) was used as a material of the electron transport layer 7 instead of Compound (2-125). The prepared organic EL device was measured for characteristics in the atmosphere at normal temperature. The results of measuring the luminescence characteristics upon applying a direct current voltage to the prepared organic EL device are summarized and shown in Table 1.

### [Comparative Example 1]

For comparison, an organic EL device was prepared under the same conditions as in Example 12 except that Compound (HTM-1) of the following structural formula was used as a material of the hole injection layer 3 and the hole transport layer 4 instead of Compound (1a-4) of Example 1. The prepared organic EL device was measured for characteristics in the atmosphere at normal temperature. The results of measuring the luminescence characteristics upon applying a direct current voltage to the prepared organic EL device are summarized and shown in Table 1.

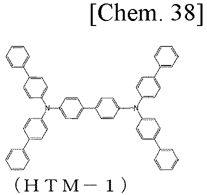

### [Comparative Example 2]

For comparison, an organic EL device was prepared under the same conditions as in Example 12 except that Compound (HTM-2) of the following structural formula was used as a material of the hole injection layer 3 and the hole transport layer 4 instead of Compound (1a-4) of Example 1. The prepared organic EL device was measured for characteristics in the atmosphere at normal temperature. The results of measuring the luminescence characteristics upon applying a direct current voltage to the prepared organic EL device are summarized and shown in Table 1.

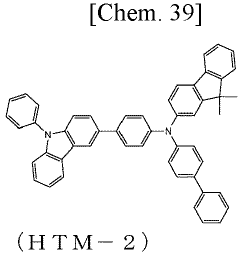

### [Comparative Example 3]

For comparison, an organic EL device was prepared under the same conditions as in Example 12 except that Compound (HTM-1) of the foregoing structural formula was used as a material of the hole injection layer 3 and the hole transport layer 4 instead of Compound (1a-4) of Example 1, and Compound (3a-118) was used as a material of the electron transport layer 7 instead of Compound (2-125). The prepared organic EL device was measured for characteristics in the atmosphere at normal temperature. The results of measuring the luminescence characteristics upon applying a direct current voltage to the prepared organic EL device are summarized and shown in Table 1.

### [Comparative Example 4]

For comparison, an organic EL device was prepared under the same conditions as in Example 12 except that Compound (HTM-2) of the foregoing structural formula was used as a material of the hole injection layer 3 and the hole transport layer 4 instead of Compound (1a-4) of Example 1, and Compound (3a-118) was used as a material of the electron transport layer 7 instead of Compound (2-125). The prepared organic EL device was measured for characteristics in the atmosphere at normal temperature. The results of measuring the luminescence characteristics upon applying a direct current voltage to the prepared organic EL device are summarized and shown in Table 1.

The results of measuring device lifetime of the organic EL devices prepared in Examples 12 to 22 and Comparative Examples 1 to 4 were summarized and shown in Table 1. The device lifetime was measured as time from a time point when emission luminance at the light-emission start (initial luminance) was 2,000 cd/m² and constant-current driving was performed to a time point when the emission luminance attenuated to 1,900 cd/m² (equivalent to 95% of the initial luminance which is set as 100%: 95% attenuation).

**[Table 1]**

| | Hole transport layer | Electron blocking layer | Light emitting layer | Electron transport layer | Voltage [V] (@10 mA/cm²) | Luminance [cd/m²] (@10 mA/cm²) | Luminous efficiency [cd/A] ((@10 mA/cm²) | Power efficiency [lm/W] (@10 mA/cm²) | Device lifetime 95% attenuation |
|---|---|---|---|---|---|---|---|---|---|
| Ex. 12 | Compound 1a-4 | Compound 4-158 | EMD-1 /EMH-1 | Compound 2-125/ETM-1 | 3.65 | 811 | 8.11 | 6.98 | 265 hours |
| Ex. 13 | Compound 1a-7 | Compound 4-158 | EMD-1 /EMH-1 | Compound 2-125/ETM-1 | 3.65 | 880 | 8.80 | 7.58 | 186 hours |
| Ex. 14 | Compound 1a-10 | Compound 4-158 | EMD-1 /EMH-1 | Compound 2-125/ETM-1 | 3.64 | 821 | 8.21 | 7.09 | 270 hours |
| Ex. 15 | Compound 1a-14 | Compound 4-158 | EMD-1 /EMH-1 | Compound 2-125/ETM-1 | 3.55 | 778 | 7.78 | 6.89 | 279 hours |
| Ex. 16 | Compound 1a-17 | Compound 4-158 | EMD-1 /EMH-1 | Compound 2-125/ETM-1 | 3.60 | 877 | 8.77 | 7.66 | 193 hours |
| Ex. 17 | Compound 1a-20 | Compound 4-158 | EMD-1 /EMH-1 | Compound 2-125/ETM-1 | 3.56 | 759 | 7.59 | 6.71 | 302 hours |
| Ex. 18 | Compound 1a-23 | Compound 4-158 | EMD-1 /EMH-1 | Compound 2-125/ETM-1 | 3.64 | 840 | 8.40 | 7.25 | 217 hours |
| Ex. 19 | Compound 1b-4 | Compound 4-158 | EMD-1 /EMH-1 | Compound 2-125/ETM-1 | 3.58 | 818 | 8.18 | 7.19 | 274 hours |
| Ex. 20 | Compound 1b-10 | Compound 4-158 | EMD-1 /EMH-1 | Compound 2-125/ETM-1 | 3.58 | 817 | 8.17 | 7.17 | 296 hours |
| Ex. 21 | Compound 1a-4 | Compound 4-158 | EMD-1 /EMH-1 | Compound 3a-118/ ETM-1 | 3.46 | 857 | 8.57 | 7.78 | 255 hours |
| Ex. 22 | Compound 1a-14 | Compound 4-158 | EMD-1 /EMH-1 | Compound 3a-118/ ETM-1 | 3.44 | 847 | 8.47 | 7.73 | 269 hours |
| Comp. Ex. 1 | HTM-1 | Compound 4-158 | EMD-1 /EMH-1 | Compound 2-125/ETM-1 | 3.78 | 720 | 7.20 | 5.98 | 147 hours |
| Comp. Ex. 2 | HTM-2 | Compound 4-158 | EMD-1 /EMH-1 | Compound 2-125/ETM-1 | 3.66 | 749 | 7.49 | 6.39 | 131 hours |
| Comp. Ex. 3 | HTM-1 | Compound 4-158 | EMD-1 /EMH-1 | Compound 3a-118/ ETM-1 | 3.73 | 710 | 7.10 | 5.94 | 120 hours |
| Comp. Ex. 4 | HTM-2 | Compound 4-158 | EMD-1 /EMH-1 | Compound 3a-118/ ETM-1 | 3.70 | 726 | 7.26 | 6.14 | 115 hours |

As shown in Table 1, the luminous efficiency of the organic EL devices of Comparative Examples 1 to 4 when a current with a current density of 10 mA/cm² flowed in the organic EL devices was within a range of 7.10 to 7.49 cd/A. In contrast, the luminous efficiency of the organic EL devices of Examples 12 to 22 was within a range of 7.59 to 8.80 cd/A, which all had high luminous efficiency.

The power efficiency of the organic EL devices of Comparative Examples 1 to 4 was within a range of 5.94 to 6.39 lm/W. In contrast, the power efficiency of the organic EL devices of Examples 12 to 22 was within a range of 6.71 to 7.78 lm/W, which all had high power efficiency.

On the other hand, device lifetime (95% attenuation) of the organic EL devices of Comparative Examples 1 to 4 was within a range of 115 to 147 hours. In contrast, the device lifetime of the organic EL devices of Examples 12 to 22 was within a range of 186 to 302 hours, and it is found that lifetime was improved.

The organic EL device of the present invention can efficiently inject and transport holes from the electrode to the hole transport layer by selecting a specific indenophenanthrene compound as a material of the hole injection layer. As a result, it has been found that the carrier balance inside the organic EL device is improved, and thus an organic EL device having high luminous efficiency and long lifetime, as compared with a conventional organic EL device, can be achieved.

Although the present invention has been described in detail with reference to specific examples, it is apparent to those skilled in the art that it is possible to add various alterations and modifications without departing from the spirit and the scope of the present invention.

The present application is based on Japanese Patent Application (No. 2018-25363) filed on February 15, 2018, the entirety of which is incorporated by reference. In addition, all references referred herein are entirely incorporated.

### Industrial Applicability

According to the organic EL device of the present invention, in which a specific indenophenanthrene compound is used as a material of the hole transport layer, the luminous efficiency can be increased and the durability of the organic EL device can be improved. For example, the organic EL device of the present invention can be deployed in a home electric appliance or lighting application.

### References Signs List

- 1: Glass substrate
- 2: Transparent anode
- 3: Hole injection layer
- 4: Hole transport layer
- 5: Electron blocking layer
- 6: Light emitting layer
- 7: Electron transport layer
- 8: Electron injection layer
- 9: Cathode

## Claims

1. An organic electroluminescence device comprising at least an anode, a hole transport layer, a light emitting layer, an electron transport layer, and a cathode in this order, wherein the hole transport layer comprises an indenophenanthrene compound represented by the following general formula (1a) or (1b): 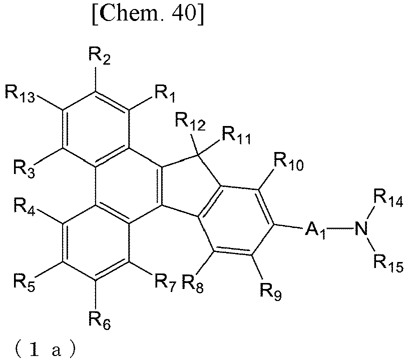
(In the formula, R₁ to R₁₀, and R₁₃ may be the same as or different from each other and each represents a hydrogen atom, a deuterium atom, a fluorine atom, a chlorine atom, a cyano group, a nitro group, a linear or branched alkyl group having a carbon number of 1 to 6 which may have a substituent, a cycloalkyl group having a carbon number of 5 to 10 which may have a substituent, a linear or branched alkenyl group having a carbon number of 2 to 6 which may have a substituent, a linear or branched alkyloxy group having a carbon number of 1 to 6 which may have a substituent, a cycloalkyloxy group having a carbon number of 5 to 10 which may have a substituent, a substituted or unsubstituted aromatic hydrocarbon group, a substituted or unsubstituted aromatic heterocyclic group, a substituted or unsubstituted condensed polycyclic aromatic group, a substituted or unsubstituted aryloxy group, or a di-substituted amino group substituted with a group selected from an aromatic hydrocarbon group, an aromatic heterocyclic group, and a condensed polycyclic aromatic group, these groups may be bonded to each other through a single bond, a substituted or unsubstituted methylene group, an oxygen atom, or a sulfur atom to form a ring, and these groups may be bonded to each other through an oxygen atom, a sulfur atom, or a linking group to form a ring together with a benzene ring to which R₁ to R₁₀, and R₁₃ are bonded;
R₁₁, R₁₂, R₁₄ and R₁₅ may be the same as or different from each other and each represents a linear or branched alkyl group having a carbon number of 1 to 6 which may have a substituent, a cycloalkyl group having a carbon number of 5 to 10 which may have a substituent, a linear or branched alkenyl group having a carbon number of 2 to 6 which may have a substituent, a substituted or unsubstituted aromatic hydrocarbon group, a substituted or unsubstituted aromatic heterocyclic group, a substituted or unsubstituted condensed polycyclic aromatic group, or a substituted or unsubstituted aryloxy group;
here, R₁₁ and R₁₂, or R₁₄ and R₁₅ may be bonded to each other between the respective groups through a single bond, an oxygen atom, a sulfur atom, or a linking group to form a ring; and
A₁ represents a single bond, a divalent group of a substituted or unsubstituted aromatic hydrocarbon, a divalent group of a substituted or unsubstituted aromatic heterocycle, or a divalent group of a substituted or unsubstituted condensed polycyclic aromatic compound), 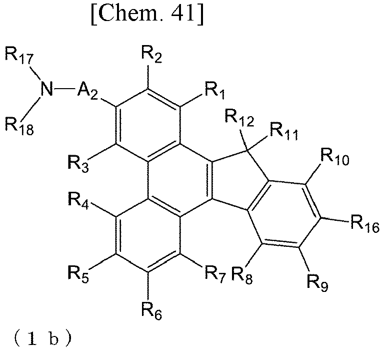
(in the formula, R₁ to R₁₀, and R₁₆ may be the same as or different from each other and each represents a hydrogen atom, a deuterium atom, a fluorine atom, a chlorine atom, a cyano group, a nitro group, a linear or branched alkyl group having a carbon number of 1 to 6 which may have a substituent, a cycloalkyl group having a carbon number of 5 to 10 which may have a substituent, a linear or branched alkenyl group having a carbon number of 2 to 6 which may have a substituent, a linear or branched alkyloxy group having a carbon number of 1 to 6 which may have a substituent, a cycloalkyloxy group having a carbon number of 5 to 10 which may have a substituent, a substituted or unsubstituted aromatic hydrocarbon group, a substituted or unsubstituted aromatic heterocyclic group, a substituted or unsubstituted condensed polycyclic aromatic group, a substituted or unsubstituted aryloxy group, or a di-substituted amino group substituted with a group selected from an aromatic hydrocarbon group, an aromatic heterocyclic group, and a condensed polycyclic aromatic group, these groups may be bonded to each other through a single bond, a substituted or unsubstituted methylene group, an oxygen atom, or a sulfur atom to form a ring, and these groups may be bonded to each other through an oxygen atom, a sulfur atom, or a linking group to form a ring together with a benzene ring to which R₁ to R₁₀, and R₁₆ are bonded;
R₁₁, R₁₂, R₁₇ and R₁₈ may be the same as or different from each other and each represents a linear or branched alkyl group having a carbon number of 1 to 6 which may have a substituent, a cycloalkyl group having a carbon number of 5 to 10 which may have a substituent, a linear or branched alkenyl group having a carbon number of 2 to 6 which may have a substituent, a substituted or unsubstituted aromatic hydrocarbon group, a substituted or unsubstituted aromatic heterocyclic group, a substituted or unsubstituted condensed polycyclic aromatic group, or a substituted or unsubstituted aryloxy group;
here, R₁₁ and R₁₂, or R₁₇ and R₁₈ may be bonded to each other between the respective groups through a single bond, an oxygen atom, a sulfur atom, or a linking group to form a ring; and
A₂ represents a single bond, a divalent group of a substituted or unsubstituted aromatic hydrocarbon, a divalent group of a substituted or unsubstituted aromatic heterocycle, or a divalent group of a substituted or unsubstituted condensed polycyclic aromatic compound).

2. The organic electroluminescence device according to Claim 1, wherein R₁₄, R₁₅, R₁₇ and R₁₈ each represents a substituted or unsubstituted aromatic hydrocarbon group, a substituted or unsubstituted aromatic heterocyclic group, or a substituted or unsubstituted condensed polycyclic aromatic group.

3. The organic electroluminescence device according to Claim 1 or 2, wherein A₁ and A₂ are a single bond.

4. The organic electroluminescence device according to any one of Claims 1 to 3, wherein the electron transport layer comprises a compound having a pyrimidine ring structure, which is represented by the following general formula (2): 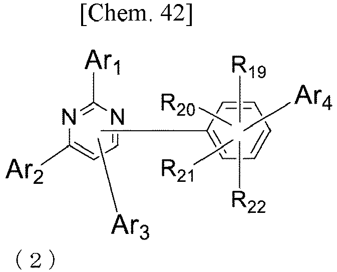
(in the formula, Ar₁ represents a substituted or unsubstituted aromatic hydrocarbon group, or a substituted or unsubstituted condensed polycyclic aromatic group;
Ar₂ and Ar₃ may be the same as or different from each other and represent a hydrogen atom, a substituted or unsubstituted aromatic hydrocarbon group, or a substituted or unsubstituted condensed polycyclic aromatic group;
Ar₄ represents a substituted or unsubstituted aromatic heterocyclic group; and
R₁₉ to R₂₂ may be the same as or different from each other and each represents a hydrogen atom, a deuterium atom, a fluorine atom, a chlorine atom, a cyano group, a trifluoromethyl group, a linear or branched alkyl group having a carbon number of 1 to 6, a substituted or unsubstituted aromatic hydrocarbon group, a substituted or unsubstituted aromatic heterocyclic group, or a substituted or unsubstituted condensed polycyclic aromatic group;
provided that Ar₂ and Ar₃ are not a hydrogen atom at the same time).

5. The organic electroluminescence device according to any one of Claims 1 to 3, wherein the electron transport layer comprises a compound having a benzazole ring structure, which is represented by the following general formula (3): 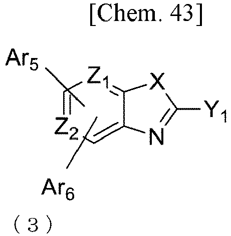
(in the formula, Ar₅ and Ar₆ may be the same as or different from each other and represent a hydrogen atom, a deuterium atom, a substituted or unsubstituted aromatic hydrocarbon group, a substituted or unsubstituted aromatic heterocyclic group, a substituted or unsubstituted condensed polycyclic aromatic group, or a substituted or unsubstituted alkyl group;
Y₁ represents a substituted or unsubstituted aromatic hydrocarbon group, a substituted or unsubstituted aromatic heterocyclic group, a substituted or unsubstituted condensed polycyclic aromatic group, or a substituted or unsubstituted alkyl group;
X represents an oxygen atom or a sulfur atom; and
Z₁ and Z₂ may be the same as or different from each other and represent a carbon atom or a nitrogen atom).

6. The organic electroluminescence device according to any one of Claims 1 to 5, further comprising an electron blocking layer between the hole transport layer and the light emitting layer.

7. The organic electroluminescence device according to Claim 6, wherein the electron blocking layer comprises an arylamine compound represented by the following general formula (4): 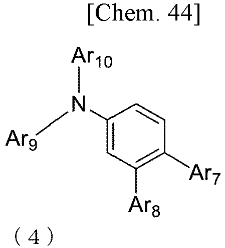 (in the formula, Ar₇ to Ar₁₀ may be the same as or different from each other and each represents a substituted or unsubstituted aromatic hydrocarbon group, a substituted or unsubstituted aromatic heterocyclic group, or a substituted or unsubstituted condensed polycyclic aromatic group).

8. The organic electroluminescence device according to any one of Claims 1 to 7, further comprising a hole injection layer between the anode and the hole transport layer.

9. The organic electroluminescence device according to Claim 8, wherein the hole injection layer comprises the indenophenanthrene compound represented by the foregoing general formula (1a) or (1b) and an electron acceptor, and the electron acceptor is at least one electron acceptor selected from the group consisting of trisbromophenylamine hexachloroantimony, tetracyanoquinone dimethane (TCNQ), 2,3,5,6-tetrafluoro-tetracyano-1,4-benzoquinone dimethane (F4TCNQ), and radialene derivatives.
